# EUROPEAN PATENT APPLICATION

(11) **EP 4 783 737 A1**
(43) Date of publication of application: **29.07.2026**
(21) Application number: 24868733.7
(22) Date of filing: 20.09.2024
(51) Int. Cl.: H05B 6/12, H01F 3/10, H01F 38/14, H01F 27/26, F24C 15/10, H05B 6/06, F24C 15/34, F24C 3/12

(54) **WORKING COIL AND HOME APPLIANCE INCLUDING SAME**

(30) Priority: 21.09.2023 KR 20230126657; 21.09.2023 KR 20230126658; 26.09.2023 KR 20230129155; 22.02.2024 KR 20240026117; 09.09.2024 KR 20240122340
(71) Applicant: LG Electronics Inc., Yeongdeungpo-gu Seoul 07336 (KR)
(72) Inventor: OH, Dooyong, Seoul 08592 (KR); SHIN, Yonghwan, Seoul 08592 (KR); LEE, Jae-Woo, Seoul 08592 (KR); CHA, Kwanghyung, Seoul 08592 (KR); KANG, Kyelyong, Seoul 08592 (KR); HAN, Jinwook, Seoul 08592 (KR); HONG, Jaepyo, Seoul 08592 (KR); LEE, Yongsoo, Seoul 08592 (KR)
(74) Representative: Vossius & Partner Patentanwälte Rechtsanwälte mbB
(86) International application number: PCT/KR2024/014229
(87) International publication number: WO 2025/063757

(57) **Abstract**

Present disclosure relates to a working coil and a home appliance including the working coil. In an embodiment, the working coil may include a plurality of first coil layers disposed along a first pattern and stacked in a vertical direction; and a plurality of second coil layers disposed along a second pattern, stacked in a vertical direction, and disposed in layers different from the plurality of first coil layers. In an embodiment, the working coil may include a connection region and a non-connection region. In an embodiment, the connection region may include a via electrically connecting at least one of coil strands included in the plurality of first coil layers with at least one of coil strands included in the plurality of second coil layers.

## Description

### Technical Field

Present disclosure relates to a working coil and a home appliance including the working coil.

### Background Art

Recently, various home appliances are being used to make human life more convenient. Examples of these home appliances may include cooking appliances, refrigerators, washing machines, clothes dryers, clothes management machines, water purifiers, and the like.

The cooking appliance, one of the home appliances, is a type of home appliance for cooking food, which is installed in the kitchen space and cooks food according to the user's intention. Such cooking appliance may be classified in various ways depending on a heat source used, a shape, and a type of fuel.

When classifying the cooking appliance based on a method of cooking the food, the cooking appliance may be classified into an open cooking appliance and a closed cooking appliance depending on a type of a space where the food is placed. Examples of the closed cooking appliance include an oven, a microwave, and the like, while examples of the open cooking appliance include a cooktop, a hob, and the like.

Among the open cooking appliances, the cooktop is provided to be capable of heating food contained in a cooking container through at least one burner. This cooktop may be provided in a form having a burner using electricity, or may be provided in a form having a burner using gas. Additionally, the cooktop may be implemented as a standalone unit, as well as in the form of an oven range including an oven underneath the cooktop.

As an example of a cooktop having a burner using electricity, there is an induction heating device. The induction heating device is a cooking appliance that performs a cooking function in an induction heating method. In the induction heating device, when a current is applied to a working coil, eddy current can be generated in the cooking container made of a magnetic material, and food can be cooked by the cooking container that generates heat by acting as a resistance to the eddy current.

This induction heating device does not require combustion of gas and therefore does not produce combustion exhaust gases. Furthermore, by allowing the container itself to generate heat immediately, the induction heating device can minimize the transfer process through heat radiation or conduction, thus being capable of heating the cooked food at a high speed.

Typically, in the induction heating device, the position where the cooking container is to be placed is marked on the top plate above the working coil, and the cooking container is heated by the working coil in a state in which the cooking container is placed in the marked area.

In the induction heating device, one or more working coils and circuit boards may be provided. The working coil serves to transmit electromagnetic force to the cooking container. In general, the working coil may be formed in the form of a wire wound in a spiral shape. And the circuit board may play a role in controlling the supply of the induction current to the working coil in a circuit manner.

Recently, instead of a working coil in the form of a wire wound in a spiral shape, a working coil in the form of a coil pattern formed on a circuit board is also used.

Among the costs and time required to manufacture the induction heating device, the cost and time spent on manufacturing the working coil account for a large proportion. Among these, the cost of the wire and the cost and time required to wind the wire are significant.

If the working coil is formed in the form of forming a coil-shaped pattern on a circuit board instead of forming a working coil by winding a wire, the cost and time spent on manufacturing the working coil can be reduced.

To the working coil, high frequency power is applied, and thereby, considerable heat is generated in the working coil. In particular, in the induction heating device that requires high power, a lot of heat is generated in the working coil as the high power is applied.

In a case where a working coil is formed in the form of forming a coil-shaped pattern on a circuit board, due to the limited area of the circuit board, the working coil is inevitably formed in a form in which coil patterns are concentrated in a narrow area of the circuit board. As a result, the circuit board on which the working coil is formed may be inevitably subjected to a lot of heat relative to its area, and thereby, the temperature of the circuit board may increase excessively.

Meanwhile, recently, an induction heating device has been developed that automatically recognizes the size and location of a cooking container and performs heating in an appropriate manner even if the seating position of the cooking container is not placed in a specific location. In order for the heating in this type of induction heating device to be performed more effectively, the number of working coils provided in the induction heating device needs to be increased.

Therefore, due to the temperature rise problem caused by the concentration of coil patterns, there is a difficulty for the working coil in the form of a coil pattern to be applied to the above-described type of induction heating device.

### Disclosure of the invention

### Technical Problem

The purpose of present disclosure is to provide a working coil and a home appliance including the working coil, whose structure is improved to suppress the temperature rise.

Also, the purpose of present disclosure is to provide a working coil and a home appliance including the working coil, whose structure is improved to increase the density of the area occupied by the working coil within a cooktop.

Also, the purpose of present disclosure is to provide a working coil and a home appliance including the working coil, whose structure is improved to allow the working coils to be disposed more densely while suppressing the temperature rise of the working coils.

Also, the purpose of present disclosure is to provide a working coil and a home appliance including the working coil, whose structure is improved to reduce the loss of the original substrate used to manufacture the coil substrate portion while increasing the density of the area occupied by the working coil within a cooktop.

Also, the purpose of present disclosure is to provide a working coil and a home appliance including the working coil, whose structure is improved to simplify the connection structure between the working coil and the electronic unit.

Also, the purpose of present disclosure is to provide a working coil and a home appliance including the working coil, whose structure is improved to suppress the decrease in the pattern cross-sectional area per turn of the working coil caused by the foil loss generated during the coil pattern formation process.

Also, the purpose of present disclosure is to provide a working coil and a home appliance including the working coil, which are capable of making the current distribution and magnetic flux density distribution of the working coil more uniform by reducing the proximity effect and skin effect of the coil strand included in the working coil.

Also, the purpose of present disclosure is to reduce power loss occurring during the operation of a home appliance and to increase power efficiency.

Also, the purpose of present disclosure is to alleviate the phenomenon in which the temperature of a specific area of the working coil becomes excessively higher than that of other areas during the operation of a home appliance.

The purposes of present disclosure are not limited to the purposes mentioned above, and other purposes and advantages of present disclosure which are not mentioned will be more clearly appreciated by the embodiments of present disclosure described below. Furthermore, the purposes and advantages of present disclosure can be realized by the components described in the claims and combinations thereof.

### Means for Solving the Problem

A working coil according to an embodiment may include a plurality of first coil layers disposed along a first pattern and stacked in a vertical direction; and a plurality of second coil layers disposed along a second pattern and disposed in layers different from the plurality of first coil layers.

In an embodiment, the working coil may include a connection region and a non-connection region.

In an embodiment, the connection region may include a via electrically connecting at least one of coil strands included in the plurality of first coil layers with at least one of coil strands included in the plurality of second coil layers.

In an embodiment, each of coil strands included in the plurality of first coil layers and each of coil strands included in the plurality of second coil layers may be disposed in different traces in the non-connection region.

In an embodiment, each of coil strands included in the plurality of first coil layers and each of coil strands included in the plurality of second coil layers may be disposed in a same trace in the non-connection region.

In an embodiment, each of coil strands included in the plurality of first coil layers and each of coil strands included in the plurality of second coil layers may be parallel to each other in the non-connection region.

In an embodiment, each of coil strands included in the plurality of first coil layers and each of coil strands included in the plurality of second coil layers may intersect with each other in the connection region.

In an embodiment, the connection region may include two or more via patterns.

In an embodiment, each of the via patterns may be disposed on a straight line orthogonal to a coil strand included in the plurality of first coil layers or the plurality of second coil layers.

In an embodiment, each of the via patterns may be disposed on a straight line intersecting at a predetermined angle with a coil strand included in the plurality of first coil layers or the plurality of second coil layers.

In an embodiment, the working coil may include a plurality of coil turns.

In an embodiment, each of the via patterns included in each of the coil turns may be disposed on a same straight line.

In an embodiment, the via pattern included in each of the coil turns may be disposed in a same position as the via included in another coil turn.

In an embodiment, each of the via patterns included in an nth coil turn may be disposed on a first straight line, and each of the via patterns included in an (n+2)th coil turn may be disposed on a second straight line. (where n is a positive integer)

In an embodiment, the connection region and the non-connection region may be alternately disposed.

In an embodiment, the working coil may be included in a home appliance, and heat an object.

A working coil according to an embodiment may include a plurality of first coil layers disposed along a first pattern and stacked in a vertical direction; a plurality of second coil layers disposed along a second pattern, stacked in a vertical direction, and disposed in layers different from the plurality of first coil layers; and a plurality of third coil layers disposed along a third pattern, stacked in a vertical direction, and disposed in layers different from the plurality of first coil layers and the plurality of second coil layers.

In an embodiment, the working coil may include a connection region and a non-connection region.

In an embodiment, the connection region may include a via electrically connecting at least one of coil strands included in the plurality of first coil layers, at least one of coil strands included in the plurality of second coil layers, and at least one of coil strands included in the plurality of third coil layers.

In an embodiment, each of the coil strands included in the plurality of first coil layers, each of the coil strands included in the plurality of second coil layers, and each of the coil strands included in the plurality of third coil layers may be disposed in a same trace in the non-connection region.

In an embodiment, the connection region may include a first connection region and a second connection region.

In an embodiment, in the first connection region, the via may be formed in an nth coil turn. (where n is a positive integer)

In an embodiment, in the second connection region, the via may be formed in an (n+2)th coil turn. (where n is a positive integer)

In an embodiment, at least one of each of the coil strands included in the plurality of first coil layers and at least one of each of the coil strands included in the plurality of second coil layers may be electrically connected by the via in the first connection region.

In an embodiment, at least one of each of the coil strands included in the plurality of second coil layers and at least one of each of the coil strands included in the plurality of third coil layers may be electrically connected by the via in the second connection region.

In an embodiment, each of the coil strands included in the plurality of first coil layers, each of the coil strands included in the plurality of second coil layers, and each of the coil strands included in the plurality of third coil layers may intersect with each other in the connection region.

In an embodiment, the connection region may include two or more via patterns.

In an embodiment, each of via patterns may be disposed on a straight line orthogonal to the coil strand included in the plurality of first coil layers or the plurality of second coil layers or the plurality of third coil layers.

In an embodiment, each of the via patterns may be disposed on a straight line intersecting at a predetermined angle with a coil strand included in the plurality of first coil layers or the plurality of second coil layers or the plurality of third coil layers.

In an embodiment, the working coil may include a plurality of coil turns.

In an embodiment, each of the via patterns included in an nth coil turn may be disposed on a first straight line, and each of the via patterns included in an (n+2)th coil turn may be disposed on a second straight line. (where n is a positive integer)

In an embodiment, the connection region and the non-connection region may be alternately disposed.

In an embodiment, in the nth coil turn, the first connection region and the non-connection region may be alternately disposed, and in the (n+2)th coil turn, the second connection region and the non-connection region may be alternately disposed. (where n is a positive integer)

In an embodiment, the working coil may be included in a home appliance, and heat an object.

### Advantageous Effects

According to embodiments, a plurality of coil patterns stacked in the up and down directions are connected to each other in the up and down directions to form a working coil in the form of a pattern coil, thereby increasing the length of the working coil in the up and down direction, so that the pattern cross-sectional area per turn of the working coil can be effectively increased.

According to embodiments, by suppressing the increase in the size of the working coil in the horizontal direction and increasing the pattern cross-sectional area per turn of the working coil, it is possible to effectively suppress the temperature rise of the working coil.

According to embodiments, since the outer shape of the working coil formed in a polygonal shape similar to the outer shape of the cooktop is formed in a polygonal shape similar to the outer shape of the coil module, it is possible to effectively improve the density of the area occupied by the working coil within the cooktop.

According to embodiments, it is possible to increase the heating efficiency of the home appliance by increasing the area of the region where the object to be heated is in contact with the working coil.

According to embodiments, a plurality of coil lines stacked in the up and down directions are connected to each other in the up and down directions to form a working coil, and a horizontal direction twist structure and an up-and-down direction twist structure are formed in the working coil, so that it is possible to minimize the increase in the horizontal size of the working coil while increasing the pattern cross-sectional area per turn of the working coil.

According to embodiments, by reducing the size of the working coil while lowering the density of the current flowing in the working coil, it is possible to allow the working coils to be disposed more closely together compared to a cooktop of the same standard, and to maintain maximum output for a longer period of time compared to a cooktop of the same size.

According to embodiments, by using the densely disposed small working coils, it is possible to provide more improved heating efficiency as well as to provide higher output for a longer period of time.

According to embodiments, by allowing the coil assembly to be made of a combination of a plurality of coil modules, the loss of the original substrate used to manufacture the coil module can be reduced, and the space required to dispose the control panel on the cooktop can be effectively secured.

According to embodiments, a wiring for connecting the working coil and the sensing coil to the terminal part is formed in the form of being patterned in the coil module itself, and the connection of the working coil and the sensing coil with the electronic unit can be made only by the connection between the terminal part and the electronic unit. Accordingly, a connection structure between the electronic unit and both the working coil and the sensing coil can be formed very simply.

According to embodiments, in addition to allowing the connection work between the coil assembly and the electronic unit to be done easily and quickly, it is possible to effectively prevent that the accommodation space inside the cooktop, in which the coil assembly and the electronic unit are accommodated, becomes complicated due to a large number of wirings.

According to embodiments, since the proximity effect and the skin effect of the coil strand included in the working coil are reduced, the current distribution and magnetic flux density distribution of the working coil can become more uniform.

According to embodiments, it is possible to reduce power loss occurring during the operation of a home appliance and to increase power efficiency.

According to embodiments, it is possible is to alleviate the phenomenon in which the temperature of a specific area of the working coil becomes excessively higher than that of other areas during the operation of a home appliance.

### Brief Description of Drawings

FIG. 1 is a perspective view illustrating a home appliance according to an embodiment.
FIG. 2 is a plan view separately showing a cooktop shown in FIG. 1.
FIG. 3 is a view showing the indicator lamp lighting status of the cooktop shown in FIG. 2.
FIG. 4 is an exploded perspective view showing an exploded state of the cooktop shown in FIG. 2.
FIG. 5 is a view showing a state in which electronic components are installed on the bottom surface of a supporter shown in FIG. 4.
FIG. 6 is a plan view schematically showing the configuration of a coil assembly shown in FIG. 4.
FIG. 7 is a cross-sectional view schematically showing a stacked structure of a coil module shown in FIG. 6.
FIG. 8 is a plan view showing a first example of a layout structure of a first coil module and a second coil module.
FIG. 9 is a view schematically illustrating an example of the cutting state of an original substrate for forming a first coil substrate portion.
FIG. 10 is a plan view showing a second example of a layout structure of a first coil module and a second coil module.
FIG. 11 is a plan view showing another example of a layout structure of a first coil module and a second coil module shown in FIG. 8.
FIG. 12 is a plan view showing another example of a layout structure of a first coil module and a second coil module shown in FIG. 10.
FIG. 13 is a plan view showing a third example of a layout structure of a first coil module and a second coil module.
FIG. 14 is a plan view showing a fourth example of a layout structure of a first coil module and a second coil module.
FIG. 15 is a plan view showing a fifth example of a layout structure of a first coil module and a second coil module.
FIG. 16 is a plan view showing a sixth example of a layout structure of a first coil module and a second coil module.
FIG. 17 is a plan view showing an example of a first coil substrate portion according to an embodiment.
FIG. 18 is an enlarged view illustrating a portion of the first coil substrate portion shown in FIG. 17.
FIG. 19 is a cross-sectional view schematically showing a stacked structure of a first coil portion shown in FIG. 18.
FIG. 20 is a plan view showing an example of the layout structure of a sensing coil.
FIG. 21 is an enlarged view of part "21" in FIG. 20, which shows an example of a layout structure of a sensing coil with respect to a working coil.
FIG. 22 is an enlarged view of a first terminal shown in FIG. 18.
FIG. 23 is an enlarged view of a second terminal shown in FIG. 18.
FIG. 24 is a plan view showing a seventh example of a layout structure of a first coil module and a second coil module.
FIG. 25 is a block diagram schematically illustrating a power supply-related configuration of a home appliance according to an embodiment.
FIG. 26 is a circuit diagram of a home appliance according to an embodiment.
FIG. 27 is a plan view illustrating an example of a working coil.
FIG. 28 is an enlarged view of a portion of a first coil layer set of a coil pattern of a working coil according to a first embodiment.
FIG. 29 is an enlarged view of a portion of a second coil layer set of a coil pattern of a working coil according to a first embodiment.
FIG. 30 is an enlarged view of a portion of a first coil layer set and a second coil layer set of a working coil according to a first embodiment.
FIG. 31 is a cross-sectional view of a connection region of a coil pattern of a working coil according to a first embodiment.
FIG. 32 is a cross-sectional view of AA1-AA2 portion of a connection region of a coil pattern of a working coil according to a first embodiment.
FIG. 33 is a cross-sectional view of BB1-BB2 portion of a non-connection region of a coil pattern of a working coil according to a first embodiment.
FIG. 34 is an enlarged view of a portion of a first coil layer set of a coil pattern of a working coil according to a second embodiment.
FIG. 35 is an enlarged view of a portion of a second coil layer set of a coil pattern of a working coil according to a second embodiment.
FIG. 36 is an enlarged view of a portion of a first coil layer set and a second coil layer set of a working coil according to a second embodiment.
FIG. 37 is a cross-sectional view of a non-connection region of a coil pattern of a working coil according to a second embodiment.
FIG. 38 is a cross-sectional view of AA1-AA2 portion of a connection region of a coil pattern of a working coil according to a second embodiment.
FIG. 39 is a cross-sectional view of BB1-BB2 portion of a connection region of a coil pattern of a working coil according to a second embodiment.
FIG. 40 is an enlarged view of a portion of a first coil layer set of a coil pattern of a working coil according to a third embodiment.
FIG. 41 is an enlarged view of a portion of a second coil layer set of a coil pattern of a working coil according to a third embodiment.
FIG. 42 is an enlarged view of a portion of a third coil layer set of a coil pattern of a working coil according to a third embodiment.
FIG. 43 is an enlarged view of a portion of a first coil layer set, a second coil layer set, and a third coil layer set of a working coil according to a third embodiment.
FIG. 44 is a cross-sectional view of a non-connection region of a coil pattern of a working coil according to a third embodiment.
FIG. 45 is a cross-sectional view of AA1-AA2 portion of a connection region of a coil pattern of a working coil according to a third embodiment.
FIG. 46 is a cross-sectional view of BB1-BB2 portion of a connection region of a coil pattern of a working coil according to a third embodiment.
FIG. 47 is an enlarged view of a portion of a first coil layer set of a coil pattern of a working coil according to a fourth embodiment.
FIG. 48 is an enlarged view of a portion of a second coil layer set of a coil pattern of a working coil according to a fourth embodiment.
FIG. 49 is an enlarged view of a portion of a first coil layer set and a second coil layer set of a working coil according to a fourth embodiment.
FIG. 50 is a cross-sectional view of a non-connection region of a coil pattern of a working coil according to a fourth embodiment.
FIG. 51 is a cross-sectional view of AA1-AA2 portion of a connection region of a coil pattern of a working coil according to a fourth embodiment.
FIG. 52 is a cross-sectional view of BB1-BB2 portion of a connection region of a coil pattern of a working coil according to a fourth embodiment.
FIG. 53 is a circuit diagram of a sensing circuit according to an embodiment.
FIG. 54 is a diagram illustrating a waveform of a resonance signal output from an output node of a sensing circuit according to an embodiment.
FIG. 55 is a diagram illustrating a waveform of a square wave output from a comparator of a sensing circuit according to an embodiment.

### Embodiments for implementing the invention

The purposes, features and advantages described above will be described in detail below with reference to the accompanying drawings, so that a person having ordinary knowledge in the technical field to which the present disclosure pertains can easily practice the technical idea of the present disclosure. In describing the present disclosure, if it is determined that a detailed description of a known technology related to the present disclosure may unnecessarily obscure the gist of the present disclosure, the detailed description thereof will be omitted. Hereinafter, preferred embodiments of the present disclosure will be described in detail with reference to the accompanying drawings. In the drawings, like reference numerals are used to refer to like or similar components.

Although the terms "first", "second", and so on are used to describe various components, these components are not limited by these terms. These terms are merely used to distinguish one component from another component, and unless specifically stated to the contrary, it should be understood that a first component may also be a second component.

The present disclosure may not be limited to embodiments disclosed below, and various changes may be made and the present disclosure may be implemented in various different forms. The present embodiment is provided solely to ensure that the disclosure of the present disclosure is complete and to fully inform those skilled in the art of the scope of the invention. Therefore, it should be understood that the present disclosure is not limited to the embodiments disclosed below, but includes all changes, equivalents or substitutes included in the technical idea and the scope of the present disclosure, as well as substitution of components of an embodiment with components of another embodiment and addition of components.

The attached drawings are only for easy understanding of the embodiments disclosed herein, and the technical ideas disclosed herein are not limited by the attached drawings. Further, it should be understood that the present disclosure includes all modifications, equivalents or substitutions that fall within the technical concept and scope of the present disclosure. In drawings, components may be expressed exaggeratedly large or small in size or thickness for convenience of understanding or the like, but the scope of protection of the present disclosure should not be interpreted as limited by the same.

The terms used herein are merely used to describe specific implementations or embodiments, and are not intended to limit the present disclosure. Further, singular expressions include plural expressions, unless the context clearly dictates otherwise. Herein, terms such as "comprise", "include", "have", "be provided with", "composed of", and the like are intended to indicate the existence of features, numbers, steps, operations, components, parts, or combinations thereof described herein. That is to say, it should be understood that terms such as "comprise", "include", "have", "be provided with", "composed of", and the like as used herein do not exclude in advance the presence or addition of one or more other features, numbers, steps, operations, components, parts, or combinations thereof.

Terms including ordinal numbers, such as first, second, and the like, may be used to describe various components, but the components are not limited by the terms. The above terms are used only for the purpose of distinguishing one component from another.

When a first component is described as being "connected" or "coupled" to a second component, it should be understood that the components may be directly connected or coupled to each other, but a third component may be interposed between the components. On the other hand, when it is described that the first component is "directly connected" or "directly coupled" to the second component, it should be understood that there are no other components interposed therebetween.

When a component is described to be "on top of" or "under" another component, it is understood that the component may be disposed in contact with a top surface (or a bottom surface) of the other component, as well as that still another component may be interposed therebetween.

Unless otherwise defined, all terms used herein, including technical or scientific terms, have the same meaning as commonly understood by a person of ordinary skill in the technical field to which the present disclosure pertains. Terms defined in commonly used dictionaries should be interpreted as having a meaning consistent with the meaning in the context of the related technology, and unless explicitly defined in the present application, should not be interpreted in an ideal or excessively formal sense.

When the appliance is placed on the floor, the direction in which the door is installed is defined as forward based on the center of the home appliance. Therefore, the direction of entering the inside of the appliance after opening the door is rearward. And, the horizontal direction perpendicular to the front and rear directions of the home appliance, that is, the width direction of the home appliance when looking at the home appliance from before the door of the home appliance may be referred to as the left and right directions.

For convenience, the left and right directions may be referred to as a first direction. Then, a right side may be referred to as one side in the first direction, and a left side may be referred to as the other side in the first direction.

Additionally, the width direction of the home appliance may be referred to as the lateral direction. Then, a right side may be referred to as one side in the lateral direction, and a left side may be referred to as the other side in the lateral direction.

Additionally, the direction of gravity may be defined as a down direction, and a direction opposite to the direction of gravity may be defined as an up direction.

For convenience, the direction toward the front and the rear may be referred to as the second direction. Then, the front side may be referred to as one side in the second direction, and the rear side may be referred to as the other side in the second direction.

Additionally, the up and down directions described above may be referred to as a third direction. Then, the up direction may be referred to as one side in the third direction, and the down direction may be referred to as the other side in the third direction.

Additionally, the up and down directions described above may be referred to as a vertical direction. Then, both the front and rear direction and left and right direction, that is, both the first direction and the second direction may be referred to as a horizontal direction.

Throughout the present document, "A and/or B" means A, B, or A and B, unless otherwise specified, and "C to D" means equal to or greater than C and equal to or smaller than D unless otherwise specified.

### [Overall structure of home appliance]

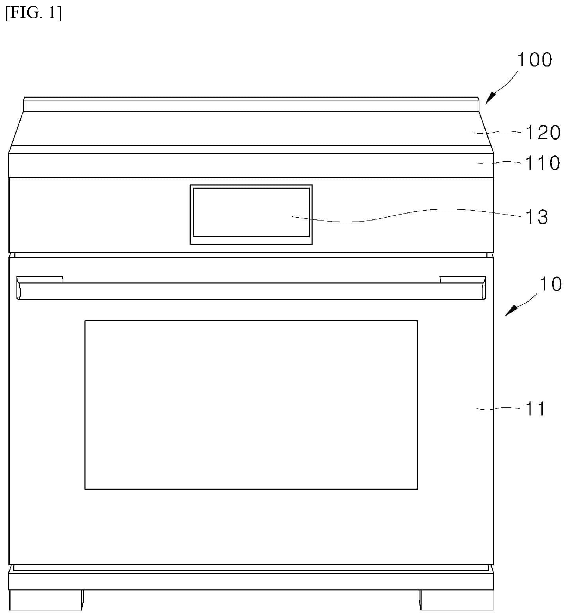

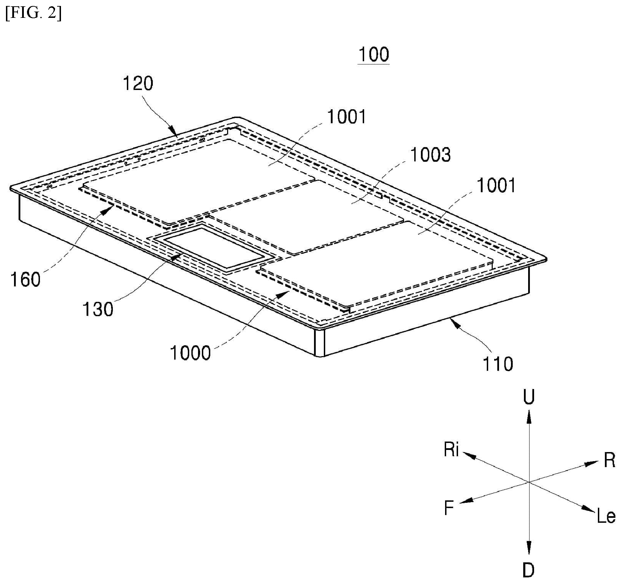

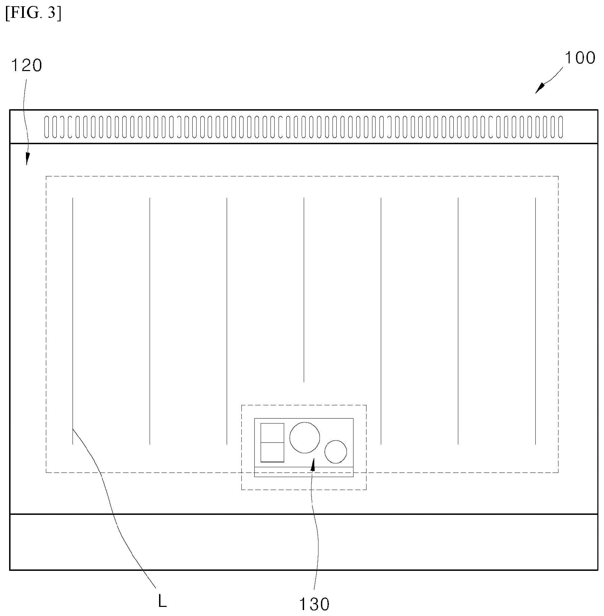

FIG. 1 is a perspective view illustrating a home appliance according to an embodiment; FIG. 2 is a plan view separately showing a cooktop shown in FIG. 1; and FIG. 3 is a view showing the indicator lamp lighting status of the cooktop shown in FIG. 2.

Referring to FIGS. 1 to 3, the home appliance according to an embodiment may include the cooktop 100. Additionally, the home appliance according to an embodiment may further include an oven part 10. In this embodiment, the home appliance is exemplified as being provided in the form of an oven range.

The home appliance according to an embodiment provided in the form of an oven range can provide both the function of an oven, which is a closed home appliance, and the function of a cooktop, which is an open home appliance. This home appliance may include the oven part 10 and the cooktop 100.

The oven part 10 may have a cooking chamber formed therein. In the oven part, food can be cooked as the inside of the cooking chamber is heated.

In the oven part 10, a heating part may be provided to heat the cooking chamber. The heating part may be provided as a heating device using gas fuel, or may be provided as a heater using electricity.

In the home appliance, a door 11 may be rotatably provided to selectively open and close the cooking chamber. As an example, the door may be provided in the form of opening and closing the cooking chamber in a pull-down manner in which the upper end pivots up and down around the lower end thereof.

In the front surface upper portion of the home appliance, a control panel 13 (hereinafter, referred to as a "main control panel") may be provided. The main control panel 13 may form a part of the front surface exterior of the home appliance. This main control panel 13 may be provided with various switches for adjusting the operation of the home appliance, a display for displaying the operation state of the home appliance, and the like.

In the upper side of the oven part 10, the cooktop 100 may be disposed. The cooktop is provided to heat food or a container containing food placed on the top of the cooktop 100.

### [Overall structure of cooktop]

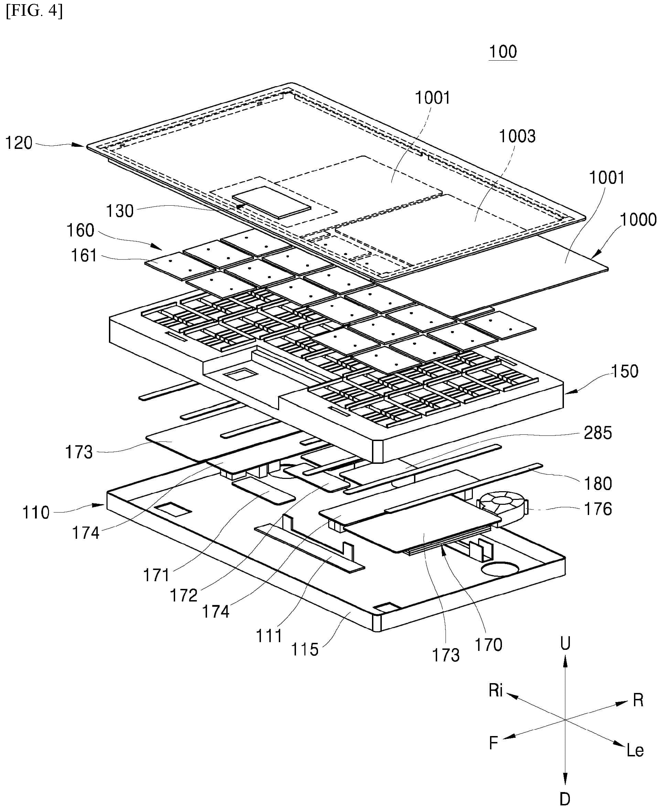

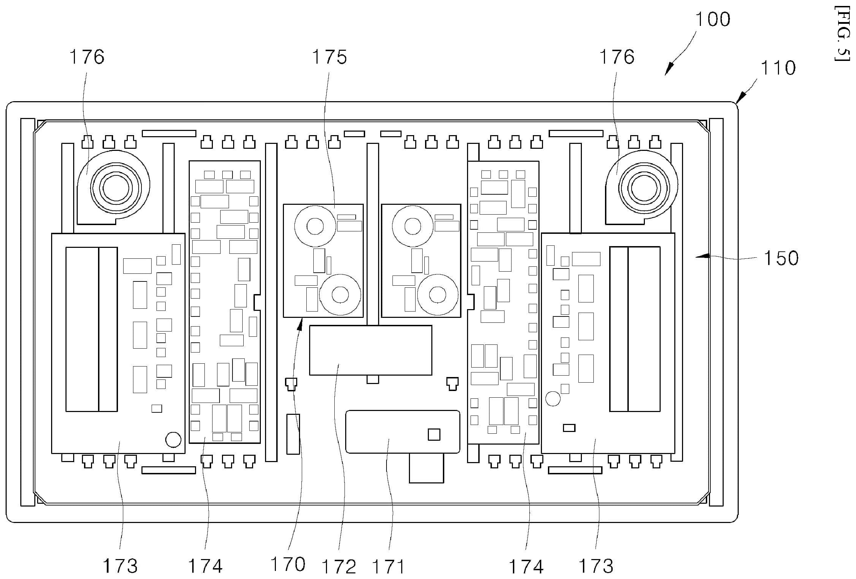

FIG. 4 is an exploded perspective view showing an exploded state of the cooktop shown in FIG. 2, and FIG. 5 is a view showing a state in which electronic components are installed on the bottom surface of a supporter shown in FIG. 4.

Referring to FIGS. 1 to 5, the cooktop 100 may include a case 110 and a top plate 120. In an embodiment, the exterior of the cooktop 100 may be formed by the case 110 and the top plate 120. The case 110 may be disposed in the lower side of the top plate 120, and may form a front surface, a rear surface, side surfaces, and a bottom surface of the cooktop. The top plate 120 may be disposed on an upper end of the cooktop 100, and may form a top surface exterior of the cooktop 100.

In the inside of the case 110, an accommodation space may be formed. The accommodation space formed in the inside of the case 110 may be opened toward the upper side. As an example, the case 110 may be formed in a hexahedral shape with an open upper side. In the accommodation space surrounded by the top plate 120 and the case 110, various internal components may be accommodated to constitute the cooktop 100.

In an embodiment, the case 110 may include a bottom portion 111. The bottom portion 111 may form a bottom surface of the case 110 to define a lower boundary surface of the accommodation space. The bottom portion 111 may be disposed under the top plate 120 to form a plane parallel to the top plate 120.

Additionally, the case 110 may include a side wall portion 113. The side wall portion 113 may form the front surface, the rear surface, and both side surfaces of the case 110 to be formed in a vertical wall shape extending upward from an edge of the bottom portion 111. This side wall portion 113 may define a horizontal boundary surface of the accommodation space.

Additionally, the cooktop 100 may be provided with a heating part for heating food to be cooked or a container containing the food (hereinafter referred to as "an object to be heated"). The heating part may be provided with at least more than one burner. For example, the burner may be provided in a form of including a working coil or a heating wire coil using electricity.

In this embodiment, the cooktop 100 is exemplified as being provided in the form of an induction heating device. This burner of the cooktop 100 may include a working coil. The burner including the working coil as described above can be operated by the high-frequency current applied by an inverter to generate strong magnetic field lines.

The magnetic field lines generated in the burner including the working coil as described above can generate eddy currents in the container, and heat can be generated due to the flow of the eddy currents in the container, so that the container can be heated, and thus the food contained in the container can be heated due to the heating of the container.

Additionally, the cooktop 100 according to an embodiment may be provided with a control panel 130. The control panel 130 may be disposed in the top plate 120. This control panel 130 may be provided with a manipulation part including various switches for adjusting the operation of the cooktop 100, a display for displaying the operation state of the cooktop 100, and the like.

The cooktop 100 may be provided with a plurality of indicator lamps L. The indicator lamp L may be indicated in the top plate 120 of the cooktop. This indicator lamp L may display information related to the location of the food to be heated or the cooking container containing the food (hereinafter referred to as "a body to be heated"), the heating state, temperature, or the like of the object to be heated.

The cooktop 100 according to an embodiment may include a coil assembly 1000. The coil assembly 1000 may be provided to constitute the heating part of the cooktop 100, and may be disposed in an accommodation space inside the cooktop 100.

Additionally, the cooktop 100 may include a supporter 150. The supporter 150 may be disposed in the lower side of the top plate 120. This supporter 150 may be disposed in a space surrounded by the top plate 120 and the case 110, that is, the accommodation space.

The supporter 150 may form a frame for supporting various internal components constituting the cooktop 100 in the inside of the cooktop 100. For example, the supporter 150 may be formed in a hexahedral shape with an open lower side. For example, the supporter 150 may be formed approximately in a shape of an upside-down version of the case 110 to have a size slightly smaller than that of the case 110.

In an embodiment, the accommodation space may be formed in the inside of the supporter 150 to be formed as a space surrounded by the bottom portion 111 of the case 110 and the supporter 150. That is, various internal components constituting the cooktop 100 may be accommodated in the inside of the supporter 150.

In an embodiment, the supporter 150 may also provide a coil base function. That is, on the supporter 150 a ferrite core 160 may be installed, and the coil assembly 1000 may be installed on the upper side of the supporter 150 on which the ferrite core 160 is installed in this way.

As an example, the ferrite core 160 may be formed by a combination of a plurality of ferrite modules 161 provided as separate elements. That is, the ferrite core 160 may be provided in a structure in which it may be separated into a plurality of ferrite modules 161.

In the present embodiment, the ferrite modules 161 are illustrated as each being provided to be coupled to the supporter 150. To this end, the supporter 150 may have a structure formed therein for the fitting with the ferrite modules 161. Each ferrite module 161 may be coupled to the supporter 150 by being fitted into the structure.

Each ferrite module 161 includes ferrite capable of forming a magnetic field around the ferrite module 161. As an example, each ferrite module 161 may be provided in a form in which ferrite is insert-injected.

According to the ferrite core 160 formed by a combination of the plurality of ferrite modules 161 provided as described above, the number of work hours required to install the ferrite core 160 in the cooktop 100 can be reduced. Additionally, the ferrite core 160 has the advantage in that, if a portion of the ferrite core 160 is damaged, its repair can be done by replacing the ferrite module 161 corresponding to that portion.

Each of the indicator lamps L may be implemented by a lighting module 180. The lighting module 180 is provided to emit light toward a light display area of the top plate 120. As an example, the indicator lamp L may be implemented by light irradiated by the lighting module 180 to the light display area of the top plate 120.

In this embodiment, the light display area is an area in which light emitted from the lighting module 180 can be recognized from the outside through the top plate 120, that is, an area in which light emitted from the lighting module 180 is irradiated from on the top plate 120, and is defined as a predetermined partial area of the entire area of the top plate 120.

As an example, the light display area may be a virtual area designated as a portion where light emitted from the lighting module 180 is to be irradiated from on the top plate 120. In this case, the light display area is not a part noticeably marked on the top plate 120 by a method such as performing a separate surface treatment on the surface of the top plate 120, but only a virtual area.

As another example, the light display area may be an area noticeably marked on the top plate 120 by a method such as performing a separate surface treatment on the surface of the top plate 120.

The lighting module 180 may include a light source. As an example, an LED may be applied as a light source, but the kind of light source applicable as a light source is not limited to an LED.

The lighting module 180 may include a plurality of light sources, which may be disposed in each lighting module 180 to be spaced apart from each other by a predetermined interval in front and rear directions. As an example, the lighting module 180 may be provided in a form in which a plurality of light sources are mounted on a PCB in the form of a PCB. The number of light sources for each lighting module 180 and the length of the PCB in front and rear directions may be appropriately set according to the size or intensity of the lighting to be implemented through the lighting module 180.

Additionally, a plurality of lighting modules 180 may be disposed in the cooktop, and the plurality of lighting modules 180 may be disposed to be spaced apart from each other by a predetermined interval in the lateral direction. The number of lighting modules 180 and the distance between the lighting modules 180 may be appropriately set by considering the size of the working coil and number of the working coils, the distance between the working coils, and the like.

At least a portion of the lighting module 180 may be disposed between the supporter 150 and the bottom portion 111. As an example, the lighting module 180 may be disposed in the accommodation space. More specifically, the lighting module 180 may be disposed in a space surrounded by the bottom portion 111 of the case 110 and the supporter 150.

In the inside of the cooktop 100, that is, in the accommodation space, various electronic components may be installed. For example, in the inner space of the cooktop 100, a main PCB 171, a switching mode power supply (SMPS) 162, an inverter PCB 163, a resonance PCB (Resonant PCB) 164, a noise filter (EMI filter) 165, a fan 176, and the like may be disposed.

Hereinafter, the electronic components will be collectively referred to as an electronic unit 170. The electronic unit 170 may include at least one of a power processing part and a coil controlling part. The power processing part may be provided to supply power to the coil assembly 1000, and the power processing part may include the switching mode power supply (SMPS) 162, the noise filter (EMI filter 165), and the like. The coil controlling part is provided to control the operation of the coil assembly 1000, and the coil controlling part may include an inverter PCB 174, and the like.

### [Overall structure of coil assembly]

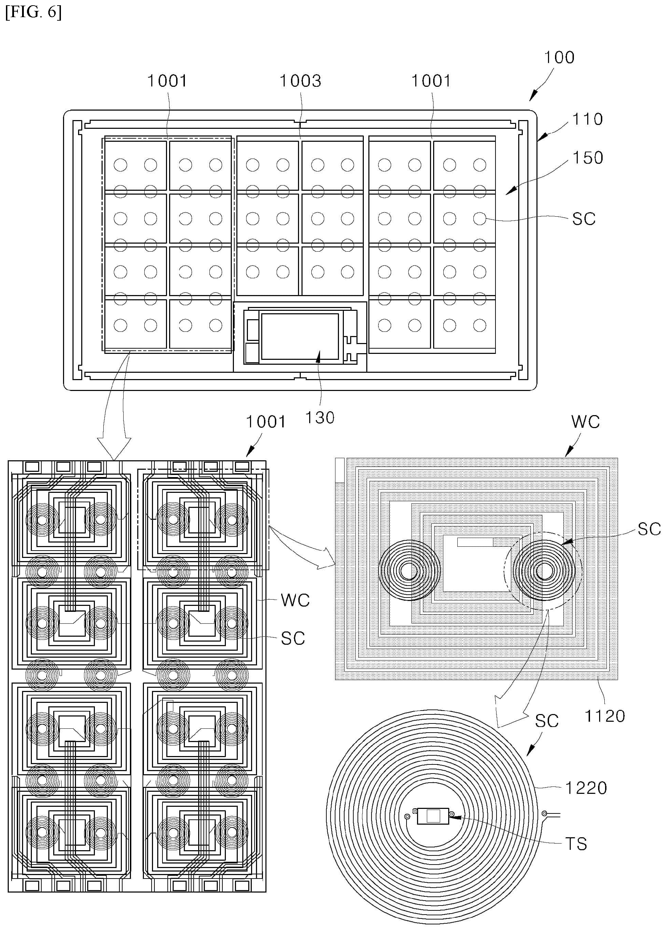

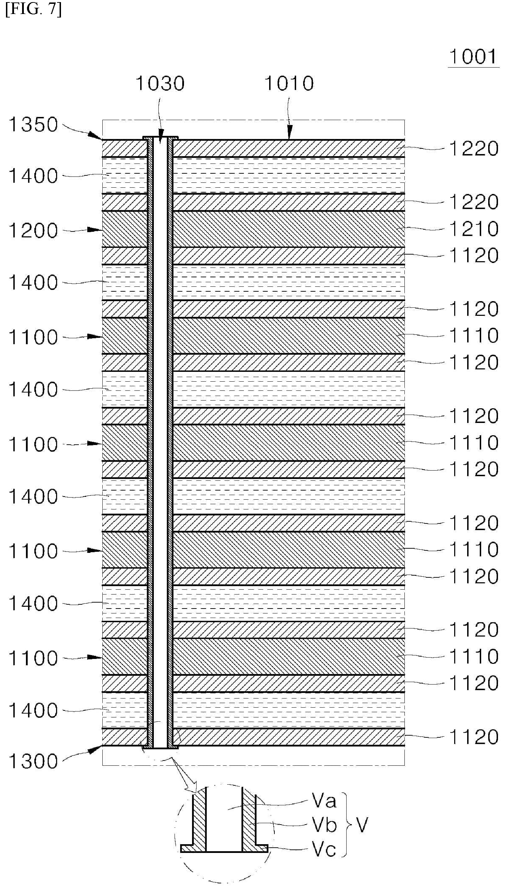

FIG. 6 is a view schematically showing the configuration of the coil assembly shown in FIG. 4, and FIG. 7 is a cross-sectional view schematically showing a stacked structure of a coil module shown in FIG. 6.

Referring to FIGS. 4 and 6, the coil assembly 1000 may include a plurality of working coils WC arranged in a horizontal direction. As an example, in the coil assembly 1000, a plurality of working coils WC may be arranged along the first direction, that is, the lateral direction, and a plurality of working coils WC may be arranged in the second direction, that is, the front and rear directions.

The coil assembly 1000 may include at least one coil module 1001, 1003. In the present embodiment, the coil assembly 1000 is exemplified as including a plurality of coil modules 1001, 1003.

As an example, the coil assembly 1000 may include a plurality of coil modules 1001, 1003 arranged in the horizontal direction. For example, the coil assembly 1000 may include a plurality of coil modules 1001, 1003 arranged in the first direction.

In each of the coil modules 1001, 1003, as illustrated in FIGS. 6 and 7, a plurality of working coils WC may be disposed in the horizontal direction. Each of the working coils WC may be provided in a form in which a spiral coil is formed as a pattern on a printed circuit board. That is, the working coil 142 may be provided in the form of a pattern formed in the coil modules 1001, 1003.

Each of the coil modules 1001, 1003 may include a coil substrate-stacked body 1010. The coil substrate-stacked body 1010 may include a plurality of first coil substrate portions 1100 stacked in the up and down directions.

Each of the first coil substrate portions 1100 may include a first coil portion 1120. As an example, the first coil portion 1120 may be formed as a result of a metal foil stacked on the surface of the first coil substrate portion 1100 being patterned into a spiral coil shape.

In an embodiment, a plurality of first coil substrate portions 1100 may be stacked in the up and down directions to form one coil module 1001, 1003, and thereby, a plurality of first coil portions 1120 may be stacked in the up and down directions. And the plurality of first coil portions 1120 stacked in the up and down directions may be connected to each other in the up and down directions to form each one of the working coils WC.

Additionally, each first coil substrate portion 1100 may have a plurality of second coil portions 1120 arranged in the horizontal direction, and accordingly, the coil module 1001, 1003 may include a plurality of working coils WC arranged in the horizontal direction.

Additionally, the coil assembly 1000 according to an embodiment may include a sensing coil SC for sensing the presence of an object to be heated, as shown in FIGS. 6 to 7. Each of the coil modules 1001, 1003 may include a plurality of sensing coils SC arranged in the horizontal direction. As an example, in the coil assembly 1000, a plurality of sensing coils SC may be arranged along the first direction, that is, the lateral direction, and a plurality of sensing coils SC may be arranged in the second direction, that is, the front and rear directions.

Each of the sensing coils SC may be provided in a form in which a spiral coil is formed as a pattern on a printed circuit board. That is, the sensing coil SC may be provided in the form of a pattern formed in the coil modules 1001, 1003.

In an embodiment, the coil substrate-stacked body 1010 may include at least one second coil substrate portion 1200. The second coil substrate portion 1200 may be stacked in the up and down directions together with the first coil substrate portion 1100. That is, at least one second coil substrate portion 1200 and a plurality of first coil substrate portions 1100 may be stacked in the up and down directions to form one coil module 1001, 1003. Accordingly, in each of the coil modules 1001, 1003, at least a portion of the working coil WC and the sensing coil SC may be arranged in the up and down directions.

Each of the second coil substrate portions 1200 may include a second coil portion 1220. As an example, the second coil portion 1220 may be formed as a result of a metal foil stacked on the surface of the second coil substrate portion 1200 being patterned into a spiral coil shape.

Each sensing coil SC may be formed by one second coil portion 1220, or may be formed as a result of connecting a plurality of second coil portions 1220 stacked in the up and down directions to each other in the up and down directions.

Additionally, each first coil substrate portion 1200 may have a plurality of second coil portions 1220 arranged in the horizontal direction, and accordingly, the coil module 1001, 1003 may include a plurality of sensing coils SC arranged in the horizontal direction.

Additionally, the coil assembly 1000 according to an embodiment may further include a temperature sensor TS. The temperature sensor TS may be provided to measure the temperature of the object to be heated, and may be disposed in the second coil substrate portion 1200.

The temperature sensor TS may be disposed in the inner side of the sensing coil SC in the horizontal direction. For example, the temperature sensor TS may be installed in the second coil substrate portion 1200 to be disposed within an area surrounded by the sensing coil SC.

In present disclosure, embodiments are described in which the coil assembly 1000 is used in a home appliance. However, in another embodiment, the coil assembly 1000 may be applied to other devices requiring induction heating. For example, the coil assembly 1000 may be mounted in a washing machine to be used to heat a water tank, drum, or laundry container in the inside of the washing machine, or to heat the washing water. As another example, the coil assembly 1000 may be mounted on a water purifier to be used to heat a hot water pipe or a water tank. As still another example, the coil assembly 1000 may be mounted on a clothes dryer or a clothes manager to be used to heat air for drying clothes. As yet another example, the coil assembly 1000 may be mounted on an electric pot or a rice cooker to be used to heat the liquid or food in the inside of the device.

### [Layout structure of coil modules]

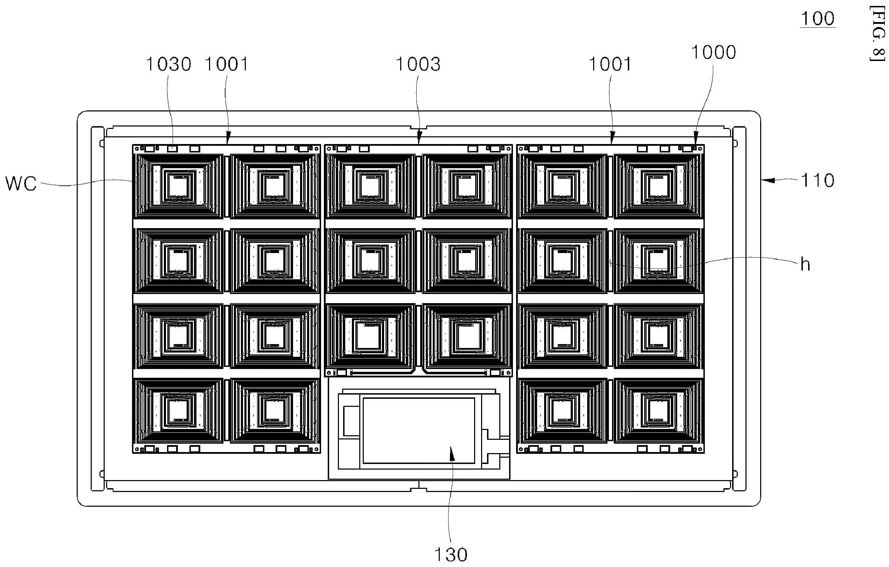

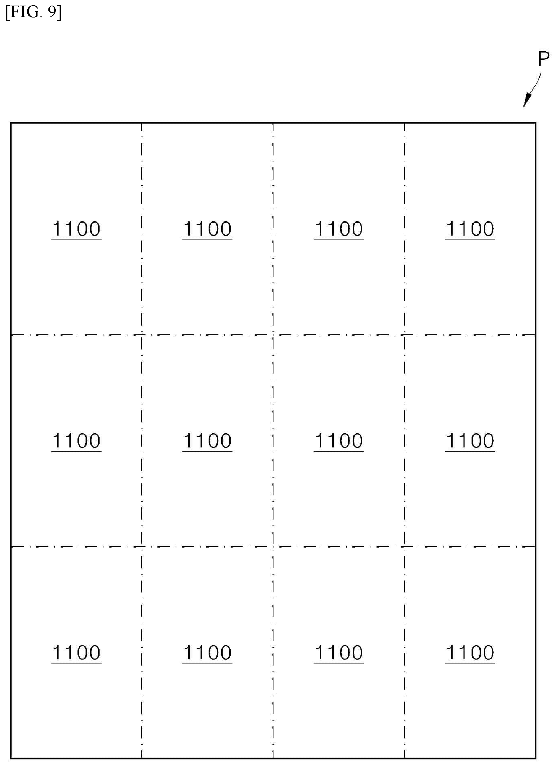

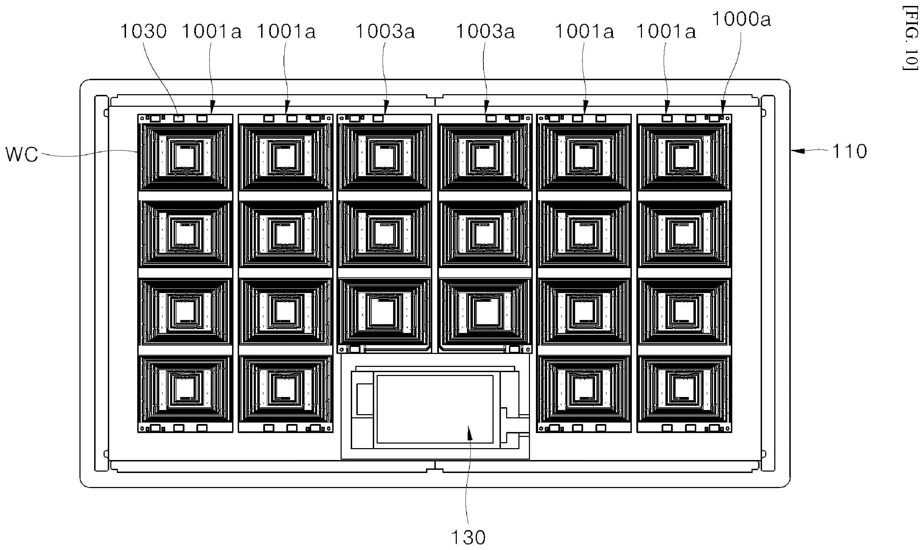

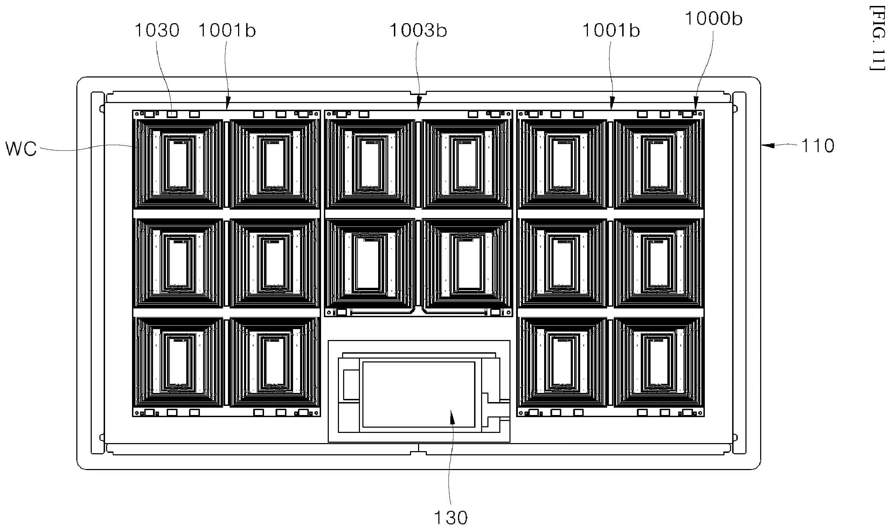

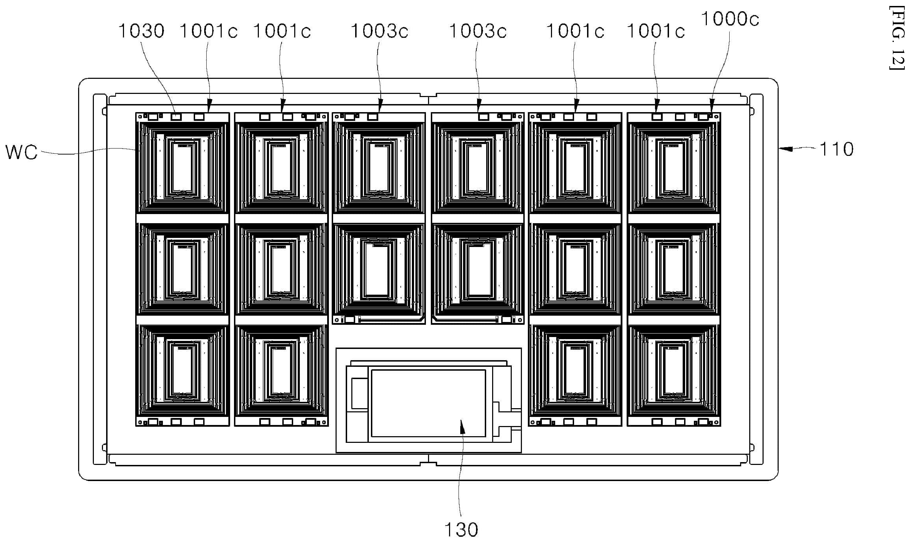

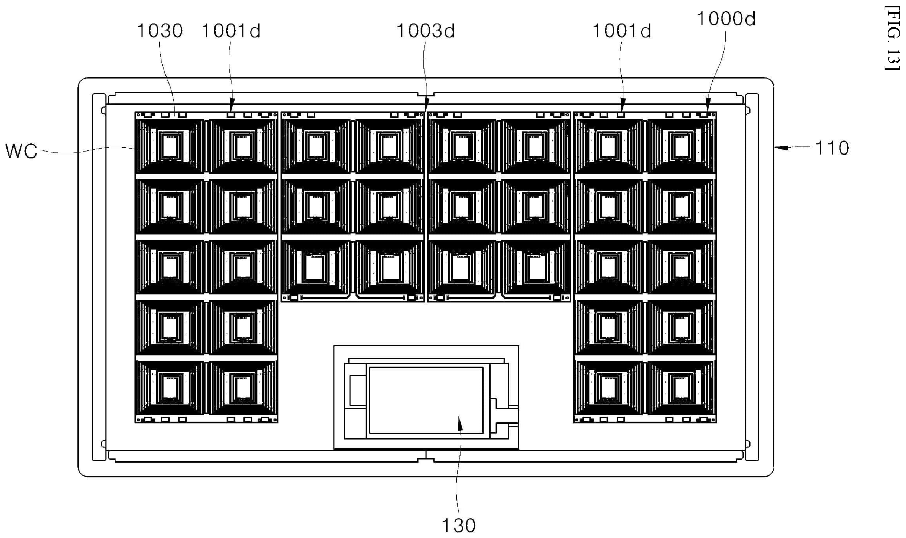

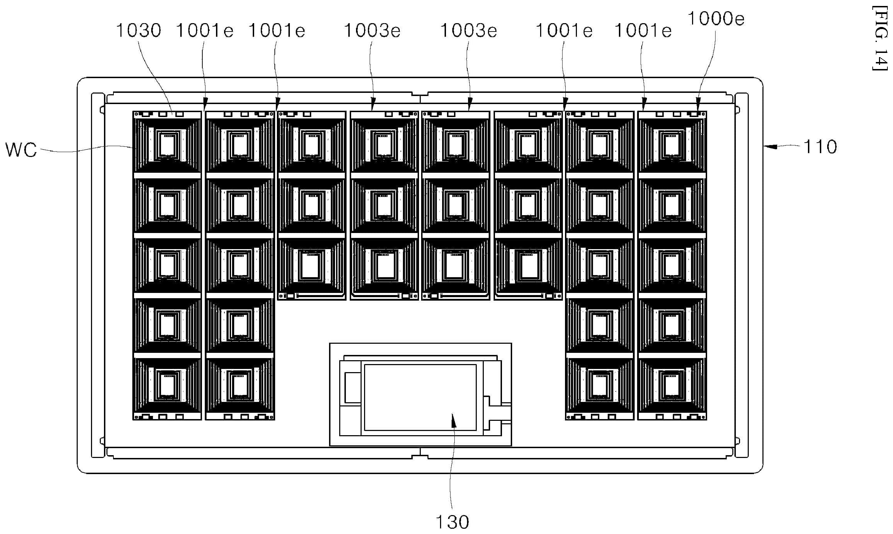

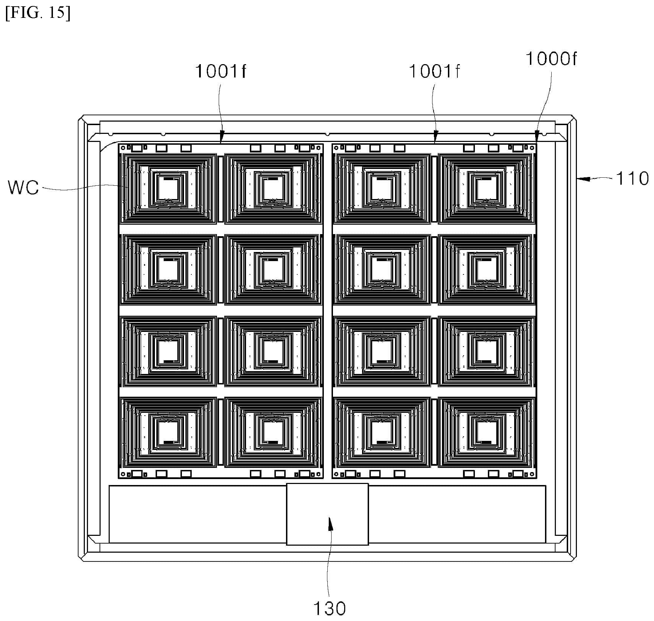

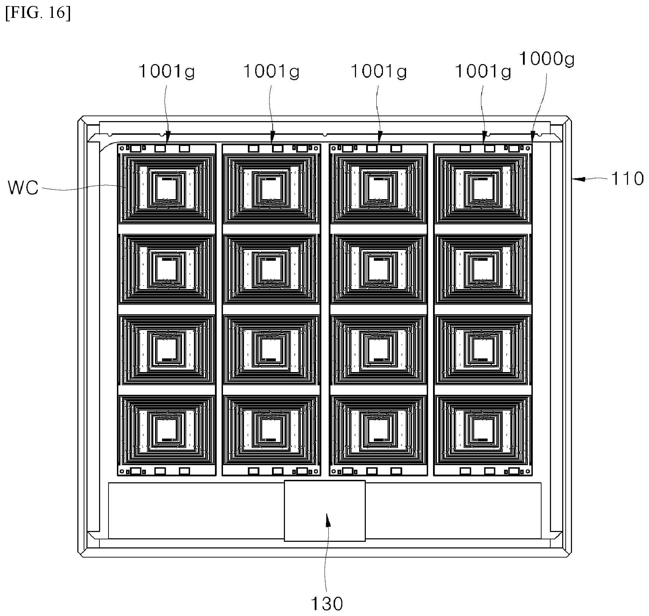

FIG. 8 is a plan view showing a first example of a layout structure of a first coil module and a second coil module, and FIG. 9 is a view schematically illustrating an example of the cutting state of an original substrate for forming a first coil substrate portion. Also, FIG. 10 is a plan view showing a second example of a layout structure of a first coil module and a second coil module; FIG. 11 is a plan view showing another example of a layout structure of a first coil module and a second coil module shown in FIG. 8; and FIG. 12 is a plan view showing another example of a layout structure of a first coil module and a second coil module shown in FIG. 10. Also, FIG. 13 is a plan view showing a third example of a layout structure of a first coil module and a second coil module, and FIG. 14 is a plan view showing a fourth example of a layout structure of a first coil module and a second coil module. Also, FIG. 15 is a plan view showing a fifth example of a layout structure of a first coil module and a second coil module, and FIG. 16 is a plan view illustrating a sixth example of a layout structure of a first coil module and a second coil module.

Referring to FIGS. 4 and 8, the coil assembly 1000 according to an embodiment may include a plurality of coil modules 1001, 1003, and a plurality of coil modules 1001, 1003 may be arranged in this coil assembly 1000 along the horizontal direction. As an example, in the coil assembly 1000, a plurality of coil modules 1001, 1003 may be arranged along the first direction.

As described above, the cooktop 100 according to an embodiment may include the control panel 130. The control panel 130 may be disposed in the top plate 120 at a position biased toward the front.

With respect to the first direction, the control panel 130 may be disposed approximately at the center of the coil assembly 1000. With respect to the second direction, the control panel 130 may be disposed at a position biased toward the front side of the coil assembly 1000.

The coil assembly 1000 is disposed in the lower side of the top plate 120, but is not disposed in the lower side of an area of the top plate 120, which is occupied by the control panel 130. That is, the working coil WC is disposed in the lower side of only an area of the top plate 120, which is not occupied by the control panel 130, and is not disposed in the lower side of an area of the top plate 120, which is occupied by the control panel 130.

This coil assembly 1000 may include several types of coil modules 1001, 1003 having different sizes. In the present embodiment, the coil modules 1001, 1003 are illustrated as including a first coil module 1001 and a second coil module 1003. The first coil module 1001 may include a plurality of working coils WC, and the second coil module 1003 may include working coils WC whose number is smaller than that of the first coil module 1001.

In an embodiment, the first coil module 1001 and the second coil module 1003 may be arranged along the horizontal direction in the coil assembly 1000. Additionally, with respect to the second direction, the length of the second coil module 1003 may be set shorter than the length of the first coil module 1001. That is, the second coil module 1003 may be provided in a form that has a shorter second direction length and includes a smaller number of working coils WC than the first coil module 1001.

In the coil assembly 1000, a pair of first coil modules 1001 and at least one second coil module 1003 may be arranged along the first direction. In this case, the pair of first coil modules 1001 may be disposed to be spaced apart from each other along the first direction. And at least one second coil module 1003 may be disposed between the pair of first coil modules 1001.

For example, similarly to the control panel 130, at least one second coil module 1003 may be disposed in the first direction center of the coil assembly 1000. At least one second coil module 1003 and the control panel 130 as described above may be disposed on the same straight line in the second direction.

With respect to the first direction, the control panel 130 may be disposed between the pair of first coil modules 1001. Additionally, with respect to the second direction, the control panel 130 may be disposed at a position more biased toward one side than the second coil module 1003, for example, at the front side of the second coil module 1003. Accordingly, at least a portion of the control panel 130 can be disposed in an area surrounded by the pair of first coil modules 1001 and the second coil module 1003.

That is, the control panel 130 is disposed in a position where visual information provided through the control panel 130 can be easily seen by the user, and in a position where the user can easily operate the control panel 130. This control panel 130 occupies a predetermined area on the top surface of the cooktop 100.

Additionally, since the working coil WC cannot be disposed in the area where the control panel 130 occupies on the top surface of the cooktop 100, the working coil WC must be disposed in the remaining area except the area occupied by the control panel 130. Accordingly, the coil assembly 1000 with the working coils WC is disposed in an area where the control panel 130 does not occupy on the top surface of the cooktop 100. For example, the horizontal direction outer shape of the coil assembly 1000 may be formed in a shape of an upside-down version of a " 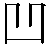 " shape.

The coil assembly 1000 may include coil modules 1001, 1003 provided with working coils WC, wherein the coil modules 1001, 1003 are of several kinds and have different second direction lengths. In the present embodiment, the coil assembly 1000 is illustraed as including two kinds of coil modules 1001, 1003, that is, the first coil module 1001 and the second coil module 1003.

As an example, the horizontal direction outer shape of the coil module 1001, 1003 (hereinafter, referred to as "outer shape of the coil module") may be formed in a rectangular shape. That is, the outer shapes of the first coil module 1001 and the second coil module 1003 may be formed in a rectangular shape, respectively.

For example, the shape of the second coil module 1003 may be formed in a rectangular shape having a second direction length different from that of the first coil module 1001. And the second coil module 1003 and the control panel 130 may be disposed on the same straight line in the second direction, and the second coil module 1003 may be disposed in the rear side of the control panel 130.

Considering that the second coil module 1003 and the control panel 130 are disposed on the same straight line in the second direction, the second direction length of the second coil module 1003 is set to be shorter than the second direction length of the first coil module 1001.

As described above, the coil assembly 1000 may be made of a combination of a plurality of coil modules 1001, 1003 arranged in the horizontal direction, and each of the coil modules 1001, 1003 may be formed in a rectangular shape. That is, the coil assembly 1000 may not be formed by a single coil module formed in a shape of an upside-down version of a " 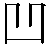 " shape, but by a combination of a plurality of coil modules 1001, 1003 formed in rectangular shapes.

In an embodiment, as shown in FIGS. 8 and 9, the first coil substrate portion 1100 forming each of the coil modules 1001, 1003 may be formed by a copper clad laminate (CCL), and each copper clad laminate forming each first coil substrate portion 1100 may be provided as a result of cutting the original substrate B of the copper clad laminate (hereinafter, referred to as "original substrate").

In a case where the first coil substrate portion 1100 is formed in the " 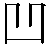 " shape or an inverted shape of the " 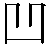 " shape, when the first coil substrate portion 1100 is manufactured by cutting the original substrate P, a loss of the original substrate P inevitably occurs as much as the amount cut out to secure a space for disposing the control panel 130. That is, in a case where the coil assembly 1000 is formed of one coil module 1001, 1003, there is a problem in that the loss of the original substrate P used to manufacture the first coil substrate portion 1100 increases.

On the other hand, in a case where the coil assembly 1000 is formed of a combination of a plurality of coil modules 1001, 1003, it is possible that each of the coil modules 1001, 1003 is formed in a rectangular shape. That is, the coil assembly 1000 can be formed in a " 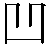 " shape or in a shape of an upside-down version of the " 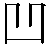 " shape by a combination of various kinds of coil modules 1001, 1003 having different sizes, for example, the first coil module 1001 and the second coil module 1003.

Accordingly, when manufacturing the first coil substrate portion 1100 by cutting the original substrate P, the original substrate P can be cut into a rectangular shape, and thereby, it is possible to reduce the loss occurring in the original substrate P used to manufacture the first coil substrate portion 1100.

In an embodiment, the working coil WC may be formed in a shape including a polygonal shape. For example, the horizontal direction outer shape of the working coil WC (hereinafter, referred to as "outer shape of the working coil") may be a polygonal shape.

As an example, the outer shape of the working coil WC may be approximately rectangular, and the horizontal direction outer shape of the cooktop 100 (hereinafter referred to as "outer shape of the cooktop") is also a shape close to an approximate rectangle. Considering this point, it is preferable that the horizontal direction outer shape of the coil module 1001, 1003 (hereinafter, referred to as "outer shape of the coil module") is rectangular.

Since the outer shape of the coil module 1001, 1003 is formed in a rectangular shape similar to the outer shape of the working coil WC, it is possible to effectively increase the density of the area in the coil module 1001, 1003, which is occupied by the working coil WC. Additionally, since the outer shape of the coil module 1001, 1003 is formed in a rectangular shape similar to the outer shape of the cooktop 100, it is possible to effectively increase the density of the area in the cooktop 100, which is occupied by the coil module 1001, 1003.

In other words, since the outer shape of the coil module 1001, 1003 is formed in a polygonal shape similar to the outer shape of the working coil WC and the outer shape of the cooktop 100, it is possible to effectively increase the density of the area in the cooktop 100, which is occupied by the working coil WC, thereby effectively increasing the extent of the area in the cooktop 100, which can heat the container.

Accordingly, the extent of the area in the cooktop 100, in which the container is in contact with the working coil WC can be increased, so that the heating efficiency of the cooktop 100 can be effectively improved.

On the other hand, the difference in length between the first coil module 1001 and the second coil module 1003 in the second direction may be adjusted by the difference in the number of working coils WC in the second direction. For example, working coils WC of the same size and shape may be provided to both the first coil module 1001 and the second coil module 1003, and the number of working coils WC in the second direction in the second coil module 1003 may be set to be one or more less than the number of working coils WC in the second direction in the first coil module 1001.

In this way, by differently setting the lengths of the first coil module 1001 and the second coil module 1003 as a method of adjusting the number of working coils WC, even if the size of the coil module 1001, 1003 is changed, there is no need to design the size and shape of the working coil WC differently according thereto. That is, various kinds of coil modules 1001, 1003 having different second direction lengths may all be provided in a form including one kind of a working coil WC.

Accordingly, not only can the cost and time required to design the working coil WC be reduced, but also various kinds of coil modules 1001, 1003 having different second direction lengths can be manufactured more easily and quickly at a lower cost.

In an embodiment, the control panel 130 and the second coil module 1003 may be disposed in the first direction center of the top surface of the cooktop 100, and first coil modules 1001 may be disposed in the both sides of the top surface of the cooktop 100 in the first direction.

As an example, the second direction length of the first coil module 1001 may be set to be approximately similar to the second direction length of the top surface of the cooktop 100. And the second direction length difference between the first coil module 1001 and the second coil module 1003 may be set to be greater than or equal to the second direction length of the working coil WC.

Accordingly, while most area of the top surface of the cooktop 100 can be filled with working coils WC, it is possible to secure an area necessary for disposing the control panel 130 on the top surface of the cooktop 100.

As an example, in the coil assembly 1000, a pair of first coil modules 1001 and one second coil module 1003 may be arranged along the first direction. In this case, the pair of first coil modules 1001 may be disposed to be spaced apart from each other along the first direction. And one second coil module 1003 may be disposed between the pair of first coil modules 1001.

For example, similarly to the control panel 130, one second coil module 1003 may be disposed in the first direction center of the coil assembly 1000. One second coil module 1003 and the control panel 130 as described above may be disposed on the same straight line in the second direction.

In this regard, the number of working coils WC included in each first coil module 1001 and the number of working coils WC included in each second coil module 1003 may be eight and six, respectively (see FIG. 8), or six and four, respectively (see FIG. 11).

As another example, in the coil assembly 1000a as shown in FIG. 10, two pairs of first coil modules 1001a and a pair of second coil modules 1003a may be arranged along the first direction. In this case, a pair of first coil modules 1001a may be disposed on one side of the pair of second coil modules 1003a in the first direction, and the other pair of first coil modules 1001a may be disposed on the other side of the pair of second coil modules 1003a in the first direction.

In this regard, the number of working coils WC included in each first coil module 1001a and the number of working coils WC included in each second coil module 1003a may be four and three, respectively (see FIG. 10), or three and two, respectively (see FIG. 12).

As another example, in the coil assembly 1000d, as shown in FIG. 13, a pair of first coil modules 1001d and a pair of second coil modules 1003d may be disposed to be spaced apart along the first direction. And a pair of second coil modules 1003d may be disposed between the pair of first coil modules 1001d.

As another example, in the coil assembly 1000e as shown in FIG. 14, two pairs of first coil modules 1001e and two pairs of second coil modules 1003e may be arranged along the first direction. In this case, a pair of first coil modules 1001e may be disposed on one side of the two pairs of second coil modules 1003e in the first direction, and the other pair of first coil modules 1001e may be disposed on the other side of the two pairs of second coil modules 1003e in the first direction.

Additionally, as shown in FIG. 15, only a pair of first coil modules 1001f may be arranged along the first direction, or as shown in FIG. 16, only two pairs of first coil modules 1001g may be arranged along the first direction.

### [Structure of working coil]

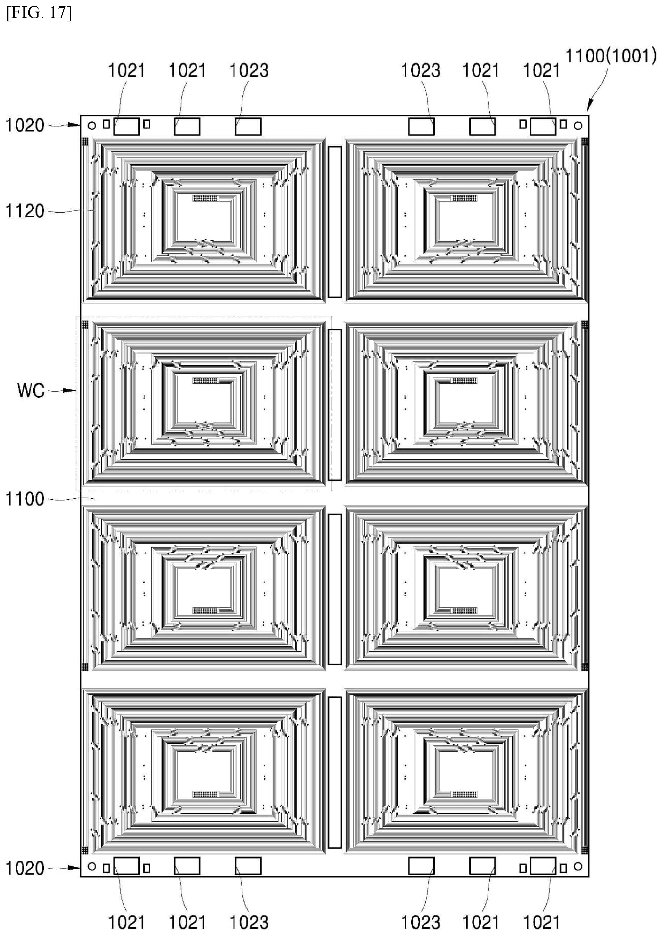

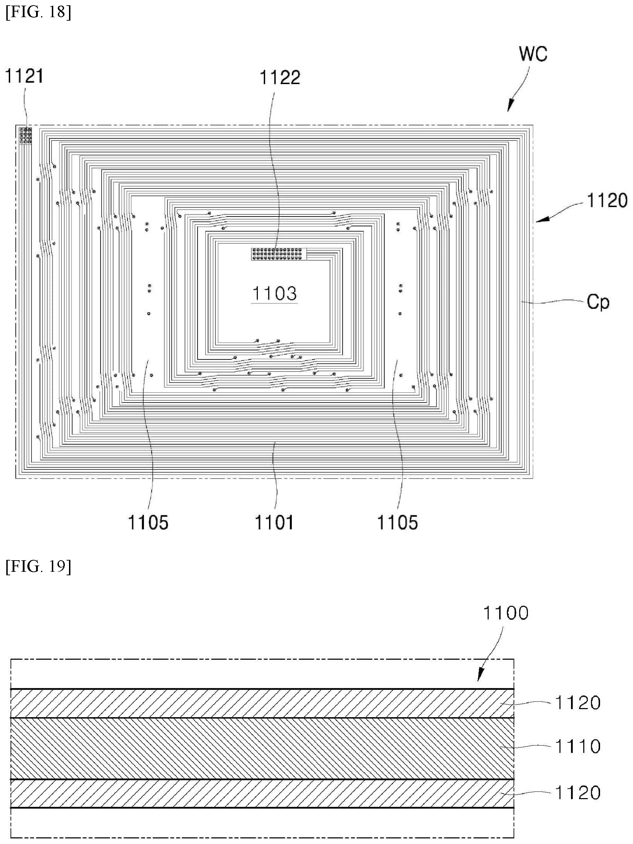

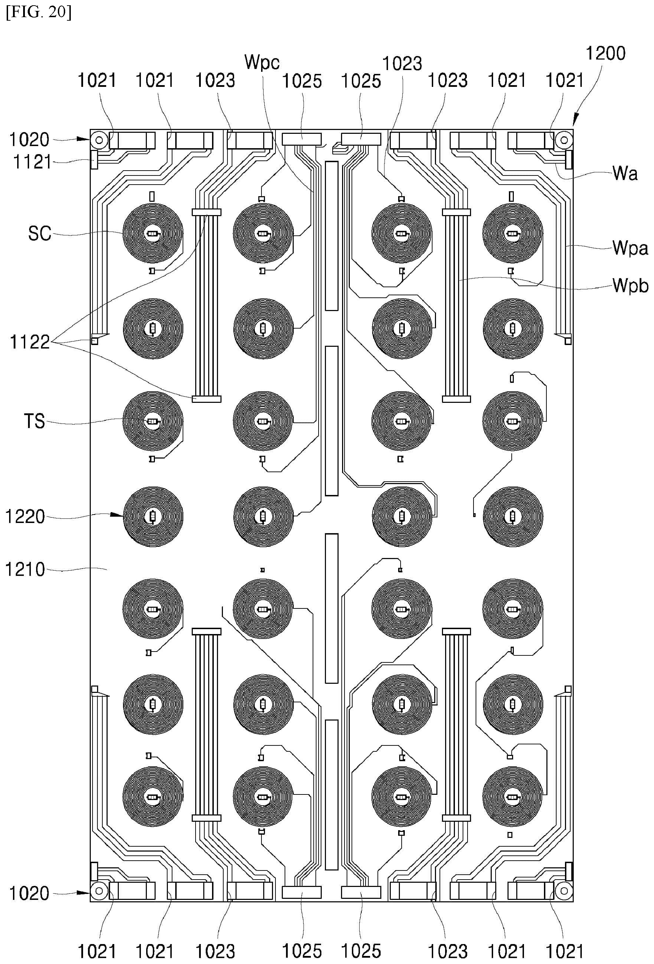

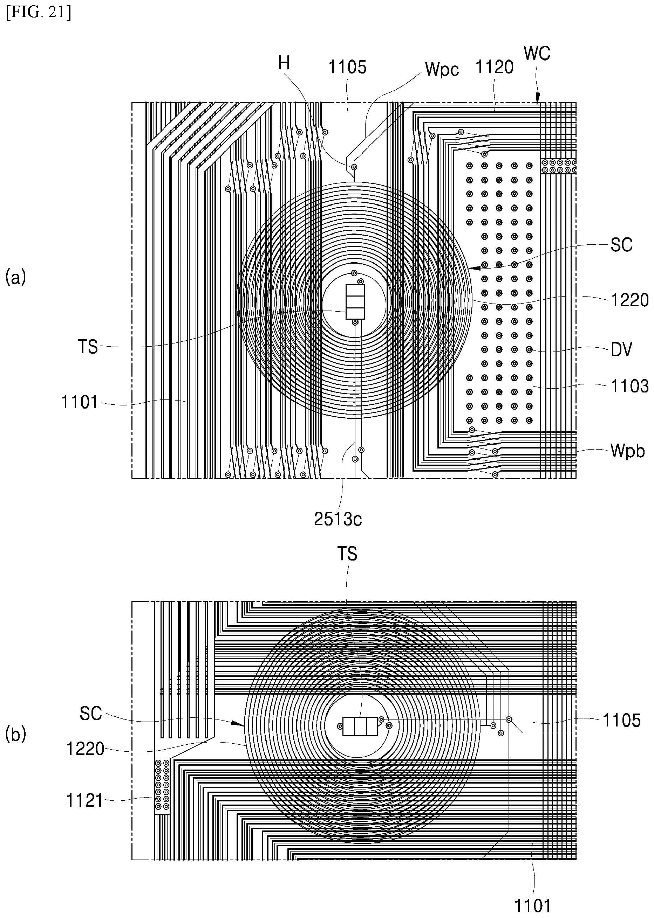

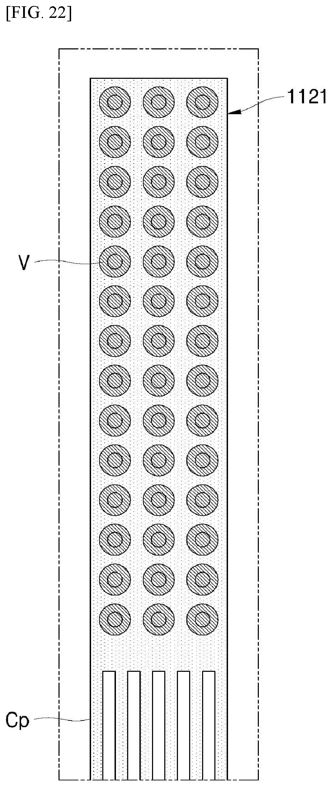

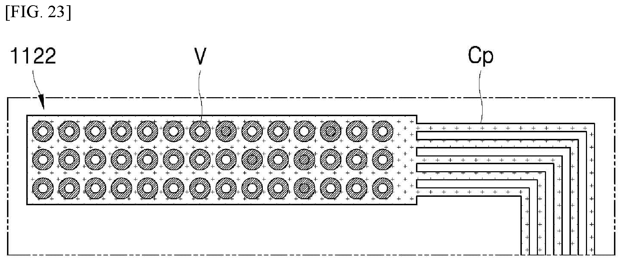

FIG. 17 is a plan view showing an example of a first coil substrate portion according to an embodiment; FIG. 18 is an enlarged view illustrating a portion of the first coil substrate portion shown in FIG. 17; and FIG. 19 is a cross-sectional view schematically showing a stacked structure of a first coil portion shown in FIG. 18. Also, FIG. 20 is a plan view showing an example of the layout structure of a sensing coil, and FIG. 21 is an enlarged view of part "21" in FIG. 20, which shows an example of a layout structure of a sensing coil with respect to a working coil. Also, FIG. 22 is an enlarged view of a first terminal shown in FIG. 18, and FIG. 23 is an enlarged view of a second terminal shown in FIG. 18.

In an embodiment, as shown in FIGS. 8, and 17 to 19, the working coil WC may be formed of conductors, more specifically, electrical conductors, stacked in a plurality of layers. In the present embodiment, the first coil portion 1120, more specifically, a coil pattern Cp to be described later, is exemplified as being formed of a conductor.

The working coil WC may be formed as a result of connecting, in the up and down directions, the first coil portions 1120 to each other, which are respectively provided to the plurality of first coil substrate portions 1100 stacked in the up and down directions. Each of the first coil substrate portions 1100 may include a core 1110 and a first coil portion 1120.

The core 1110 may form a frame of the first coil substrate portion 1100, and may be formed of insulating material. As an example, the core 1110 may be formed of prepreg material. In the present embodiement, the core 1110 is exemplified as being formed of a heat-cured prepreg, more specifically, a prepreg that is FR4.

The first coil portions 1120 may be disposed in both sides of the core 1110 in the up and down directions, respectively. For example, each first coil substrate portion 1100 may be provided in a form in which the first coil portions 1120 are formed on both sides of the core 1110 in the up and down directions, respectively, as a layer.

As an example, the first coil portions 1120 may be provided in a form patterned on both sides of the core 1110 in the up and down directions. For example, the first coil substrate portion 1100 may be formed by a copper clad laminate including a core 1110 and copper foils stacked on both sides of the core 1110 in the up and down directions. In this case, the first coil portion 1120 may be formed as a result of patterning the foil stacked on the core 1110 into a coil shape.

In an embodiment, the working coil WC may be formed in a shape including a polygonal shape. For example, the horizontal direction outer shape of the working coil WC (hereinafter, referred to as "outer shape of the working coil") may be a polygonal shape.

Additionally, as described above, the working coil WC may be formed by a plurality of first coil substrate portions 1100 stacked in the up and down directions. The first coil substrate portion 1100 may include a pattern region 1101 and a non-patterned region 1103, 1105.

The pattern region 1101 corresponds to a region of the first coil substrate portion 1100, in which the first coil portion 1120 is disposed. Additionally, the non-patterned region 1103, 1105 correspond to a region of the first coil substrate portion 1100, in which the first coil portion 1120 is not disposed. The pattern region 1101 and the non-patterned region 1103, 1105 may be disposed on the same plane, and may be arranged in the horizontal direction.

The non-patterned region 1103, 1105 may include a first non-patterned region 1103. In each of the working coils WC, the first non-patterned region 1103 may be disposed in the horizontal direction center. Additionally, the first non-patterned region 1103 may be disposed in the horizontal direction center of the first coil substrate portion 1100.

For example, the first non-patterned region 1103 may be disposed at the horizontal direction center of each of the working coil WC and the first coil substrate portion 1100. The pattern region 1101 may be disposed to surround the first non-patterned region 1103 in the outside in the horizontal direction.

In the present embodiment, the expression "center" does not mean the exact center, but means an area surrounded by a spirally wound working coil WC and including the center of the working coil WC in the diameter direction and its surroundings.

At least a portion of the first coil portion 1120 may surround the non-patterned region 1103, 1105 in the outside in the horizontal direction. As an example, at least a portion of the first coil portion 1120 may surround the first non-patterned region 1103 in the outside in the horizontal direction.

This first coil portion 1120 may include at least one coil pattern Cp disposed outside the first non-patterned region 1103 in the horizontal direction. In each of the first coil portions 1120, each coil pattern Cp may be wound multiple times around the first non-patterned region 1103. The first coil portion 1120 may be formed by at least one coil pattern Cp provided in this form.

Each of the first coil portions 1120 may include a plurality of coil patterns Cp. In this regard, in each of the first coil portions 1120, a plurality of coil patterns Cp may be disposed to be spaced apart from each other by a predetermined interval along the diameter direction of the working coil WC.

For example, each of the first coil portions 1120 may include three to six coil patterns Cp, respectively. However, the present disclosure is not limited to this, and each of the coil portions 112 may include a number of coil patterns Cp exceeding six, respectively.

In the present embodiment, each of the first coil portions 1120 is exemplified as including three to six coil patterns Cp, respectively. According to this, in each of the first coil portions 1120, three to six coil patterns Cp may be arranged along the diameter direction of the working coil WC. The coil pattern Cp disposed in each of the first coil portions 1120 may be connected in the up and down directions to any one of the coil patterns Cp disposed in the other first coil portions 1120 adjacent in the up and down directions.

Additionally, the first coil substrate portion 1100 may further include a second non-patterned region 1105. Like the first non-patterned region 1103, the second non-patterned region 1105 corresponds to a region in which the first coil portion 1120 is not formed.

With respect to the horizontal direction, the second non-patterned region 1105 may be disposed in the outer side of the first non-patterned region 1103. In the present embodiment, the second non-patterned region 1105 is exemplified as being disposed in the first direction outer side of the first non-patterned region 1103.

Additionally, in each of the first coil substrate portions 1100, the first non-patterned region 1103 and the second non-patterned region 1105 are not connected in the horizontal direction. With respect to the horizontal direction, at least a portion of the sensing coil SC may be disposed between the first non-patterned region 1103 and the second non-patterned region 1105. That is, between the first non-patterned region 1103 and the second non-patterned region 1105, at least a portion of the first coil portion 1120 may be disposed.

In an embodiment, a plurality of second non-patterned regions 1105 may be arranged along the first direction for each working coil WC. As an example, a pair of second non-patterned regions 1105 may be disposed for each working coil WC. This pair of second non-patterned regions 1105 may be disposed in the first direction outer side of the first non-patterned region 1103. That is, with respect to the first direction, the first non-patterned region 1103 may be disposed between the pair of second non-patterned regions 1105.

Additionally, in an embodiment, a plurality of working coils WC may be arranged along the first direction. The plurality of second non-patterned regions 1105 provided to the plurality of working coils WC disposed in this way may be disposed at equal intervals along the first direction.

Meanwhile, as shown in FIGS. 6 and 7, the second coil substrate portion 1200 may be disposed in the upper side or lower side of the first coil substrate portion 1100, and the sensing coil SC may be formed by the second coil substrate portion 1200. The sensing coil SC may be disposed in the upper side or lower side of the first coil substrate portion 1100, and may be disposed in a region overlapping the first coil substrate portion 1100 in the up and down directions.

In each of the coil modules 1001, 1003, as shown in FIGS. 6, 7, 20, and 21, the sensing coil SC may be disposed in the vertical direction outer side of the working coil WC. For example, in each of the coil modules 1001, 1003, the sensing coil SC and the working coil WC may be arranged in the up and down directions.

With respect to the horizontal direction, at least a portion of the sensing coil SC may be disposed in the second non-patterned region 1105. Accordingly, as a plurality of second non-pattern regions 1105 are disposed at equal intervals along the first direction, a plurality of sensing coils SC can be disposed at equal intervals along the first direction.

As a plurality of second non-pattern regions 1105 are disposed at equal intervals along the first direction, a plurality of sensing coils SC can be disposed at equal intervals along the first direction. In an embodiment, at least a portion of each sensing coil SC may be disposed in the second non-patterned region 1105. Accordingly, as a plurality of second non-pattern regions 1105 are disposed at equal intervals along the first direction, a plurality of sensing coils SC can be disposed at equal intervals along the first direction.

In an embodiment, the temperature sensor TS may be disposed in the horizontal direction inner side of the sensing coil SC. With respect to the horizontal direction, at least a portion of the temperature sensor TS may be disposed in the second non-patterned region 1105.

As an example, the temperature sensor TS may be disposed in the second non-patterned region 1105. That is, the temperature sensor TS installed on the second coil substrate portion 1200 and the second non-patterned region 1105 formed on the first coil substrate portion 1100 may be disposed to overlap each other in the up and down directions.

To this end, each sensing coil SC may be disposed at a position where the entire temperature sensor TS can be disposed in the second non-patterned area 1105, that is, a position where the entire temperature sensor TS can overlap the second non-patterned area 1105 in the up and down directions.

Meanwhile, as shown in FIGS. 17, 18, 22, and 23, each first coil portion 1120 may include a fourth terminal 1121 and a fifth terminal 1122, respectively. The fourth terminal 1121 and the fifth terminal 1122 may be provided to connect a plurality of coil patterns Cp arranged in the horizontal direction, that is, a plurality of coil patterns Cp forming one first coil portion 1120.

With respect to the horizontal direction, the fourth terminal 1121 may be disposed in the outer side of the first non-patterned area 1103 and the fifth terminal 1122, and at least a portion of the fifth terminal 1122 may be disposed to be in contact with the first non-patterned area 1103. According to this, with respect to the horizontal direction, the second non-patterned region 1105 may be disposed between the fourth terminal 1121 and the fifth terminal 1122.

Additionally, based on the second non-patterned area 1105, the fourth terminal 1121 may be disposed in the horizontal direction outer side area of the first coil portion 1120, and the fifth terminal 1122 may be disposed in the horizontal direction inner side area of the first coil portion 1120.

As an example, the fourth terminal 1121 may be disposed in the horizontal direction outermost side of the first coil portion 1120, and the fifth terminal 1122 may be disposed in the horizontal direction innermost side of the first coil portion 1120. For example, the fourth terminal 1121 may be connected with the horizontal direction outermost end of the coil pattern Cp. And the fifth terminal 1122 may be connected with the innermost end of the coil pattern Cp.

Referring to FIGS. 6 and 20, the coil assembly 1000 according to an embodiment may further include a terminal part 1020. The terminal part 1020 may be connected with at least one of the fourth terminal 1121 and the fifth terminal 1122. A detailed description of the terminal part 1020 will be provided later.

### [Layout structure of working coils for each coil module]

As shown in FIG. 8, in each of the coil modules 1001, 1003, a plurality of working coils WC may be arranged in the horizontal direction. For example, in each of the coil modules 1001, 1003, a plurality of working coils WC may be arranged along the first direction, and may also be arranged in the second direction. That is, in each of the coil modules 1001, 1003, a plurality of working coils WC may be disposed in a matrix form.

In this case, each working coil WC may be disposed to be spaced apart from another working coil WC adjacent thereto in the first direction by a predetermined interval in the first direction, and may be disposed to be spaced apart from another working coil WC adjacent thereto in the second direction by a predetermined interval in the second direction.

In an embodiment, the length of the coil module 1001, 1003 in the first direction may be set to be shorter than the length of the coil module 1001, 1003 in the second direction. That is, each of the coil modules 1001, 1003 may be formed in a rectangular shape, wherein the rectangular shape may have the second direction length longer than the first direction length.

In contrast to this, the length of the working coil WC in the second direction may be set to be shorter than the length of the working coil WC in the first direction. That is, each of the working coils WC may be formed in a rectangular shape, wherein the rectangular shape may have the first direction length longer than the second direction length.

In each of the coil modules 1001, 1003 including these working coils WC, the number of working coils WC disposed on the same straight line in the second direction is greater than the number of working coils WC disposed on the same straight line in the first direction.

In an embodiment, the first coil module 1001 may include a plurality of working coils WC arranged in A columns by B rows, and the second coil module 1003 may include a plurality of working coils WC arranged in A columns by C rows. In this embodiment, the column is defined as a line along the first direction, and the row is defined as a line along the second direction.

As an example, the relationship among A, B, and C may be defined as follows:
A≥1, C≥2, B>C,

For example, in the first coil module 1001 and the second coil module 1003, one or more working coils WC may be arranged in the first direction and two or more working coils WC may be arranged in the second direction. Additionally, in the first coil module 1001, one or more working coils WC may be arranged in the first direction, and three or more working coils WC may be arranged in the second direction.

According to this, the number of working coils WC disposed on the same straight line in the first direction in the first coil module 1001 and the number of working coils WC disposed on the same straight line in the first direction in the second coil module 1003 may be set to be equal to each other. Additionally, the number of working coils WC disposed on the same straight line in the second direction in the second coil module 1003 may be set to be less than the number of working coils WC disposed on the same straight line in the second direction in the first coil module 1001.

As an example, when n first coil modules 1001 are disposed to be spaced apart along the first direction, n/2 second coil modules 1003 may be disposed between a pair of first coil modules 1001 disposed in the first direction innermost side.

In this case, each of the first coil modules 1001 may include 16/n working coils WC arranged in the form of 4/n columns by 4 rows. And each of the second coil modules 1003 may include 12/n working coils WC arranged in the form of 4/n columns by 3 rows.

For example, when two first coil modules 1001 are disposed to be spaced apart along the first direction, one second coil module 1003 may be disposed between a pair of first coil modules 1001 disposed in the first direction innermost side. In this case, each of the first coil modules 1001 may include eight working coils WC arranged in the form of 2 columns by 4 rows.

And each of the second coil modules 1003 may include six working coils WC arranged in the form of 2 columns by 3 rows. In this case, the coil assembly 1000 may include a total of twenty two working coils WC.

As described above, the cooktop 100 (see FIG. 3) may be provided with a plurality of indicator lamps L (see FIG. 3), and the indicator lamp L may be implemented by the lighting module 180 (see FIG. 4). The lighting module 180 may be disposed in the lower side of the coil assembly 1000, and the light emitted from the lighting module 180 may pass through the coil assembly 1000 to illuminate the light display area of the top plate 120.

In order to allow the light emitted from the lighting module 180 to be transmitted to the light display area of the top plate 120, each of the coil modules 1001, 1003 may be provided with a through hole h. In each of the coil modules 1001, 1003, the through hole h may penetrate the coil module 1001, 1003 in the up and down directions, and each through hole h may be disposed between one column of working coils WC and one column of working coils WC.

As illustrated in FIG. 10, if four first coil modules 1001a are disposed to be spaced apart to each other along the first direction, two second coil modules 1003a may be disposed between a pair of first coil modules 1001a disposed in the first direction innermost side. In this case, each of the first coil modules 1001a may include four working coils WC arranged in the form of 1 column by 4 rows.

In a case where the coil assembly 1000a is provided in the above-described form, it becomes possible to allow a space to be formed between columns in the coil assembly 1000a. This space may be used as a passage for allowing the light emitted from the lighting module 180 to be transmitted to the light display area of the top plate 120.

That is, by providing each of the coil modules 1001a and 1003a in a form including only one column of working coils WC, the need for a separate through hole to be formed in the coil assembly 1000a becomes unnecessary.

Additionally, considering that its own size, or size of a display or a control panel may vary for each model, the coil assembly 1000a provided in the above-described form may be more advantageous for mass production than the coil assembly in the form illustrated in FIG. 8.

For example, according to the coil assembly 1000a provided in the above-described form, when producing several products with different sizes of the display or control panel, the first coil module 1001a can be used in common while only the size of the second coil module 1003a is changed depending on the size of the display or control panel.

Additionally, according to the coil assembly 1000a provided in the form described above, when necessary, it is enough only to repair or replace one column for each coil module 1001a, 1003a, so maintenance becomes easier and maintenance costs are reduced.

Additionally, if each coil module 1001a, 1003a is provided in the form including only one column of working coils WC as described above, the surface area of each coil module 1001a, 1003a can be relatively widened compared to the form in which each coil module includes two columns of working coils WC, and air can flow in each space between the coil modules 1001a, 1003a, thereby improving the heat dissipation performance of the coil assembly 1000a.

In comparison, in a case where two or more columns of working coils WC are disposed in each coil module 1001, 1003 as shown in FIG. 8, the number of coil modules 1001, 1003 to be assembled is reduced compared to when only one column of working coils WC is disposed in each coil module, so there is an advantage of reducing the assembly hour.

Additionally, in a case where two or more columns of working coils WC are disposed in each of the coil modules 1001, 1003, the space required to form wiring between the working coils WC of the two adjacent columns can be easily secured in the coil module 1001, 1003, so there is an advantage in that the wiring design can be performed easily and efficiently.

And each of the second coil modules 1003a may include three working coils WC arranged in the form of 1 column by 3 rows. Also in this case, the coil assembly 1000a may include a total of twenty two working coils WC.

As a second example, as shown in FIG. 11, each of the first coil modules 1001b may include 12/n working coils WC arranged in the form of 4/n columns by 3 rows. And each of the second coil modules 1003b may include 8/n working coils WC arranged in the form of 4/n columns by 2 rows.

For example, when two first coil modules 1001b are disposed to be spaced apart along the first direction, one second coil module 1003b may be disposed between a pair of first coil modules 1001b disposed in the first direction innermost side. In this case, each of the first coil modules 1001b may include six working coils WC arranged in the form of 2 columns by 3 rows.

And each of the second coil modules 1003b may include fourth working coils WC arranged in the form of 2 columns by 2 rows. In this case, the coil assembly 1000b may include a total of sixteen working coils WC.

As illustrated in FIG. 12, if four first coil modules 1001c are disposed to be spaced apart to each other along the first direction, two second coil modules 1003c may be disposed between a pair of first coil modules 1001c disposed in the first direction innermost side.

In this case, each of the first coil modules 1001c may include three working coils WC arranged in the form of 1 column by 3 rows. And each of the second coil modules 1003c may include two working coils WC arranged in the form of 1 column by 2 rows. Also in this case, the coil assembly 1000c may include a total of sixteen working coils WC.

As a third example, as shown in FIG. 13, when two first coil modules 1001d are disposed to be spaced apart to each other along the first direction, two second coil modules 1003d may be disposed between a pair of first coil modules 1001d disposed in the first direction innermost side. In this case, each of the first coil modules 1001d may include ten working coils WC arranged in the form of 2 columns by 5 rows.

And each of the second coil modules 1003d may include six working coils WC arranged in the form of 2 columns by 3 rows. In this case, the coil assembly 1000d may include a total of thirty two working coils WC.

As a fourth example, as shown in FIG. 14, if four first coil modules 1001e are disposed to be spaced apart to each other along the first direction, four second coil modules 1003e may be disposed between a pair of first coil modules 1001e disposed in the first direction innermost side. In this case, each of the first coil modules 1001e may include five working coils WC arranged in the form of 1 column by 5 rows.

And each of the second coil modules 1003e may include three working coils WC arranged in the form of 1 column by 3 rows. Also in this case, the coil assembly 1000e may include a total of thirty two working coils WC.

As a fifth example, as shown in FIG. 15, when n first coil modules 1001f are disposed to be spaced apart from each other along the first direction, each first coil module 1001f may include 16/n working coils WC arranged in the form of 4/n columns by 4 rows.

For example, when two first coil modules 1001f are disposed to be spaced apart from each other along the first direction, each first coil module 1001f may include eight working coils WC arranged in the form of 2 columns by 4 rows. In this case, the coil assembly 1000f may include a total of sixteen working coils WC.

As illustrated in FIG. 16, if four first coil modules 1001g are disposed to be spaced apart from each other along the first direction, each first coil module 1001g may include four working coils WC arranged in the form of 1 column by 4 rows. Also in this case, the coil assembly 1000g may include a total of sixteen working coils WC.

In the above-described examples, the coil assembly may include working coils WC which all have the same size and shape. Alternatively, the coil assembly may include several kinds of working coils WC having different sizes and shapes.

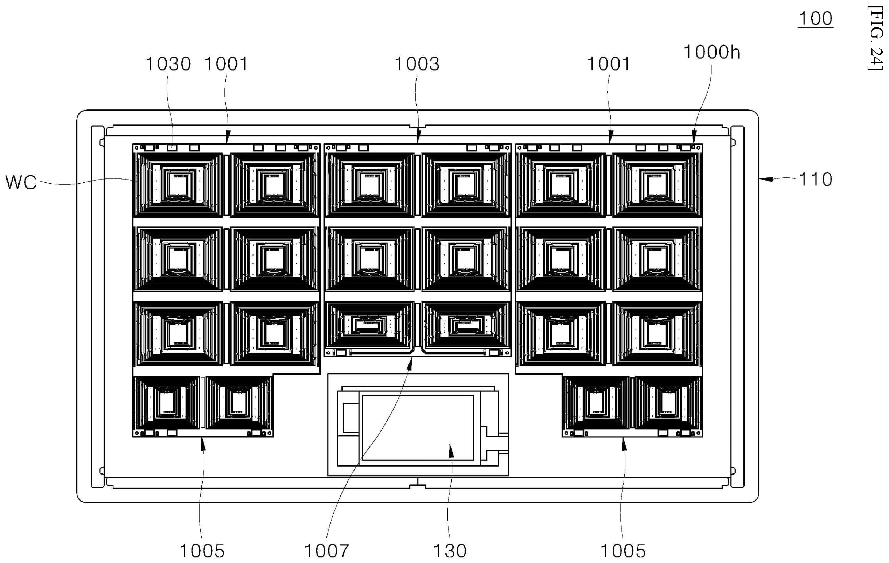

FIG. 24 is a plan view showing a seventh example of a layout structure of a first coil module and a second coil module.

As another example, the coil assembly 1000h as shown in FIG. 24 may further include at least one of the third coil module 1005 and the fourth coil module 1007. The first coil module 1001 and the third coil module 1005 may be disposed on the same straight line in the second direction, and the second coil module 1003 and the fourth coil module 1007 may be disposed on the same straight line in the second direction.

According to this, with respect to the first direction, a pair of first coil modules 1001 may be disposed to be spaced apart to each other along the first direction with the second coil module 1003 and the fourth coil module 1007 interposed therebetween.

Additionally, with respect to the second direction, the first coil module 1001 may protrude further to one side than the second coil module 1003; the third coil module 1005 may be disposed at a position more biased toward one side than the first coil module 1001; and the fourth coil module 1007 may be disposed at a position more biased toward one side than the second coil module 1003.

That is, the first coil module 1001 having the second direction length greater than that of the second coil module 1003 may protrude further to the front than the second coil module 1003; the third coil module 1005 may be disposed at a position more biased toward the front than the first coil module 1001; and the fourth coil module 1007 may be disposed at a position more biased toward the front than the second coil module 1003. Of course, the third coil module 1005 may be disposed at a position more biased toward the front than the fourth coil module 1007.

The third coil module 1005 and the fourth coil module 1007 may be formed to have horizontal direction sizes smaller than those of the first coil module 1001 and the second coil module 1003. To this end, the third coil module 1005 may include a working coil having the horizontal direction size smaller than that of the working coil provided to the first coil module 1001.

As described above, the control panel 130 may be disposed at a position more biased toward the front than the second coil module 1003, and a pair of first coil modules 1001 may be disposed to be spaced apart from each other along the first direction with the control panel 130 interposed therebetween. Additionally, a pair of third coil modules 1005 disposed in the front side of the pair of first coil modules 1001 may also be disposed to be spaced apart to each other along the first direction with the control panel 130 interposed therebetween.

With respect to the first direction, the length of the third coil module 1005 may be set to be shorter than the length of the first coil module 1001. And with respect to the second direction, the length of the third coil module 1005 may be set to be shorter than the length of the first coil module 1001. That is, the third coil module 1005 may be formed to have the first direction length and the second direction length which are shorter than those of the first coil module 1001.

Additionally, the fourth coil module 1007 may be disposed in the rear side of the control panel 130. With respect to the second direction, the fourth coil module 1007 may be disposed between the control panel 130 and the second coil module 1003, and the length of the fourth coil module 1007 may be formed to be shorter than the length of the second coil module 1003.

As the third coil module 1005 and the fourth coil module 1007 are disposed in the above-described form, it is possible to secure a wider area for the area in which the control panel 130 is to be disposed. According to this, the control panel 130 can be further spaced apart from the coil modules 1001, 1003 in the horizontal direction, and thereby, the control panel 130 can be less affected by the heat generated around the working coil WC.

### [Power supply-related configuration]

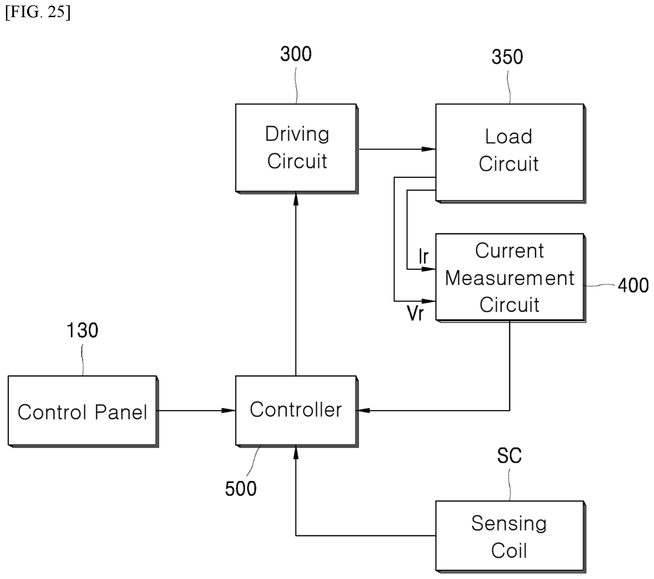

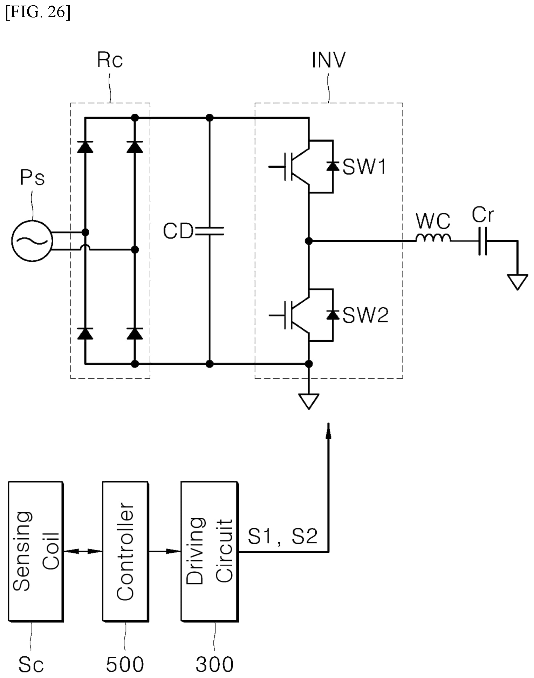

FIG. 25 is a block diagram schematically illustrating a power supply-related configuration of a home appliance according to an embodiment. FIG. 26 is a circuit diagram of a home appliance according to an embodiment.

Referring to FIG. 25, a home appliance according to an embodiment may include a control panel 130, a driving circuit 300, a load circuit 350, a controller 500, and a sensing coil SC.

To the control panel 130, a user interface may be presented which includes various icons for adjusting the operation of the cooktop 100 by touch, a display showing the operation state of the cooktop 100, and the like. The user may input through the control panel 130 a heating level which the user wants.

The load circuit 350 may include at least one working coil, at least one capacitor, and at least one relay. Here, at least one working coil, at least one capacitor, and at least one relay may be connected with each other selectively in series or in parallel.

The driving circuit 300 may supply a switching signal for driving an inverter included in the load circuit 350.

The home appliance according to an embodiment may further include a current measurement circuit 400. The current measurement circuit 400 may measure the resonance current Ir and the resonance voltage Vr of the load circuit 350 when the inverter included in the load circuit 350 is driven. The controller 500 may calculate an input current applied to the load circuit 350 with the use of the resonance current Ir and the resonance voltage Vr. The controller 500 may calculate an output power value of the working coil based on the input current, and determine a driving frequency of the inverter included in the load circuit 350 based on the calculated output power value and the heating level input through the control panel 130.

The controller 500 may supply to the driving circuit 300 a control signal corresponding to the determined driving frequency. The driving circuit 300 may generate a switching signal according to a control signal supplied from the controller 500, and supply the switching signal to the load circuit 350.

The controller 500 may determine whether a container is present on the top of the working coil by using the sensing coil SC. The controller 500 may supply current to the sensing coil SC for a predetermined time period. The controller 500 may determine whether a container is present on the top of a working coil or of which working coil a container is present on the top, based on a resonance signal which the sensing coil SC outputs by the supply of the current.

In an embodiment, the controller 500 may determine container information including at least one of the position, material, shape, and size of a container with the use of the sensing coil SC. The controller 500 may control at least one relay in the load circuit 350 according to the position of the container so that at least one working coil corresponding to the position of the container is activated.

Additionally, the controller 500 may determine or vary the switching frequency of the inverter according to at least one of the material, shape, and size of the container.

Referring to FIG. 25, a home appliance according to an embodiment may include a rectifying circuit Rc, a DC link capacitor CD, an inverter INV, a sensing coil SC, a controller 500, a driving circuit 300, a working coil WC, and a resonance capacitor Cr.

The rectifier circuit Rc may rectify an input voltage supplied from an external power source Ps and output the rectified voltage. The rectifier circuit Rc may be a circuit including a plurality of diodes (e.g., bridge circuit).

The DC link capacitor CD may smooth the voltage output from the rectifier circuit Rc, and output the smoothed voltage.

The inverter INV may output an alternating current with the use of the voltage output from the DC link capacitor CD. In an embodiment, the inverter INV may include a first switching element SW1 and a second switching element SW2. The first switching element SW1 and the second switching element SW2 may be turned on and turned off by a first switching signal S1 and a second switching signal S2 supplied by the driving circuit 300. The first switching element SW1 and the second switching element SW2 may be alternately turned on and turned off. In another embodiment, the inverter INV may include two or more switching elements.

The controller 500 may determine whether a container is present on the top of the working coil by using the sensing coil SC. The controller 500 may supply current to the sensing coil SC for a predetermined time period. The controller 500 may determine whether a container is present on the top of a working coil or of which working coil a container is present on the top, based on a resonance signal which the sensing coil SC outputs by the supply of the current.

The controller 500 may determine the driving frequency of the inverter included in the load circuit 350 based on the output power value of the working coil WC and the heating level input through the control panel 130. The controller 500 may supply to the driving circuit 300 a control signal corresponding to the driving frequency of the inverter INV. When the control signal is supplied to the driving circuit 300, the driving circuit 300 may output the switching signal S1, S2. When the first switching signal S1 and the second switching signal S2 are supplied to the inverter INV, the first switching element SW1 and the second switching element SW2 may be alternately turned on and turned off. Thereby, from the inverter INV an alternating current can be output. When the alternating current output from the inverter INV is supplied to the working coil WC, the container provided on the top of the working coil WC can be heated.

To one end of the working coil WC, a resonance capacitor Cr may be connected. When the alternating current is supplied to the working coil WC, a resonance phenomenon may occur due to the working coil WC, the resonance capacitor Cr, and the container.

In FIG. 26, only one working coil WC and one resonance capacitor Cr are shown as an example. However, in another embodiment, a home appliance may include a plurality of working coils and resonance capacitors.

### [Stacked structure of coil substrate-stacked body]

Referring to FIGS. 7 and 8, each of the coil modules 1001, 1003 may be formed by the coil substrate-stacked body 1010. The coil substrate-stacked body 1010 may include a plurality of first coil substrate portions 1100 and at least one second coil substrate portion 1200, which are stacked in the up and down directions.

As shown in FIGS. 7 and 19, the first coil substrate portion 1100 may be formed in a form in which the core 1110 and the first coil portion 1120 are stacked in the up and down directions. And the second coil substrate portion 1200 may be formed in a form in which the core 1210 and the second coil portion 1220 are stacked in the up and down directions. The core 1210 may form the frame of the second coil substrate portion 1200, and may be formed of the same or similar material as or to the core 1110 of the first coil substrate portion 1100.

For example, in the first coil substrate portion 1100, the first coil portions 1120 may be disposed on both sides of the core 1110 in the up and down directions. For example, the first coil portions 1120 may be stacked on the top surface and bottom surface of the core 1110, respectively.

And in the second coil substrate portion 1200, the first coil portion 1120 may be disposed on the up and down direction one side, that is, on the lower side of the core 1210, and the second coil portion 1220 may be disposed on the vertical direction other side, that is, on the upper side of the core 1210. For example, the first coil portion 1120 may be stacked on the bottom surface of the core 1210, and the second coil portion 1220 may be stacked on the top surface of the core 1210.

As another example, in the second coil substrate portion 1200, the second coil portions 1220 may be disposed on both sides of the core 1210 in the up and down directions.

This embodiment illustrates that the second coil substrate portion 1200 includes the first coil portion 1120 and the second coil portion 1220 wherein the first coil portion 1120 is disposed on the lower side of the core 1210, and the second coil portion 1220 is disposed on the upper side of the core 1210.

In an embodiment, the working coil WC, more specifically, the coil substrate-stacked body 1010, may include first coil portions 1120 of six or more layers. That is, the coil substrate-stacked body 1010 may include first coil portions 1120 of six or more layers connected with each other in the up and down directions and coupled in one body with each other.

In order for the working coil WC to secure a sufficient amount of induced power to heat the object to be heated, the amount of conductor included in the working coil WC must be sufficiently secured. There is a limit to increasing the height of the coil pattern Cp in order to increase the amount of conductor included in the working coil WC.

Considering this point, increasing the number of coil patterns Cp for each layer forming the working coil WC and increasing the number of layers of coil patterns Cp forming the working coil WC can be an effective method for increasing the amount of conductor included in the working coil WC.

In an embodiment, three or more coil patterns Cp connected in parallel for each layer may be disposed along the diameter direction of the working coil WC to form one coil line. And coil line formed in this way may be stacked up to three or more times so as to overlap each other in the up and down directions to form a working coil WC.

Considering the winding interval of the coil pattern Cp or other design conditions, there is a limit to increasing the number of coil patterns Cp for each layer. For example, if the number of coil patterns Cp for each layer is increased, the size of each working coil WC may increase, which may lead to a problem in that the number of working coils WC disposed in the home appliance must be reduced.

Additionally, in the case of reducing the width of the coil pattern Cp in order to increase the number of coil patterns Cp for each layer, the space required to secure the spacing between the coil patterns Cp increases, which may lead to a problem in that the amount of conductor included in the working coil WC is rather decreased despite the increase in the number of coil patterns Cp.

In comparison with this, it can be said that increasing the number of layers of the coil pattern Cp is a method that causes relatively fewer problems. That is, as the number of layers of the coil pattern Cp increases, the amount of conductor included in the working coil WC can also increase, and in spite of the increase in the number of layers of the coil pattern Cp, there is little concern that the number of working coils WC will decrease or the amount of conductors included in the working coil WC will decrease.

Considering this point, in the present embodiment, since three or more coil patterns Cp are disposed for each layer, three layers of coil patterns Cp are disposed in the up and down directions to form a three-layer coil line. Additionally, considering that as the three-layer coil line (e.g., first coil line) is disposed, another three-layer coil line (e.g., second coil line) having a different pattern from the aforementioned coil line must be disposed, it is preferable that the coil substrate-stacked body 1010 includes a six or more-layer coil line.

Additionally, depending on a design condition, the amount of conductor included in the working coil WC can be increased more effectively by the coil line being stacked in eight or more layers. This embodiment illustrates that the first coil portions 1120 of eight to twelve layers are stacked in the up and down directions. However, the present disclosure is not limited to this, and the first coil portions 1120 may be stacked in layers whose quantity exceeds twelve.

As an example, the coil module 1001, 1003 may be designed so that, as the number of layers of the first coil portion 1120 increases, the thickness of the first coil portion 1120 of each layer decreases, and thus the total thickness increase of the coil module 1001, 1003 may be suppressed to an appropriate level despite the increase in the number of layers of the first coil portion 1120.

Additionally, the coil substrate-stacked body 1010 may include at least one second coil portion 1220. For example, the coil substrate-stacked body 1010 may include first coil portions 1120 of eight to twelve layers and a second coil portion 1220 of one to two layers, which are connected with each other in the up and down directions and coupled in one body with each other.

Additionally, the coil substrate-stacked body 1010 may further include an insulating layer stacked in the up and down directions together with the first coil portion 1120. In each coil substrate-stacked body 1010, the coil portion 1120, 1220 and the insulating layer may be alternately disposed in the up and down directions.

In the first coil substrate portion 1100, the insulating layer may be formed by the core 1110. And also in the second coil substrate portion 1200, the insulating layer may be formed by the core 1210.

Additionally, the insulating layer may be disposed between the coil substrate portions 1100, 1200. For example, the insulating layer may be disposed between a pair of first coil substrate portions 1100 adjacent to each other in the up and down directions, and the insulating layer may also be disposed between the first coil substrate portion 1100 and the second coil substrate portion 1200. Additionally, the insulating layer may also be disposed between a pair of second coil substrate portions 1200 adjacent to each other in the up and down directions.

For example, the insulating layer disposed between the coil substrate portions 1100, 1200 as described above may be formed by an adhesive material 1400. In an embodiment, a plurality of first coil substrate portions 1100 stacked in the up and down directions may be coupled to each other by the adhesive material 1400, and the first coil substrate portion 1100 and the second coil substrate portion 1200 may also be coupled to each other by the adhesive material 1400. Also, a plurality of second coil substrate portions 1200 stacked in the up and down directions may be coupled to each other by the adhesive material 1400.

According to this, the insulating layers may be formed by the cores 1110, 1210 respectively provided in the first and second coil substrate portions 1100, 1200 (hereinafter, referred to as "coil substrate portions"), and the insulating layers may also be formed by the adhesive materials 1400 disposed between the coil substrate portions 1100, 1200.

The core 1110, 1210 may be disposed between a pair of first coil portions 1120 or second coil portions 1220, or between the first coil portion 1120 and the second coil portion 1220, which face each other in the up and down directions, to form an insulating layer therebetween. That is, the core 1110, 1210 may form the insulating layer in the inside of the first coil substrate portion 1100 or in the inside of the second coil substrate portion 1200.

And the adhesive material 1400 may be disposed between a pair of first coil portions 1120 facing each other in the up and down directions, a pair of second coil portions 1220 facing each other in the up and down directions, or the first coil portions 1120 and the second coil portions 1220 facing each other in the up and down directions to form the insulating layer therebetween. That is, the adhesive material 1400 may form an insulating layer in the outside of the first coil substrate portion 1100 or the second coil substrate portion 1200.

Thereby, any one of the first coil portion and the second coil portion 1120, 1220 (hereinafter, referred to as a "coid portion") and the insulating layer may be alternately disposed in the up and down directions. That is, the first coil portion 1120 and the insulating layer may be alternately disposed in the up and down directions, and the second coil portion 1220 and the insulating layer may be alternately disposed.

Additionally, in a plurality of insulating layers arranged in the up and down directions, the core 1110, 1210 and the adhesive material 1400 may be alternately disposed in the up and down directions. For example, the coil portions 1120, 1220 and the insulating layer may be stacked in the up and down directions in the order of '... first coil portion 1120 - core 1110 - first coil portion 1120 - adhesive material 1400 - first coil portion 1120 ...'.

In the present embodiment, each of the coil substrate portions 1100, 1200 is exemplified as being formed by a copper clad laminate including the core 1110, 1210 and foil. According to this, the core 1110, 1210 may be formed of a heat-cured prepreg.

As an example, the core 1110, 1210 may be formed of a prepreg that is FR4, and the coil portion 1120, 1220 may be formed as a result of the foil stacked on the core 1110, 1210 being patterned into a coil shape. The thickness adjustment of the first coil substrate portion 1100 or the second coil substrate portion 1200 may be performed by a method of changing the thickness of the core 1110 or changing the thickness of the first coil portion 1120 or the second coil portion 1220.

Additionally, the adhesive material 1400 may be formed of prepreg material. As an example, each adhesive material 1400 may include a plurality of prepreg films stacked in the up and down directions. The thickness adjustment of the adhesive material 1400 may be performed by a method of changing the number of prepreg films stacked in the up and down directions.

The thickness of the adhesive material 1400 may be set to be thicker than the thickness of the core 1110, 1210. in an embodiment, both the core 1110, 1210 and the adhesive material 1400 are formed of prepreg; however, the core 1110, 1210 is formed of a thermoset prepreg, whereas the adhesive material 1400 is formed of a non-thermoset prepreg. In consideration of this point, in this embodiment, the adhesive material 1400 may be formed to be thicker than the core 1110, 1210, so that the strength of the adhesive material 1400 can be maintained at a level similar to that of the core 1110, 1210, and the strength of the coil module 1001, 1003 can be strengthened.

Additionally, the thickness of the adhesive material 1400 may be set to be greater than the thickness of the coil portions 1120, 1220. As an example, the thickness of the adhesive material 1400 may be set to be twice or more the thickness of the coil portion 1120, 1220. The adhesive material 1400 formed as described above may contribute to strengthening the strength of the coil portions 1120, 1220 disposed on both sides of the adhesive material 1400 in the up and down directions.

Meanwhile, the coil assembly 1000 according to an embodiment may further include an outer layer part 1300, 1350. The outer layer part 1300, 1350 may be disposed in the outer side of the coil substrate-stacked body 1010 in the up and down directions. As an example, the outer layer parts 1300, 1350 may be disposed in the upper side and lower side of the coil substrate-stacked bodyed body 1010, respectively, and a pair of outer layer parts 1300, 1350 disposed in this way may be stacked together with the coil substrate-stacked body 1010 in the up and down directions. The pair of outer layer parts 1300, 1350 stacked together with the coil substrate-stacked body 1010 as described above may form the upper end and lower end of the coil module 1001, 1003.

The outer layer parts 1300, 1350 may be divided into a first outer layer part 1300 and a second outer layer part 1350. Like the first coil portion 1100, the first outer layer part 1300 may include a plurality of first coil portions 1120 arranged in the horizontal direction. And, like the second coil portion 1200, the second outer layer part 1350 may include a plurality of second coil portions 1220 arranged in the horizontal direction.

The first outer layer part 1300 may form a working coil WC together with a plurality of first coil portions 1120 stacked in the up and down directions. Additionally, the second outer layer part 1350 may form a working coil WC together with the second coil portion 1220. That is, the first outer layer part 1300 may be connected with the first coil portion 1120 in the up and down directions, and the second outer layer part 1350 may be connected with the second coil portion 1220 in the up and down directions.

The first outer layer part 1300 may be disposed at a position adjacent to the first coil substrate portion 1100. As an example, the first outer layer part 1300 may be disposed in the lower side of the first coil substrate portion 1100 to be connected with the first coil portion 1120 in the up and down directions. This first outer layer part 1300 may form a working coil WC together with the first coil portion 1120.

The second outer layer part 1350 may be disposed at a position adjacent to the second coil substrate portion 1200. As an example, the second outer layer part 1350 may be disposed in the upper side of the second coil substrate portion 1200 to be connected with the second coil portion 1220 in the up and down directions. This second outer layer part 1350 may form a sensing coil SC together with the second coil portion 1220.

For example, the coil substrate-stacked body 1010 may be formed in a form in which the second coil portion 1220 is stacked in the upper side of a plurality of first coil portions 1120. And this coil substrate-stacked body 1010 may be disposed between the first outer layer part 1300 and the second outer layer part 1350 which are disposed to be spaced apart from each other in the up and down directions.

In this case, the first outer layer part 1300 disposed in the lower side of the first coil substrate portion 1100 may form the lower end of the coil module 1001, 1003 while forming a working coil WC together with the first coil portion 1120. Additionally, the second outer layer unit 1350 disposed in the upper side of the second coil substrate portion 1200 may form the upper end of the coil module 1001, 1003 while forming a sensing coil SC together with the second coil portion 1220.

In an embodiment, a pair of coil portions 1120, 1220 are disposed in each of the coil substrate portions 1100, 1200 in the up and down directions. That is, the coil portions 1120, 1220 of two layers are formed on each of the coil substrate portions 1100, 1200. The coil substrate-stacked body 1010 formed in a form in which this plurality of coil substrate portions 1100, 1200 are stacked may include a plurality of coil portions 1120, 1220, and more specifically, may include coil portions 1120, 1220 of even-number layers.

Additionally, the outer layer parts 1300, 1350 may be combined to both the upper side and lower side of the coil substrate-stacked body 1010 formed as described above, and accordingly, a plurality of coil portions 1120, 1220 may be disposed in each of the coil modules 1001, 1003, and more specifically, the coil portions 1120, 1220 of even-number layers may be disposed.

The outer layer part 1300, 1350 may be combined to the coil substrate-stacked body 1010 by the adhesive material 1400 disposed between the coil portion 1120, 1220 and the outer layer part 1300, 1350. The adhesive material 1400 can form an insulating layer between the coil portion 1120, 1220 and the outer layer part 1300, 1350, and can combine the coil substrate-stacked body 1010 with the outer layer part 1300, 1350.

As an example, the adhesive material 1400 disposed between the first coil substrate portion 1100 and the first outer layer part 1300 disposed in the lower end of the coil module 1001, 1003 can form an insulating layer between the first coil portion 1120 provided to the first coil substrate portion 1100 and the first coil portion 1120 provided to the first outer layer part 1300, and can combine the first coil substrate portion 1100 with the first outer layer part 1300.

Additionally, the adhesive material 1400 disposed between the second coil substrate portion 1200 and the second outer layer part 1350 disposed in the upper end of the coil module 1001, 1003 can form an insulating layer between the second coil portion 1220 provided to the second coil substrate portion 1200 and the second coil portion 1220 provided to the second outer layer part 1350, and can combine the second coil substrate portion 1200 with the second outer layer part 1350.

In this embodiment, the coil substrate-stacked body 1010, the working coil WC, and the sensing coil SC are formed by stacking units such as the coil substrate portion 1100, 1200, the coil portion 1120, 1220, and the like, but this invention is not limited to this.

As another example, the working coil WC and the coil module 1001, 1003 may be formed in a form in which conductors of the respective layers are sequentially stacked from the bottom layer without a separate substrate. In this case, the coil module 1001, 1003 may be formed in a form in which a conductor for forming the working coil WC and an adhesive material 1400 are alternately stacked in the up and down directions.

Additionally, in the above description, it is expressed that the coil module 1001, 1003 is formed in a form in which the respective parts constituting the coil module 1001, 1003, for example, the coil substrate portion 1100, 1200, the coil portion 1120, 1220, the conductor, and the like, are stacked, but the coil module 1001, 1003 is formed in a form in which the respective parts constituting the coil module 1001, 1003 are integrated into one body.

That is, the coil module 1001, 1003 according to an embodiment is formed in a onebody type, and is not separated into individual parts constituting the coil module 1001, 1003 unless a separate process such as cutting or chemical treatment is performed.

### [Shape of working coil]

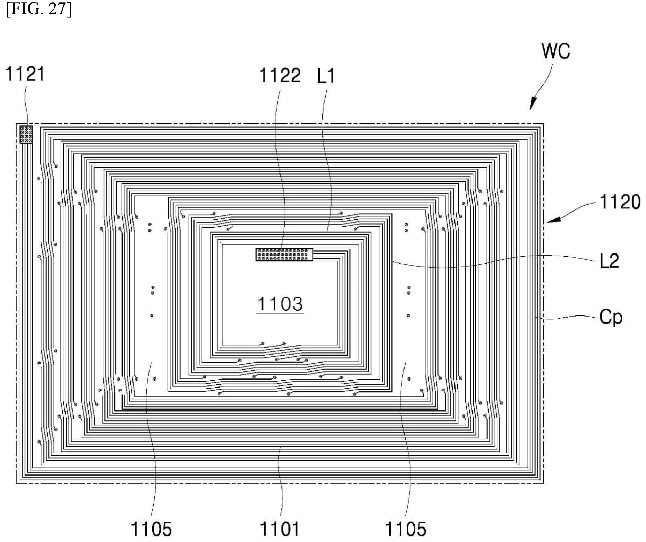

FIG. 27 is a plan view illustrating an example of a working coil.

Referring to FIGS. 17 and 27, the working coil WC may be formed in a shape including a polygonal shape. For example, the horizontal direction outer shape of the working coil WC may be a polygonal shape. In other words, when viewing the working coil WC from the top, the shape of the working coil WC may be a polygonal shape.

As an example, the outer shape of the working coil WC may be approximately rectangular. Also, the outer shape of the coil module 1001, 1003 including the working coil WC may be a polygonal shape. Further, the working coil WC may be formed by a conductor patterned on an insulating layer. For example, the working coil WC may be formed by a conductor patterned on an insulating layer, rather than a litz coil wound closely in a circular shape.

As the working coil WC is formed in the form of a pattern as described above, the outer shape of the working coil WC can be easily formed in a polygonal shape, more specifically, an approximately rectangular shape.

Additionally, since the outer shape of the working coil WC is formed in this form, the working coil WC can occupy an area very close to the edge of the coil module 1001, 1003, so that the density of the area occupied by the working coil WC in the coil module 1001, 1003 can be effectively increased.

Additionally, the horizontal direction outer shape of each first coil substrate portion 1100 provided to each working coil WC (hereinafter, referred to as the "outer shape of the first coil substrate portion") may be a polygonal shape. For example, the outer shape of the first coil substrate portion 1100 may be substantially rectangular.

Additionally, the horizontal direction outer shape of the core 1110 forming the frame of each first coil substrate portion 1100 (hereinafter referred to as "outer shape of the core") may be a polygonal shape, similar to the shapes of the coil module 1001, 1003 and the first coil substrate portion 1100.

As an example, the working coil WC may be formed in a rectangular spiral shape. For example, the working coil WC may be formed in a rectangular spiral shape in which a first straight line 11 in the first direction and a second straight line L2 in the second direction are alternately connected to each other. And the outer shape of the core 1110 of the first coil substrate portion 1100 forming the working coil WC may be formed in a rectangular shape similar to the outer shape of the working coil WC.

Accordingly, at least one of a plurality of outer sides of the working coil WC may include a straight line parallel to any one of a plurality of outer sides of the core 1110, which is closest thereto. For example, the first straight line L1 disposed at the forefront of the working coil WC may be formed as a straight line parallel to the front outer side of the core 1110, and the second straight line L2 disposed at the rightmost side of the working coil WC may be formed as a straight line parallel to the right outer side of the core 1110.

Since the outer shape of the core 1110 and the outer shape of the working coil WC are formed in the above-described form, the working coil WC can occupy an area very close to the edge of the coil module 1001, 1003, so that the density of the area occupied by the working coil WC in the coil module 1001, 1003 can be effectively increased.

Also, in an embodiment, each of the coil modules 1001, 1003 may include a plurality of working coils WC. That is, each of the coil modules 1001, 1003 may include an assembly of a plurality of working coils WC arranged in the horizontal direction. For example, each of the coil modules 1001, 1003 may be provided with an assembly of working coils WC including eight working coils WC arranged in the form of 2 columns by 4 rows along the horizontal direction.

In an embodiment, the outer shape of the assembly of the working coil WC may be a polygonal shape. That is, the outer shape of each of the coil modules 1001, 1003 and the outer shape of the assembly of the working coil WC provided in that coil module 1001, 1003 may all be a polygonal shape.

As an example, the assembly of the working coil WC may be disposed such that its outer shape is a rectangular shape. That is, a plurality of working coils WC provided in each of the coil modules 1001, 1003 may be disposed in a rectangular shape.

As another example, the outer shape of the working coil WC may be also a hexagonal shape. For example, the working coil WC may be formed in a hexagonal spiral shape. Therefore, a plurality of working coils may be disposed in a honeycomb shape in the coil module 1001a. By disposing a plurality of working coils WC, each of which is formed in a hexagonal spiral shape, in a honeycomb shape, the centers of all working coils WC provided to the working module 1001a can be maintained at equal intervals. For example, all the working coil WC provided to the coil module 1001a may be disposed so that the center distance from another adjacent working coil WC is maintained at a specified value.

The working coil WC provided in this form can provide an advantage in that, by making the center distances between the adjacent working coils WC the same, it is possible to make it easier to design the structure of the coil assembly 1000 so that the working coil WC can perform both the function of detecting the presence of the object to be heated and the function of heating the object to be heated.

As another example, the outer shape of the working coil may be a circular or elliptical shape. For example, the working coil may be formed in a spiral shape similar to a circular or elliptical shape. Even in this case, coil modules may be disposed so that the centers of all working coils provided to the coil module may be maintained at equal intervals.

### [Illustrative embodiments of coil pattern]

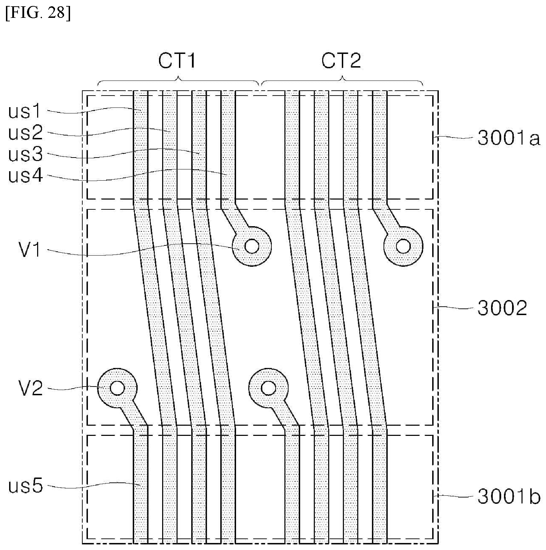

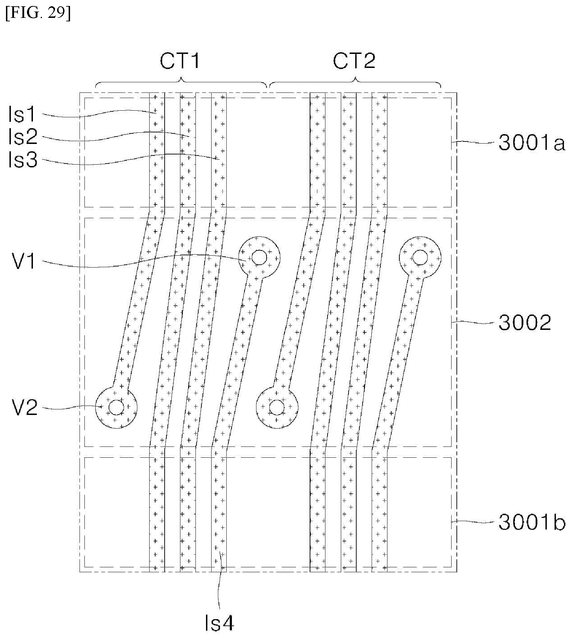

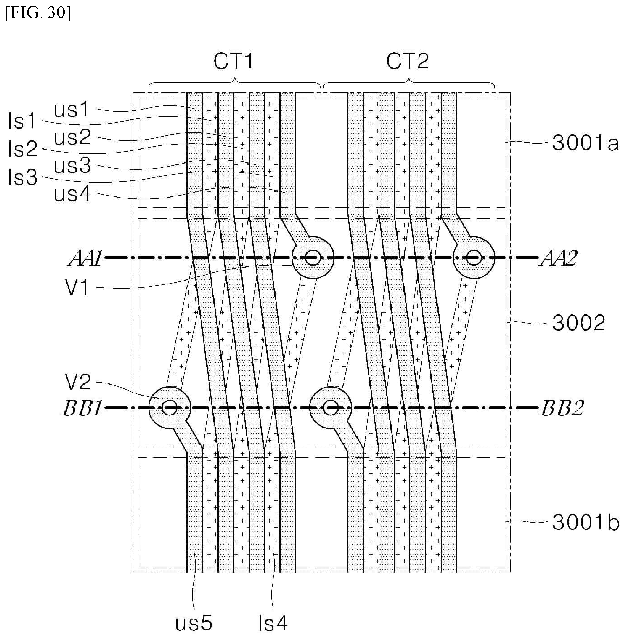

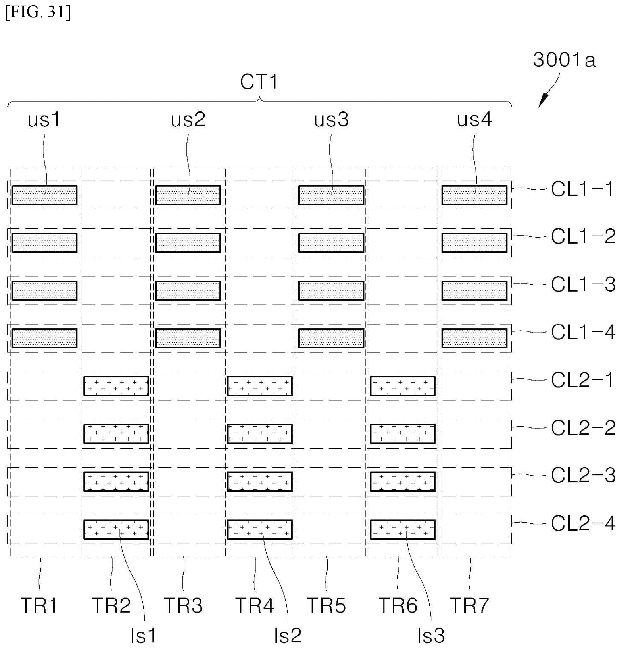

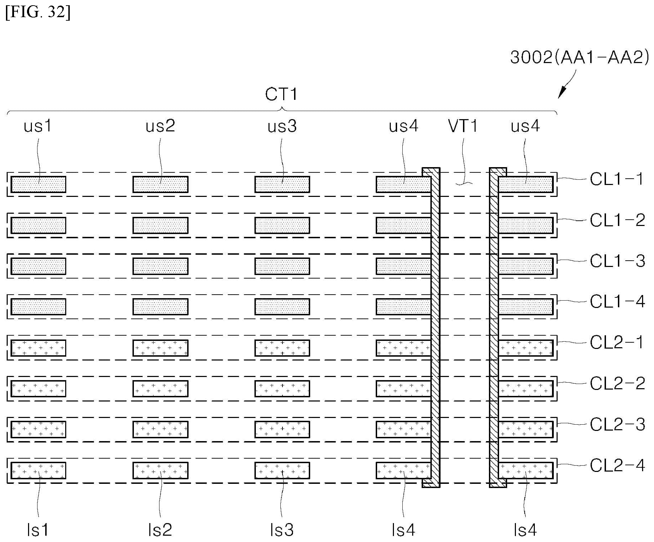

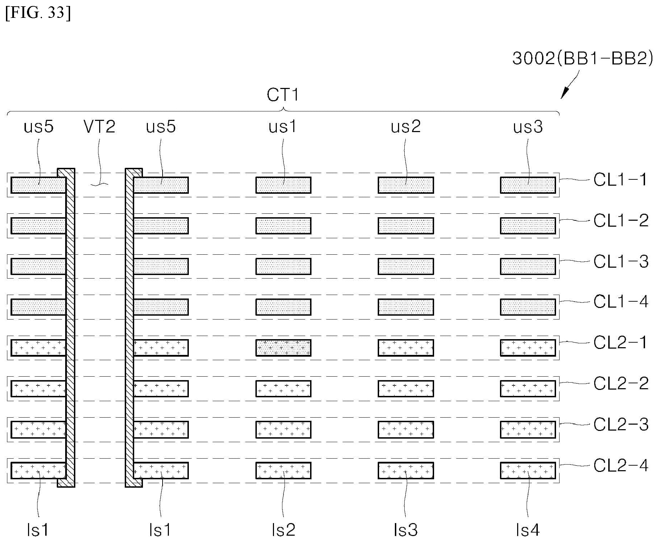

FIG. 28 is an enlarged view of a portion of a first coil layer set of a coil pattern of a working coil according to a first embodiment. FIG. 29 is an enlarged view of a portion of a second coil layer set of a coil pattern of a working coil according to a first embodiment. FIG. 30 is an enlarged view of a portion of a first coil layer set and a second coil layer set of a working coil according to a first embodiment. FIG. 31 is a cross-sectional view of a non-connection region of a coil pattern of a working coil according to a first embodiment. FIG. 32 is a cross-sectional view of AA1-AA2 portion of a connection region of a coil pattern of a working coil according to a first embodiment. FIG. 33 is a cross-sectional view of BB1-BB2 portion of a connection region of a coil pattern of a working coil according to a first embodiment.

As shown in FIGS. 28 to 30, the working coil according to a first embodiment may include a plurality of coil turns CT1, CT2. Although only two coil turns CT1, CT2 included in the working coil are illustrated in FIGS. 28 to 30, the number of coil turns included in the working coil may be variable depending on the embodiment.

Each of the coil turns CT1, CT2 may include a plurality of coil strands. For example, the first coil turn CT1 may include a plurality of coil strands us1, us2, us3, us4, us5, ..., ls1, ls2, ls2, ls4, .... Similarly, the second coil turn CT2 may also include a plurality of coil strands.

Additionally, each of the coil turns CT1, CT2 may include a plurality of via patterns V1, V2, .... For example, the first coil turn CT1 may include a plurality of via patterns V1, V2, .... Similarly, the second coil turn CT2 may include a plurality of via patterns.

As illustrated in FIGS. 31 to 33, a working coil according to a first embodiment may include a first coil layer set including a plurality of first coil layers CL1-1, CL1-2, CL1-3, CL1-4, and a second coil layer set including a plurality of second coil layers CL2-1, CL2-2, CL2-3, CL2-4.

The plurality of first coil layers CL1-1, CL1-2, CL1-3, CL1-4 may be disposed according to a first pattern. The plurality of first coil layers CL1-1, CL1-2, CL1-3, CL1-4 may be stacked in the vertical direction.

The plurality of second coil layers CL2-1, CL2-2, CL2-3, CL2-4 may be disposed according to a second pattern different from the first pattern. The plurality of second coil layers CL2-1, CL2-2, CL2-3, CL2-4 may be stacked in the vertical direction. The plurality of second coil layers CL2-1, CL2-2, CL2-3, CL2-4 may be disposed under the plurality of first coil layers CL1-1, CL1-2, CL1-3, CL1-4.

Each of the coil layers may include a plurality of coil strands. For example, each of the first coil layer CL1-1, CL1-2, CL1-3, CL1-4 and the second coil layer CL2-1, CL2-2, CL2-3, CL2-4 may include a plurality of coil strands us1, us2, us3, us4, us5, ..., ls1, ls2, ls2, ls4, ....

Although only the cross-sectional view of the first coil turn CT1 is illustrated in FIGS. 31 to 33, the second coil turn CT2 may also have the same structure and pattern as the first coil turn CT1.

FIGS. 31 to 33 illustrate an embodiment in which a working coil includes four first coil layers CL1-1, CL1-2, CL1-3, CL1-4 and four second coil layers CL2-1, CL2-2, CL2-3, CL2-4. However, the number of coil layers included in the working coil may be variable depending on the embodiment.

Referring back to the drawings, the working coil according to the first embodiment may include a non-connection region 3001a, 3001b and a connection region 3002.

The non-connection region 3001a, 3001b and the connection region 3002 may be alternately disposed. For example, although not shown in the drawings, another connection region may be disposed at one end of the non-connection region 3001a, and still another connection region may be disposed at one end of the non-connection region 3001b.

Referring to FIGS. 28 to 31, in the non-connection region 3001a, 3001b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may not be electrically connected to each other.

In an embodiment, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed in different traces in the non-connection region 3001a, 3001b.

For example, as illustrated in FIG. 31, the coil strands us1, us2, us3, us4 included in a plurality of first coil layers CL1-1, CL1-2, CL1-3, CL1-4 may be disposed in a first trace TR1, a third trace TR3, a fifth trace TR5, and a seventh trace TR7, respectively. And each of the coil strands ls1, ls2, ls3 included in a plurality of second coil layers CL2-1, CL2-2, CL2-3, CL2-4 may be disposed in a second trace TR2, a fourth trace TR4, a sixth trace TR6.

According to this configuration, since the distance between each of the coil strands included in a plurality of first coil layers CL1-1, CL1-2, CL1-3, CL1-4 and each of the coil strands included in a plurality of second coil layers CL2-1, CL2-2, CL2-3, CL2-4 is increased, it is possible to reduce the proximity effect between each of the coil strands included in a plurality of first coil layers CL1-1, CL1-2, CL1-3, CL1-4 and each of the coil strands included in a plurality of second coil layers CL2-1, CL2-2, CL2-3, CL2-4. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

As shown in FIG. 30, in the non-connection region 3001a, 3001b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to be parallel to each other.

As shown in FIG. 30, in the connection region 3002, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to intersect with each other.

In the connection region 3002, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected to each other. In an embodiment, the connection region 3002 may include a via VT1, VT2 electrically connecting at least one of coil strands included in a plurality of first coil layers CL1-1, CL1-2, CL1-3, CL1-4 with at least one of coil strands included in a plurality of second coil layers CL2-1, CL2-2, CL2-3, CL2-4.

For example, referring to FIGS. 28 to 30, 32, and 33, the connection region 3002 may include a via VT1, VT2 (e.g., through via) electrically connecting the via pattern V1, V2 electrically connected to at least one of the coil strands included in a plurality of first coil layers CL1-1, CL1-2, CL1-3, CL1-4, with the via pattern V1, V2 electrically connected to at least one of the coil strands included in a plurality of second coil layers CL2-1, CL2-2, CL2-3, CL2-4.

According to this structure, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected in the connection region 3002 while intersecting with each other. Thereby, the entire coil pattern included in the working coil can have a twisted structure like a litz coil. Therefore, it is possible to reduce the skin effect and/or proximity effect between each of the coil strands included in a plurality of first coil layers CL1-1, CL1-2, CL1-3, CL1-4 and each of the coil strands included in a plurality of second coil layers CL2-1, CL2-2, CL2-3, CL2-4. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

As shown in FIG. 30, the connection region 3002 may include two or more via patterns V1, V2. Therefore, the connection region 3002 may include two or more vias VT1, VT2.

In an embodiment, each of the via patterns may be disposed on a straight line intersecting at a predetermined angle with a coil strand included in a plurality of first coil layers CL1-1, CL1-2, CL1-3, CL1-4 or a plurality of second coil layers CL2-1, CL2-2, CL2-3, CL2-4. For example, in FIG. 30, the first via pattern V1 and the second via pattern V2 included in the first coil turn CT1 are disposed on a straight line intersecting at a predetermined angle with the coil strands disposed in the non-connection region 3001a, 3001b.

In an embodiment, each of the via patterns included in each of the coil turns may be disposed on the same straight line. For example, in FIG. 30, the first via pattern V1 included in the first coil turn CT1 and the first via pattern included in the second coil turn CT2 are disposed on the same straight line AA1-AA2. Similarly, the second via pattern V2 included in the first coil turn CT1 and the second via pattern included in the second coil turn CT2 are disposed on the same straight line BB1-BB2.

In an embodiment, each of the via patterns included in each of the coil turns may be disposed at the same location as the via pattern included in another coil turn. For example, in FIG. 30, the first via pattern V1 included in the first coil turn CT1 and the first via pattern included in the second coil turn CT2 are disposed in the same location. Similarly, the second via pattern V2 included in the first coil turn CT1 and the second via pattern included in the second coil turn CT2 are disposed in the same location.

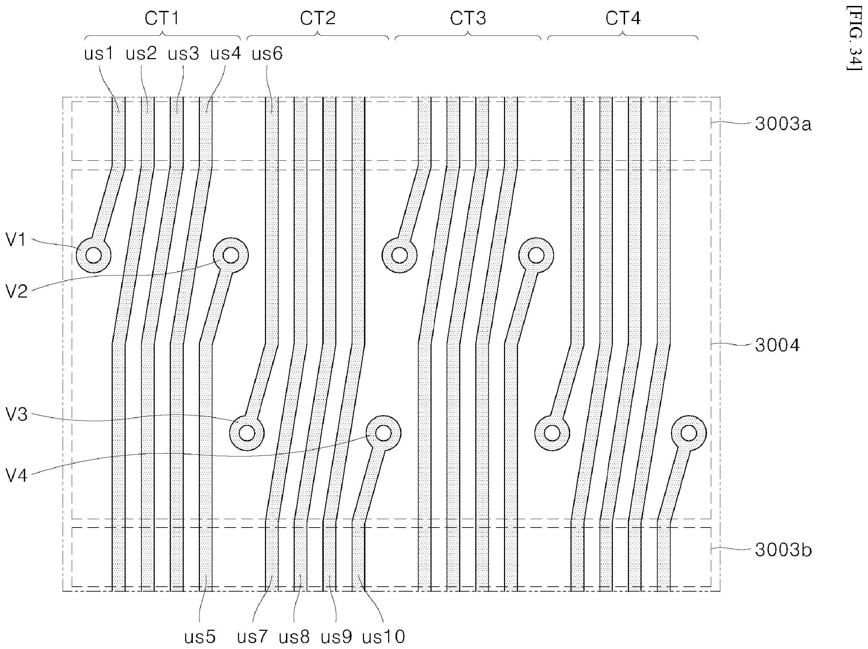

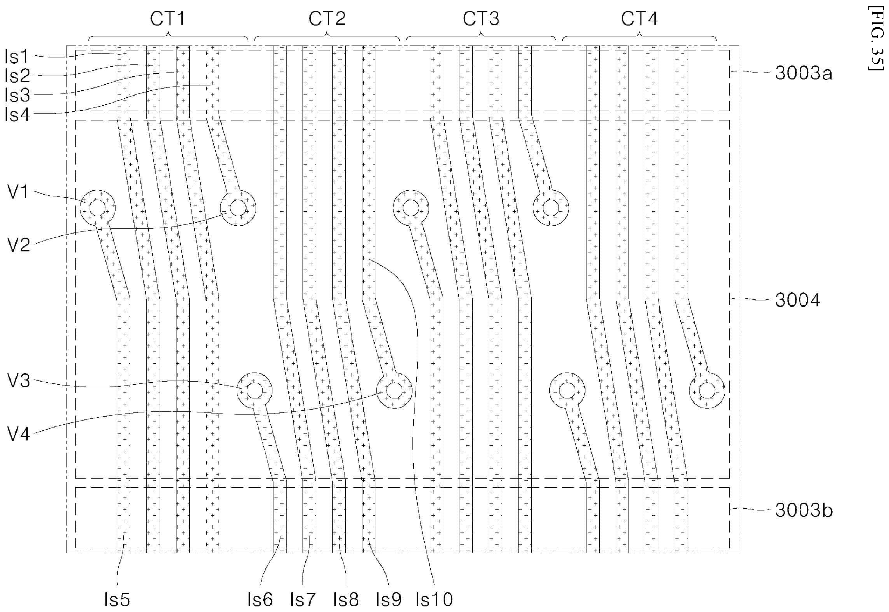

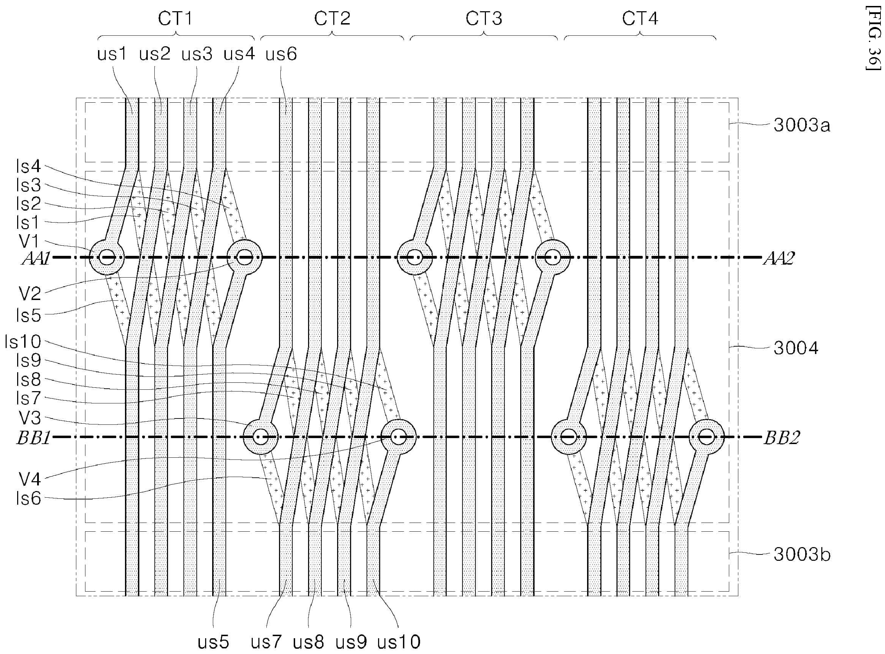

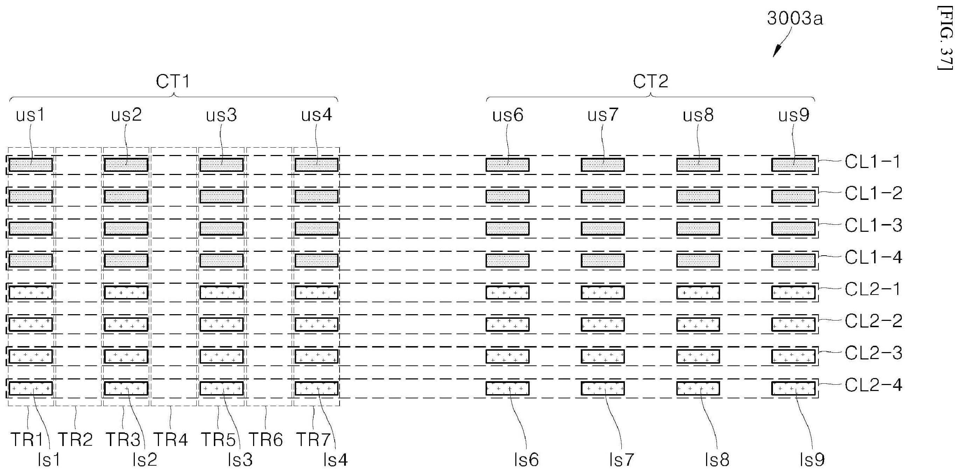

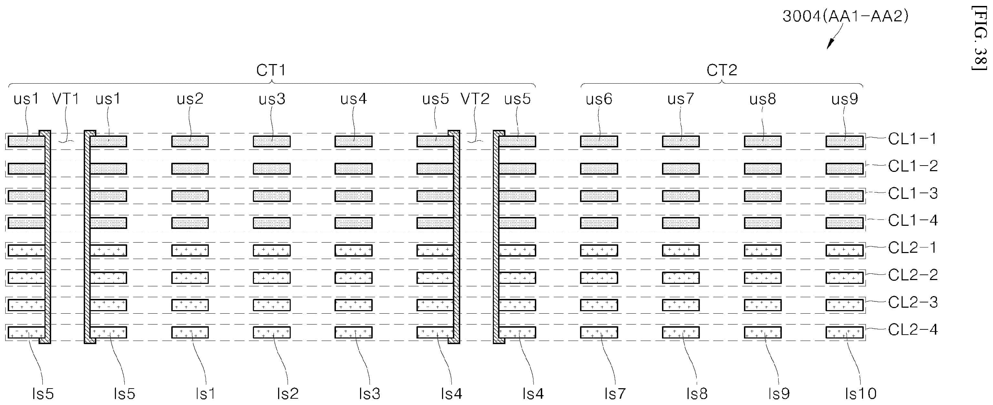

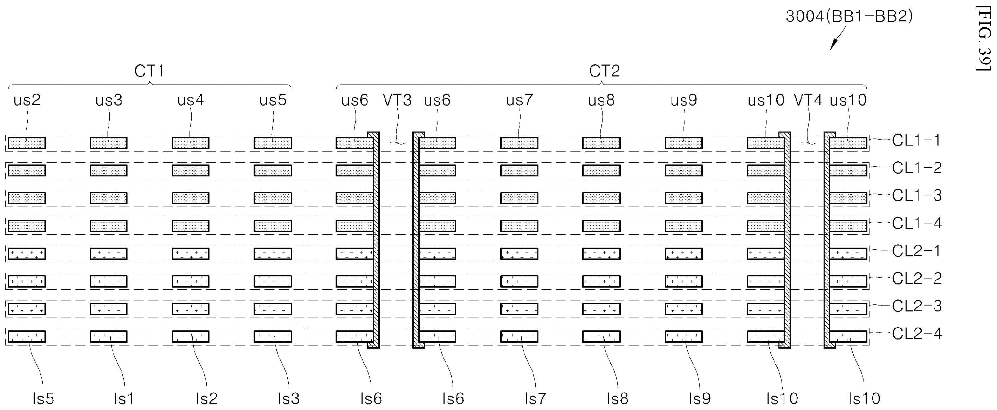

FIG. 34 is an enlarged view of a portion of a first coil layer set of a coil pattern of a working coil according to a second embodiment. FIG. 35 is an enlarged view of a portion of a second coil layer set of a coil pattern of a working coil according to a second embodiment. FIG. 36 is an enlarged view of a portion of a first coil layer set and a second coil layer set of a working coil according to a second embodiment. FIG. 37 is a cross-sectional view of a non-connection region of a coil pattern of a working coil according to a second embodiment. FIG. 38 is a cross-sectional view of AA1-AA2 portion of a connection region of a coil pattern of a working coil according to a second embodiment. FIG. 39 is a cross-sectional view of BB1-BB2 portion of a connection region of a coil pattern of a working coil according to a second embodiment.

As shown in FIGS. 34 to 36, the working coil according to a second embodiment may include a plurality of coil turns CT1, CT2, CT3, CT4. Although only four coil turns CT1, CT2, CT3, CT4 included in the working coil are illustrated in FIGS. 34 to 36, the number of coil turns included in the working coil may be variable depending on the embodiment.

Each of the coil turns CT1, CT2, CT3, CT4 may include a plurality of coil strands. For example, the first coil turn CT1 may include a plurality of coil strands us1, us2, us3, us4, us5, ..., ls1, ls2, ls2, ls4, .... Similarly, the second coil turn CT2, the third coil turn CT3, and the fourth coil turn CT4 may also include a plurality of coil strands.

Additionally, each of the coil turns CT1, CT2, CT3, CT4 may include a plurality of via patterns V1, V2, .... For example, the first coil turn CT1 may include a plurality of via patterns V1, V2, ..., and the second coil turn CT2 may include a plurality of via patterns V3, V4, .... Similarly, the third coil turn CT3 and the fourth coil turn CT4 may include a plurality of via patterns.

As illustrated in FIGS. 37 to 39, a working coil according to a second embodiment may include a first coil layer set including a plurality of first coil layers CL1-1, CL1-2, CL1-3, CL1-4, and a second coil layer set including a plurality of second coil layers CL2-1, CL2-2, CL2-3, CL2-4.

The plurality of first coil layers CL1-1, CL1-2, CL1-3, CL1-4 may be disposed according to a first pattern. The plurality of first coil layers CL1-1, CL1-2, CL1-3, CL1-4 may be stacked in the vertical direction.

The plurality of second coil layers CL2-1, CL2-2, CL2-3, CL2-4 may be disposed according to a second pattern different from the first pattern. The plurality of second coil layers CL2-1, CL2-2, CL2-3, CL2-4 may be stacked in the vertical direction. The plurality of second coil layers CL2-1, CL2-2, CL2-3, CL2-4 may be disposed under the plurality of first coil layers CL1-1, CL1-2, CL1-3, CL1-4.

Each of the coil layers may include a plurality of coil strands. For example, each of the first coil layer CL1-1, CL1-2, CL1-3, CL1-4 and the second coil layer CL2-1, CL2-2, CL2-3, CL2-4 may include a plurality of coil strands us1, us2, us3, us4, us5, ..., ls1, ls2, ls2, ls4, ....

Although only the cross-sectional view of the first coil turn CT1 and the second coil turn CT2 is illustrated in FIGS. 37 to 39, the third coil turn CT3 and the fourth coil turn CT4 may also have the same structure and pattern as the first coil turn CT1 and the second coil turn CT2.

FIGS. 37 to 39 illustrate an embodiment in which a working coil includes four first coil layers CL1-1, CL1-2, CL1-3, CL1-4 and four second coil layers CL2-1, CL2-2, CL2-3, CL2-4. However, the number of coil layers included in the working coil may be variable depending on the embodiment.

Referring back to the drawings, the working coil according to the second embodiment may include a non-connection region 3003a, 3003b and a connection region 3004.

The non-connection region 3003a, 3003b and the connection region 3004 may be alternately disposed. For example, although not shown in the drawings, another connection region may be disposed at one end of the non-connection region 3003a, and still another connection region may be disposed at one end of the non-connection region 3003b.

Referring to FIGS. 34 to 37, in the non-connection region 3003a, 3003b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may not be electrically connected to each other.

In an embodiment, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed in the same trace as each other in the non-connection region 3003a, 3003b.

For example, as illustrated in FIG. 37, the coil strands us1, us2, us3, us4 of a plurality of first coil layers CL1-1, CL1-2, CL1-3, CL1-4 included in the first coil turn CT1 may be disposed in a first trace TR1, a third trace TR3, a fifth trace TR5, and a seventh trace TR7, respectively. And the coil strands ls1, ls2, ls3, ls4 of a plurality of second coil layers CL2-1, CL2-2, CL2-3, CL2-4 included in the first coil turn CT1 may also be disposed in the first trace TR1, the third trace TR3, the fifth trace TR5, and the seventh trace TR7, respectively.

As shown in FIG. 36, in the non-connection region 3003a, 3003b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to be parallel to each other.

As shown in FIG. 36, in the connection region 3004, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to intersect with each other.

In the connection region 3004, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected to each other. In an embodiment, the connection region 3004 may include a via VT1, VT2, VT3, VT4 electrically connecting at least one of coil strands included in a plurality of first coil layers CL1-1, CL1-2, CL1-3, CL1-4 with at least one of coil strands included in a plurality of second coil layers CL2-1, CL2-2, CL2-3, CL2-4.

For example, referring to FIGS. 34 to 36, 38, and 39, the connection region 3004 may include a via VT1, VT2, VT3, VT4 (e.g., through via) electrically connecting the via pattern V1, V2, V3, V4 electrically connected to at least one of the coil strands included in a plurality of first coil layers CL1-1, CL1-2, CL1-3, CL1-4 with the via pattern V1, V2, V3, V4 electrically connected to at least one of the coil strands included in a plurality of second coil layers CL2-1, CL2-2, CL2-3, CL2-4.

According to this structure, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected in the connection region 3004 while intersecting with each other. Thereby, the entire coil pattern included in the working coil can have a twisted structure like a litz coil. Therefore, it is possible to reduce the skin effect and/or proximity effect between each of the coil strands included in a plurality of first coil layers CL1-1, CL1-2, CL1-3, CL1-4 and each of the coil strands included in a plurality of second coil layers CL2-1, CL2-2, CL2-3, CL2-4. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

As shown in FIG. 36, the connection region 3004 may include two or more via patterns V1, V2, V3, V4. Therefore, the connection region 3004 may include two or more vias VT1, VT2, VT3, VT4.

In an embodiment, each of the via patterns may be disposed on a straight line orthogonal to a coil strand included in a plurality of first coil layers CL1-1, CL1-2, CL1-3, CL1-4 or a plurality of second coil layers CL2-1, CL2-2, CL2-3, CL2-4. For example, in FIG. 36, the first via pattern V1 and the second via pattern V2 included in the first coil turn CT1 are disposed on a straight line AA1-AA2 orthogonal to the coil strands disposed in the non-connection region 3003a, 3003b. Similarly, the third via pattern V3 and the fourth via pattern V4 included in the second coil turn CT2 are disposed on a straight line BB1-BB2 orthogonal to the coil strands disposed in the non-connection region 3003a, 3003b.

In an embodiment, each of the via patterns included in each of the coil turns may be disposed on the same straight line. For example, in FIG. 36, the first via pattern V1 and the second via pattern V2 included in the first coil turn CT1 are disposed on the same straight line AA1-AA2. Similarly, the third via pattern V3 and the fourth via pattern V4 included in the second coil turn CT2 are disposed on the same straight line BB1-BB2.

In an embodiment, each of the via patterns included in the nth coil turn may be disposed in the same location as the via pattern included in the (n+2)th coil turn. (where n is a positive integer) For example, in FIG. 30, the first via pattern V1 and the second via pattern V2 included in the first coil turn CT1 are disposed in the same location as the first via pattern and the second via pattern included in the third coil turn CT3. Similarly, the third via pattern V3 and the fourth via pattern V4 included in the second coil turn CT2 are disposed in the same location as the third via pattern and the fourth via pattern included in the fourth coil turn CT4.

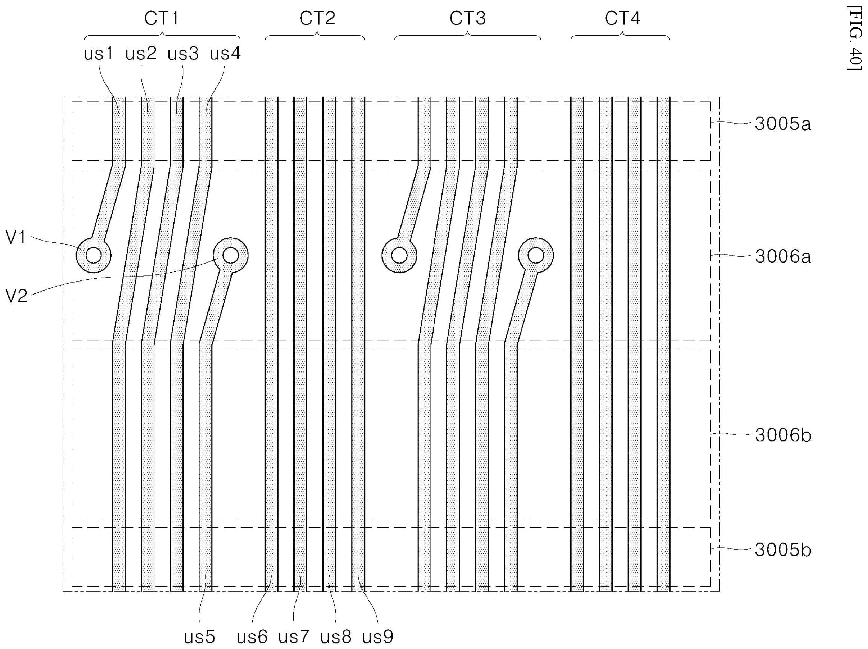

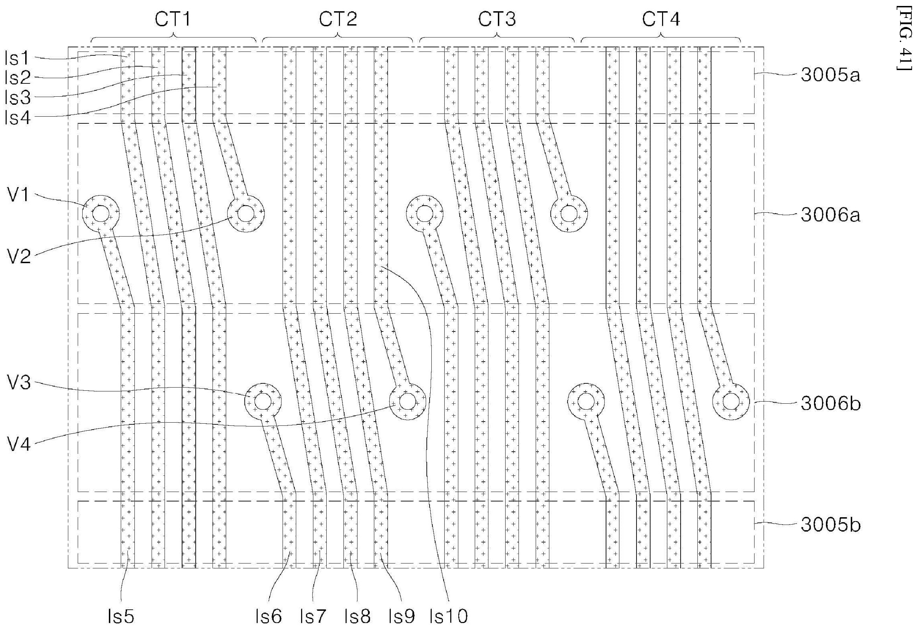

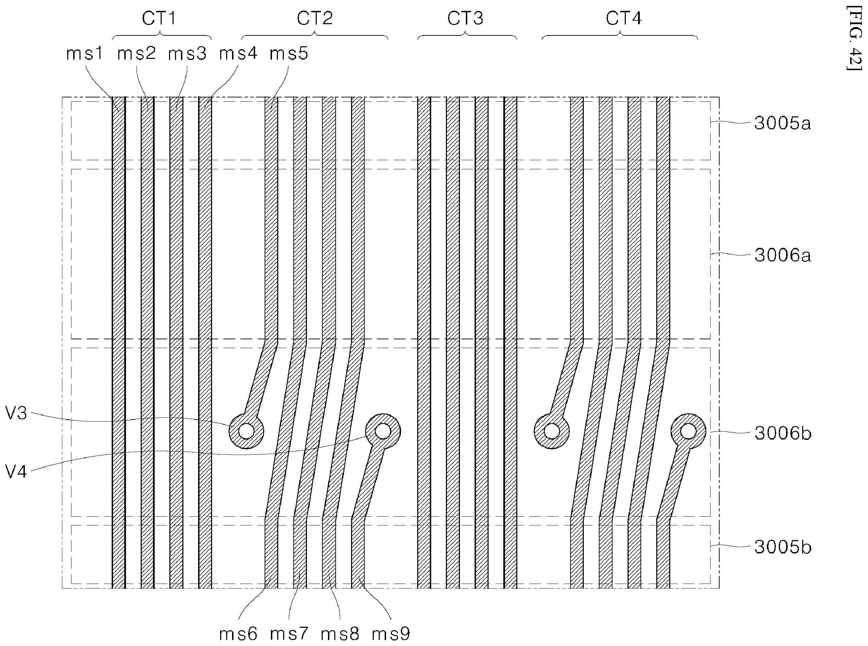

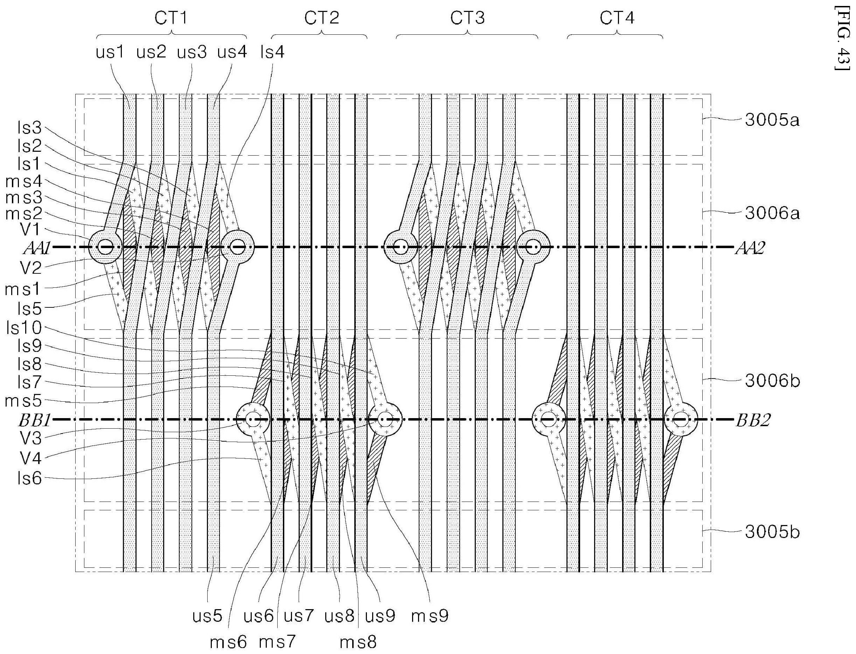

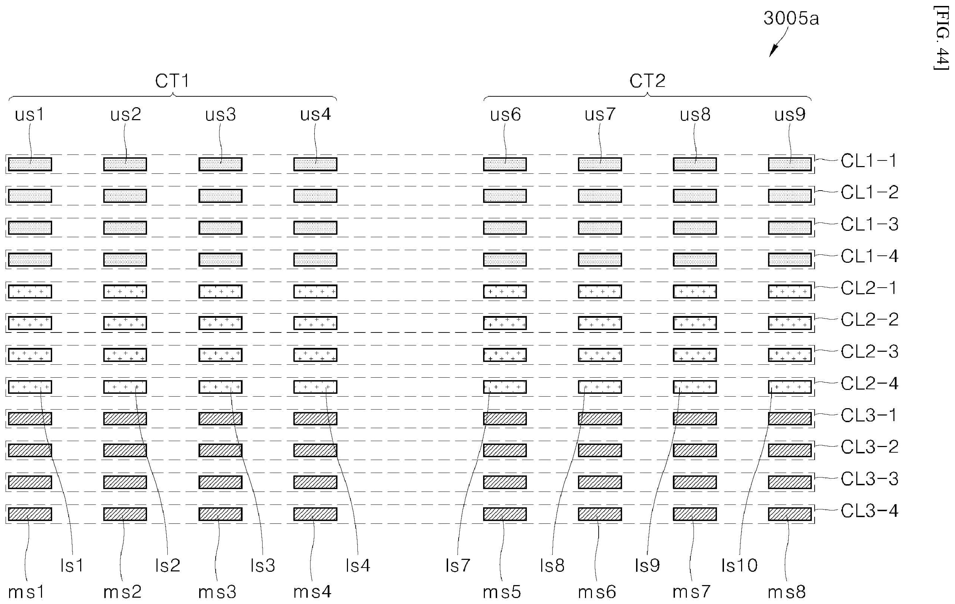

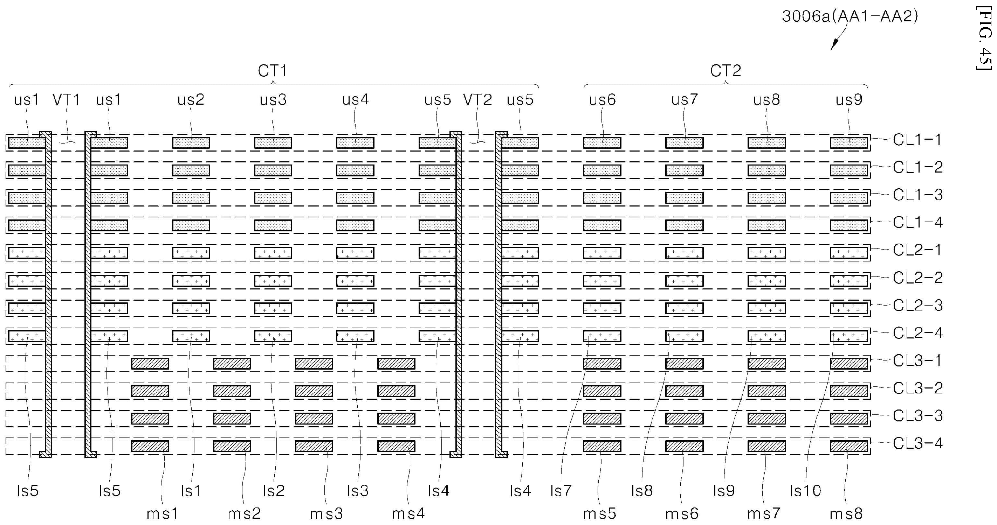

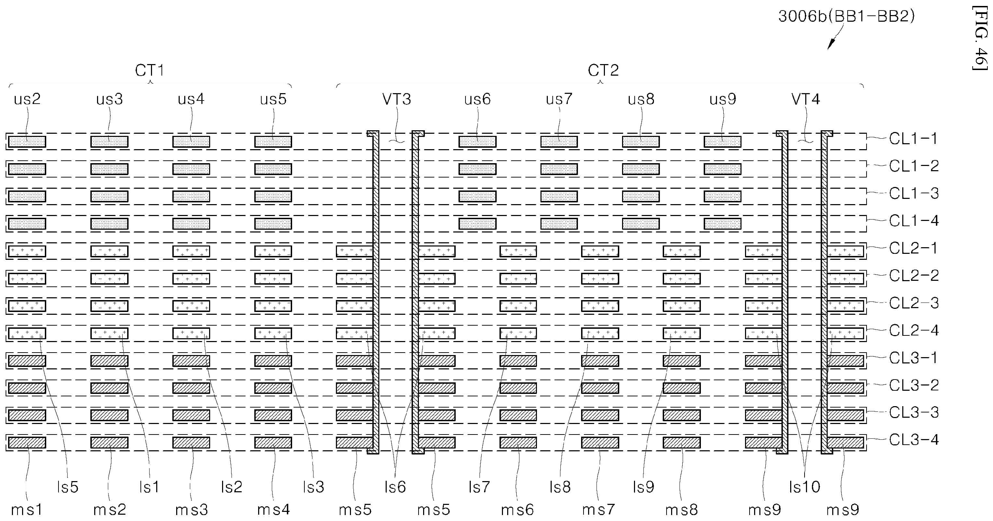

FIG. 40 is an enlarged view of a portion of a first coil layer set of a coil pattern of a working coil according to a third embodiment. FIG. 41 is an enlarged view of a portion of a second coil layer set of a coil pattern of a working coil according to a third embodiment. FIG. 42 is an enlarged view of a portion of a third coil layer set of a coil pattern of a working coil according to a third embodiment. FIG. 43 is an enlarged view of a portion of a first coil layer set, a second coil layer set, and a third coil layer set of a working coil according to a third embodiment. FIG. 44 is a cross-sectional view of a non-connection region of a coil pattern of a working coil according to a third embodiment. FIG. 45 is a cross-sectional view of AA1-AA2 portion of a connection region of a coil pattern of a working coil according to a third embodiment. FIG. 46 is a cross-sectional view of BB1-BB2 portion of a connection region of a coil pattern of a working coil according to a third embodiment.

As shown in FIGS. 40 to 43, the working coil according to a third embodiment may include a plurality of coil turns CT1, CT2, CT3, CT4. Although only four coil turns CT1, CT2, CT3, CT4 included in the working coil are illustrated in FIGS. 40 to 43, the number of coil turns included in the working coil may be variable depending on the embodiment.

Each of the coil turns CT1, CT2, CT3, CT4 may include a plurality of coil strands. For example, the first coil turn CT1 may include a plurality of coil strands us1, us2, us3, us4, us5, ..., ls1, ls2, ls2, ls4, .... Similarly, the second coil turn CT2, the third coil turn CT3, and the fourth coil turn CT4 may also include a plurality of coil strands.

Additionally, each of the coil turns CT1, CT2, CT3, CT4 may include a plurality of via patterns V1, V2, .... For example, the first coil turn CT1 may include a plurality of via patterns V1, V2, ..., and the second coil turn CT2 may include a plurality of via patterns V3, V4, .... Similarly, the third coil turn CT3 and the fourth coil turn CT4 may include a plurality of via patterns.

As illustrated in FIGS. 40 to 43, a working coil according to a third embodiment may include a first coil layer set including a plurality of first coil layers CL1-1, CL1-2, CL1-3, CL1-4, a second coil layer set including a plurality of second coil layers CL2-1, CL2-2, CL2-3, CL2-4, and a third coil layer set including a plurality of third coil layers CL3-1, CL3-2, CL3-3, CL3-4.

The plurality of first coil layers CL1-1, CL1-2, CL1-3, CL1-4 may be disposed according to a first pattern. The plurality of first coil layers CL1-1, CL1-2, CL1-3, CL1-4 may be stacked in the vertical direction.

The plurality of second coil layers CL2-1, CL2-2, CL2-3, CL2-4 may be disposed according to a second pattern different from the first pattern. The plurality of second coil layers CL2-1, CL2-2, CL2-3, CL2-4 may be stacked in the vertical direction. The plurality of second coil layers CL2-1, CL2-2, CL2-3, CL2-4 may be disposed under the plurality of first coil layers CL1-1, CL1-2, CL1-3, CL1-4.

The plurality of third coil layers CL3-1, CL3-2, CL3-3, CL3-4 may be disposed according to a third pattern different from the first pattern and the second pattern. The plurality of third coil layers CL3-1, CL3-2, CL3-3, CL3-4 may be stacked in the vertical direction. The plurality of third coil layers CL3-1, CL3-2, CL3-3, CL3-4 may be disposed under the plurality of second coil layers CL2-1, CL2-2, CL2-3, CL2-4.

Each of the coil layers may include a plurality of coil strands. For example, each of the first coil layer CL1-1, CL1-2, CL1-3, CL1-4, the second coil layer CL2-1, CL2-2, CL2-3, CL2-4, and the third coil layer CL3-1, CL3-2, CL3-3, CL3-4 may include a plurality of coil strands us1, us2, us3, us4, us5, ..., ls1, ls2, ls2, ls4, ..., ms1, ms2, ms3, ms4, ....

Although only the cross-sectional view of the first coil turn CT1 and the second coil turn CT2 is illustrated in FIGS. 44 to 46, the third coil turn CT3 and the fourth coil turn CT4 may also have the same structure and pattern as the first coil turn CT1 and the second coil turn CT2.

FIGS. 44 to 46 illustrate an embodiment in which a working coil includes four first coil layers CL1-1, CL1-2, CL1-3, CL1-4, four second coil layers CL2-1, CL2-2, CL2-3, CL2-4, and four third coil layers CL3-1, CL3-2, CL3-3, CL3-4. However, the number of coil layers included in the working coil may be variable depending on the embodiment.

Referring back to the drawings, the working coil according to the third embodiment may include a non-connection region 3005a, 3005b and a connection region 3006a, 3006b.

The non-connection region 3005a, 3005b and the connection region 3006a, 3006b may be alternately disposed. For example, although not shown in the drawings, another connection region may be disposed at one end of the non-connection region 3005a, and still another connection region may be disposed at one end of the non-connection region 3005b.

Referring to FIGS. 40 to 44, in the non-connection region 3005a, 3005b, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may not be electrically connected to each other.

In an embodiment, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be disposed in the same trace as each other in the non-connection region 3005a, 3005b. However, in another embodiment, at least one of each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be disposed in a different trace from a coil strand included in another coil layer.

As shown in FIG. 44, in the non-connection region 3005a, 3005b, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be disposed to be parallel to each other.

As shown in FIG. 43, in the connection region 3006a, 3006b, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be disposed to intersect with each other.

In the connection region 3006a, 3006b, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be electrically connected to each other. In an embodiment, the connection region 3006a, 3006b may include a via VT1, VT2, VT3, VT4 electrically connecting at least one of coil strands included in a plurality of first coil layers CL1-1, CL1-2, CL1-3, CL1-4 and at least one of the coil strands included in a plurality of second coil layers CL2-1, CL2-2, CL2-3, CL2-4 and at least one of each of the coil strands included in a plurality of third coil layers CL3-1, CL3-2, CL3-3, CL3-4.

For example, referring to FIGS. 40 to 43, 45, and 46, the connection region 3006a, 3006b may include a via VT1, VT2, VT3, VT4 (e.g., through via) electrically connecting the via pattern V1, V2, V3, V4 electrically connected to at least one of the coil strands included in a plurality of first coil layers CL1-1, CL1-2, CL1-3, CL1-4 with the via pattern V1, V2, V3, V4 electrically connected to at least one of the coil strands included in a plurality of second coil layers CL2-1, CL2-2, CL2-3, CL2-4.

The connection region 3006a, 3006b may include a first connection region 3006a and a second connection region 3006b. In the first connection region 3006a, a via may be formed in the nth coil turn. In the second connection region 3006b, a via may be formed at the (n+2)th coil turn. (where n is a positive integer) For example, in the first connection region 3006a, the vias VT1, VT2 may be formed in the first and third coil turns, while, in the second connection region 3006b, the vias VT3, VT4 may be formed in the second and fourth coil turns.

According to this structure, each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be electrically connected in the connection region 3006a, 3006b while intersecting with each other. Thereby, the entire coil pattern included in the working coil can have a twisted structure like a litz coil. Therefore, it is possible to reduce the skin effect and/or proximity effect among each of the coil strands included in a plurality of first coil layers CL1-1, CL1-2, CL1-3, CL1-4, each of the coil strands included in a plurality of second coil layers CL2-1, CL2-2, CL2-3, CL2-4, and each of the coil strands included in a plurality of third coil layers CL3-1, CL3-2, CL3-3, CL3-4 may be electrically connected to each other. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

As shown in FIG. 43, the connection region 3006a, 3006b may include two or more via patterns V1, V2, V3, V4. Therefore, the connection region 3006a, 3006b may include two or more vias VT1, VT2, VT3, VT4.

In an embodiment, each of the via patterns may be disposed on a straight line orthogonal to a coil strand included in a plurality of first coil layers CL1-1, CL1-2, CL1-3, CL1-4 or a plurality of second coil layers CL2-1, CL2-2, CL2-3, CL2-4 or a plurality of third coil layers CL3-1, CL3-2, CL3-3, CL3-4. For example, in FIG. 43, the first via pattern V1 and the second via pattern V2 included in the first coil turn CT1 are disposed on a straight line AAT-AA2 orthogonal to the coil strands disposed in the non-connection region 3005a, 3005b. Similarly, the third via pattern V3 and the fourth via pattern V4 included in the second coil turn CT2 are disposed on a straight line BB1-BB2 orthogonal to the coil strands disposed in the non-connection region 3005a, 3005b.

In an embodiment, each of the via patterns included in each of the coil turns may be disposed on the same straight line. For example, in FIG. 43, the first via pattern V1 and the second via pattern V2 included in the first coil turn CT1 are disposed on the same straight line AA1-AA2. Similarly, the third via pattern V3 and the fourth via pattern V4 included in the second coil turn CT2 are disposed on the same straight line BB1-BB2.

In an embodiment, each of the via patterns included in the nth coil turn may be disposed in the same location as the via pattern included in the (n+2)th coil turn. (where n is a positive integer) For example, in FIG. 43, the first via pattern V1 and the second via pattern V2 included in the first coil turn CT1 are disposed in the same location as the first via pattern and the second via pattern included in the third coil turn CT3. Similarly, the third via pattern V3 and the fourth via pattern V4 included in the second coil turn CT2 are disposed in the same location as the third via pattern and the fourth via pattern included in the fourth coil turn CT4.

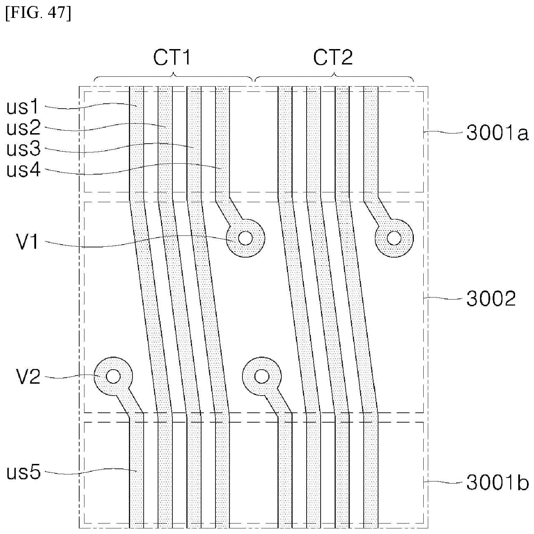

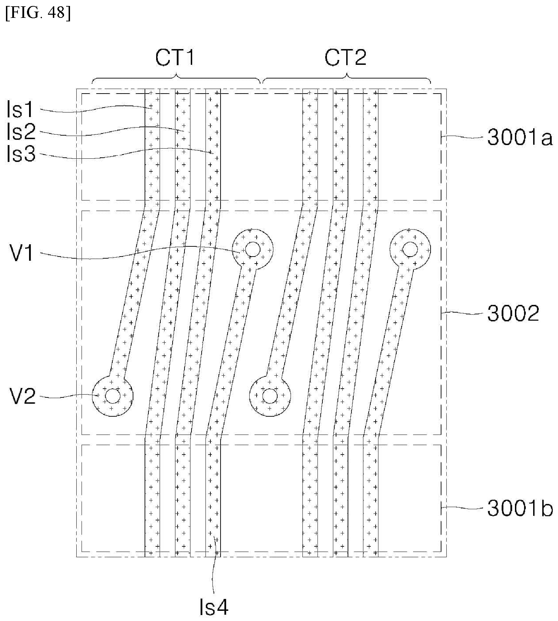

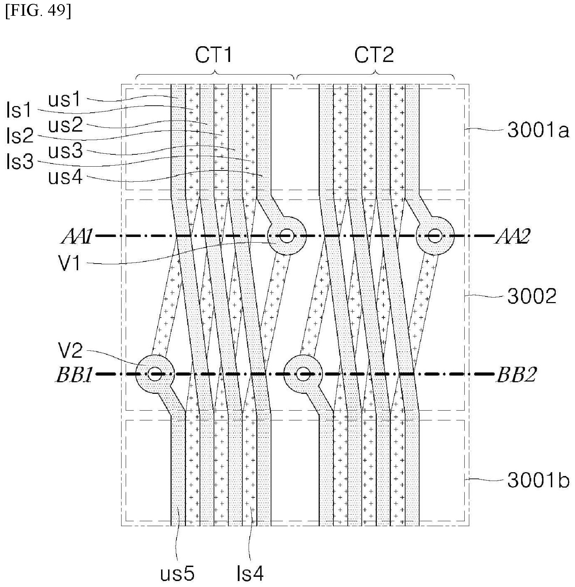

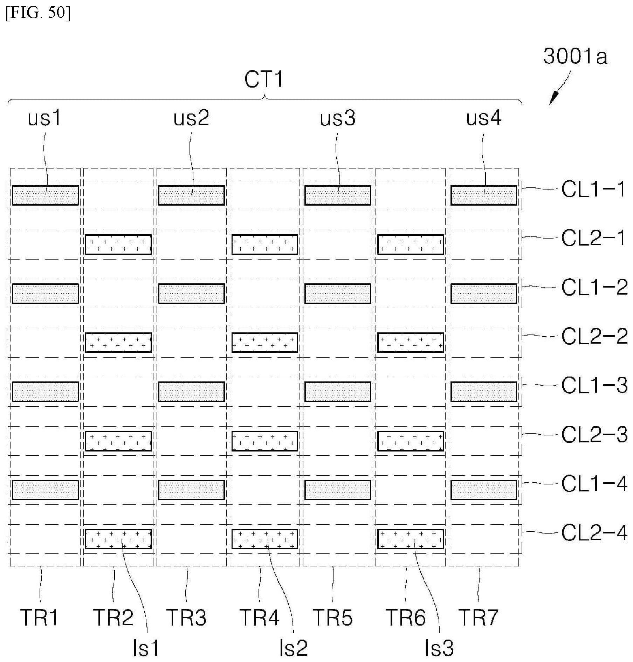

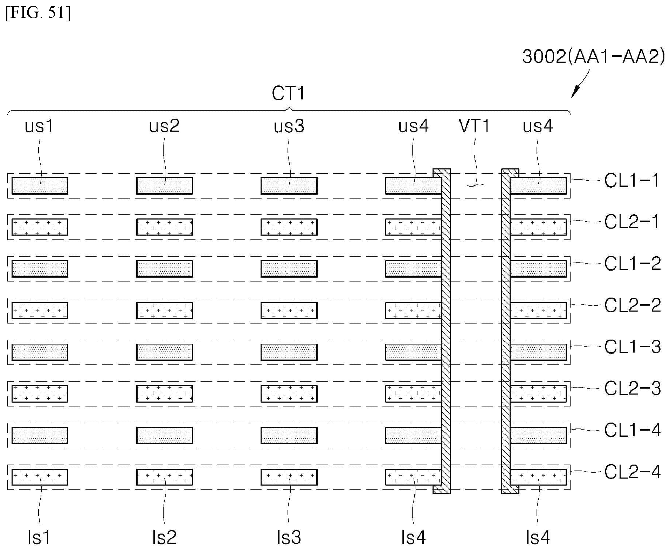

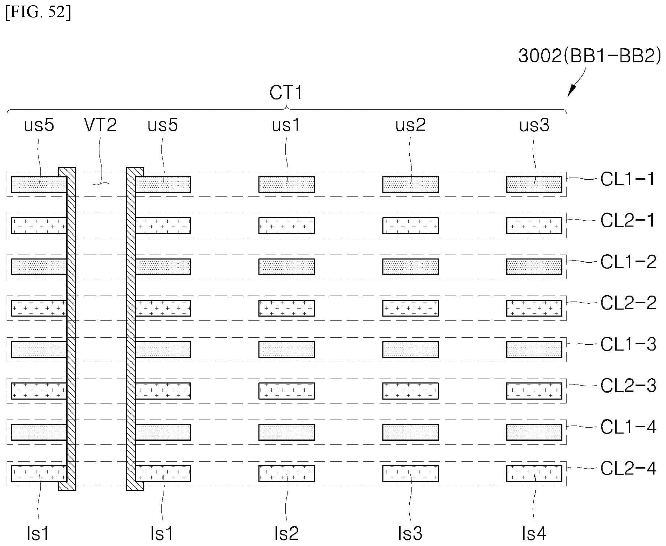

FIG. 47 is an enlarged view of a portion of a first coil layer set of a coil pattern of a working coil according to a fourth embodiment. FIG. 48 is an enlarged view of a portion of a second coil layer set of a coil pattern of a working coil according to a fourth embodiment. FIG. 49 is an enlarged view of a portion of a first coil layer set and a second coil layer set of a working coil according to a fourth embodiment. FIG. 50 is a cross-sectional view of a non-connection region of a coil pattern of a working coil according to a fourth embodiment. FIG. 51 is a cross-sectional view of AA1-AA2 portion of a connection region of a coil pattern of a working coil according to a fourth embodiment. FIG. 52 is a cross-sectional view of BB1-BB2 portion of a connection region of a coil pattern of a working coil according to a fourth embodiment.

As shown in FIGS. 47 to 52, the working coil according to a fourth embodiment may include a plurality of coil turns CT1, CT2. Although only two coil turns CT1, CT2 included in the working coil are illustrated in FIGS. 47 to 52, the number of coil turns included in the working coil may be variable depending on the embodiment.

Each of the coil turns CT1, CT2 may include a plurality of coil strands. For example, the first coil turn CT1 may include a plurality of coil strands us1, us2, us3, us4, us5, ..., ls1, ls2, ls2, ls4, .... Similarly, the second coil turn CT2 may also include a plurality of coil strands.

Additionally, each of the coil turns CT1, CT2 may include a plurality of via patterns V1, V2, .... For example, the first coil turn CT1 may include a plurality of via patterns V1, V2, .... Similarly, the second coil turn CT2 may include a plurality of via patterns.

As illustrated in FIGS. 50 to 52, a working coil according to a first embodiment may include a first coil layer set including a plurality of first coil layers CL1-1, CL1-2, CL1-3, CL1-4, and a second coil layer set including a plurality of second coil layers CL2-1, CL2-2, CL2-3, CL2-4.

The plurality of first coil layers CL1-1, CL1-2, CL1-3, CL1-4 may be disposed according to a first pattern. The plurality of first coil layers CL1-1, CL1-2, CL1-3, CL1-4 may be stacked in the vertical direction.

The plurality of second coil layers CL2-1, CL2-2, CL2-3, CL2-4 may be disposed according to a second pattern different from the first pattern. The plurality of second coil layers CL2-1, CL2-2, CL2-3, CL2-4 may be stacked in the vertical direction.

In an embodiment, a plurality of first coil layers CL1-1, CL1-2, CL1-3, CL1-4 and a plurality of second coil layers CL2-1, CL2-2, CL2-3, CL2-4 may be alternately disposed with each other. For example, as illustrated in FIGS. 50 to 52, the second coil layer CL2-1 may be disposed under the first coil layer CL1-1, and the first coil layer CL1-2 may be disposed under the second coil layer CL2-1. In this way, a plurality of first coil layers CL1-1, CL1-2, CL1-3, CL1-4 and a plurality of second coil layers CL2-1, CL2-2, CL2-3, CL2-4 may be alternately disposed with each other.

Although not shown, in another embodiment, the first coil layer CL1-2 may be disposed under the first coil layer CL1-1, and the second coil layer CL2-1 and the second coil layer CL2-2 may be disposed under the first coil layer CL1-2. And the first coil layer CL1-3 and the first coil layer CL1-4 may be stacked under the second coil layer CL2-2.

Meanwhile, although not shown, the first coil layer and the second coil layer included in the working coil according to the second embodiment shown in FIGS. 34 to 39 may also be alternately disposed with each other.

Additionally, although not shown, at least two coil layers of the first, second, and third coil layers included in the working coil according to the third embodiment shown in FIGS. 40 to 46 may be alternately disposed with each other.

Each of the coil layers may include a plurality of coil strands. For example, each of the first coil layer CL1-1, CL1-2, CL1-3, CL1-4 and the second coil layer CL2-1, CL2-2, CL2-3, CL2-4 may include a plurality of coil strands us1, us2, us3, us4, us5, ..., ls1, ls2, ls2, ls4, ....

Although only the cross-sectional view of the first coil turn CT1 is illustrated in FIGS. 50 to 52, the second coil turn CT2 may also have the same structure and pattern as the first coil turn CT1.

FIGS. 50 to 52 illustrate an embodiment in which a working coil includes four first coil layers CL1-1, CL1-2, CL1-3, CL1-4 and four second coil layers CL2-1, CL2-2, CL2-3, CL2-4. However, the number of coil layers included in the working coil may be variable depending on the embodiment.

Referring back to the drawings, the working coil according to the fourth embodiment may include a non-connection region 3001a, 3001b and a connection region 3002.

The non-connection region 3001a, 3001b and the connection region 3002 may be alternately disposed. For example, although not shown in the drawings, another connection region may be disposed at one end of the non-connection region 3001a, and still another connection region may be disposed at one end of the non-connection region 3001b.

Referring to FIGS. 47 to 49, in the non-connection region 3001a, 3001b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may not be electrically connected to each other.

In an embodiment, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed in different traces in the non-connection region 3001a, 3001b.

For example, as shown in FIG. 50, the coil strands us1, us2, us3, us4 included in a plurality of first coil layers CL1-1, CL1-2, CL1-3, CL1-4 may be disposed in a first trace TR1, a third trace TR3, a fifth trace TR5, and a seventh trace TR7, respectively. And each of the coil strands ls1, ls2, ls3 included in a plurality of second coil layers CL2-1, CL2-2, CL2-3, CL2-4 may be disposed in a second trace TR2, a fourth trace TR4, a sixth trace TR6.

According to this configuration, since the distance between each of the coil strands included in a plurality of first coil layers CL1-1, CL1-2, CL1-3, CL1-4 and each of the coil strands included in a plurality of second coil layers CL2-1, CL2-2, CL2-3, CL2-4 is increased, it is possible to reduce the proximity effect between each of the coil strands included in a plurality of first coil layers CL1-1, CL1-2, CL1-3, CL1-4 and each of the coil strands included in a plurality of second coil layers CL2-1, CL2-2, CL2-3, CL2-4. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

The coil layer of the working coil illustrated in FIGS. 47 to 52 may be manufactured by a fine process. However, due to the nature of the fine process, there may be a case in which adjacent strands are unintentionally bonded or disconnected for unknown reasons. However, as described above, when the first coil layer and the second coil layer are alternately disposed with each other while applying the structure in which the first coil layer and the second coil layer are disposed in different traces, it is possible to respond advantageously to a situation where adjacent strands are bonded or disconnected during the manufacturing process of the coil layer as described above. In particular, even if the strands of some areas of the working coil are disconnected, there are other paths through which current can flow in the same direction, and thus, the reliability of the working coil and the home appliance can be improved.

As shown in FIG. 49, in the non-connection region 3001a, 3001b, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to be parallel to each other.

As shown in FIG. 49, in the connection region 3002, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be disposed to intersect with each other.

In the connection region 3002, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected to each other. In an embodiment, the connection region 3002 may include a via VT1, VT2 electrically connecting at least one of coil strands included in a plurality of first coil layers CL1-1, CL1-2, CL1-3, CL1-4 with at least one of coil strands included in a plurality of second coil layers CL2-1, CL2-2, CL2-3, CL2-4.

For example, referring to FIGS. 47 to 49, 51, and 52, the connection region 3002 may include a via VT1, VT2 (e.g., through via) electrically connecting the via pattern V1, V2 electrically connected to at least one of the coil strands included in a plurality of first coil layers CL1-1, CL1-2, CL1-3, CL1-4, with the via pattern V1, V2 electrically connected to at least one of the coil strands included in a plurality of second coil layers CL2-1, CL2-2, CL2-3, CL2-4.

According to this structure, each of the coil strands included in a plurality of first coil layers CL1-1, CL1-2, CL1-3, CL1-4 and each of the coil strands included in a plurality of second coil layers CL2-1, CL2-2, CL2-3, CL2-4 may be electrically connected in the connection region 3002 while intersecting with each other. Thereby, the entire coil pattern included in the working coil can have a twisted structure like a litz coil. Therefore, it is possible to reduce the skin effect and/or proximity effect between each of the coil strands included in a plurality of first coil layers CL1-1, CL1-2, CL1-3, CL1-4 and each of the coil strands included in a plurality of second coil layers CL2-1, CL2-2, CL2-3, CL2-4. Accordingly, since the current distribution and magnetic flux density distribution of the working coil become more uniform, power loss generated during the driving process of a home appliance can be reduced and power efficiency can be increased. Additionally, it is possible is to alleviate the phenomenon in which the temperature of a specific area of the working coil becomes excessively higher than that of other areas during the driving process of a home appliance.

As shown in FIG. 49, the connection region 3002 may include two or more via patterns V1, V2. Therefore, the connection region 3002 may include two or more vias VT1, VT2.

In an embodiment, each of the via patterns may be disposed on a straight line intersecting at a predetermined angle with a coil strand included in a plurality of first coil layers CL1-1, CL1-2, CL1-3, CL1-4 or a plurality of second coil layers CL2-1, CL2-2, CL2-3, CL2-4. For example, in FIG. 49, the first via pattern V1 and the second via pattern V2 included in the first coil turn CT1 are disposed on a straight line intersecting at a predetermined angle with the coil strands disposed in the non-connection region 3001a, 3001b.

In an embodiment, each of the via patterns included in each of the coil turns may be disposed on the same straight line. For example, in FIG. 49, the first via pattern V1 included in the first coil turn CT1 and the first via pattern included in the second coil turn CT1 are disposed on the same straight line AA1-AA2. Similarly, the second via pattern V2 included in the first coil turn CT1 and the second via pattern included in the second coil turn CT2 are disposed on the same straight line BB1-BB2.

In an embodiment, each of the via patterns included in each of the coil turns may be disposed at the same location as the via pattern included in another coil turn. For example, in FIG. 30, the first via pattern V1 included in the first coil turn CT1 and the first via pattern included in the second coil turn CT1 are disposed in the same location. Similarly,the second via pattern V2 included in the first coil turn CT1 and the second via pattern included in the second coil turn CT2 are disposed in the same location.

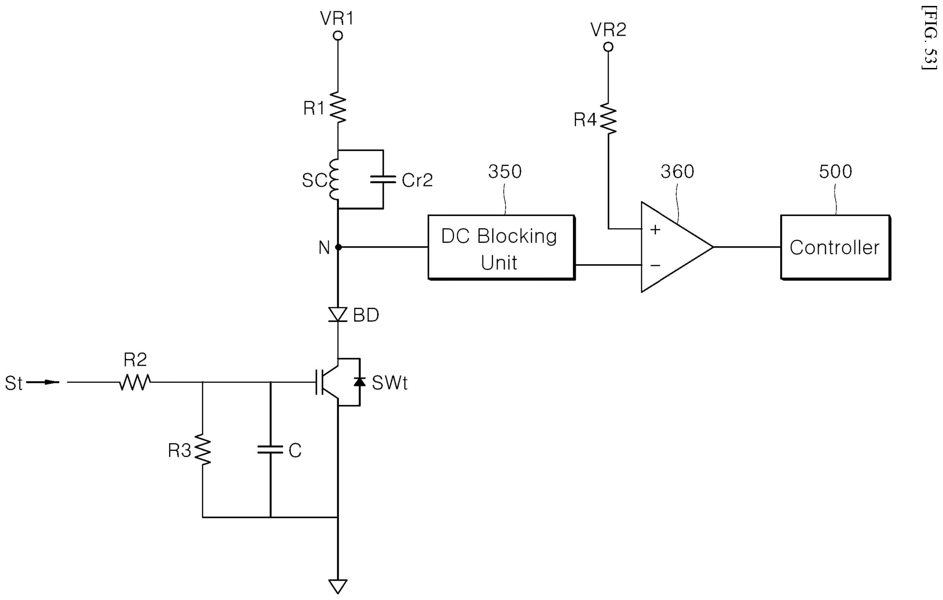

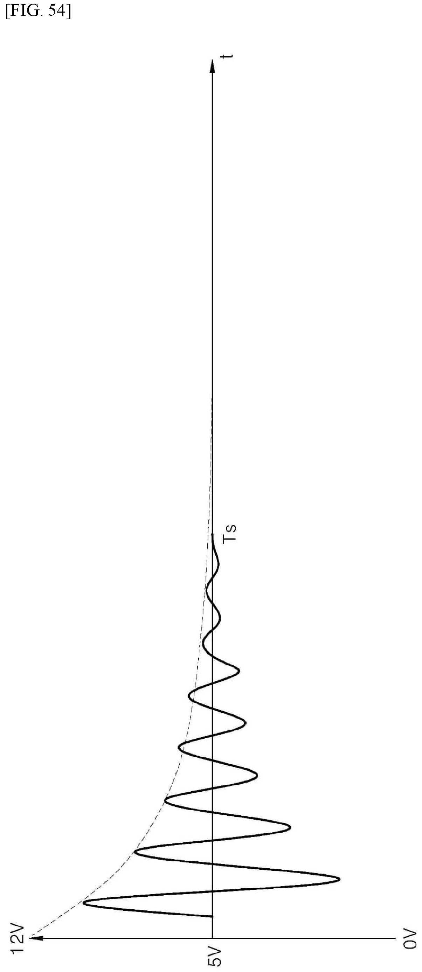

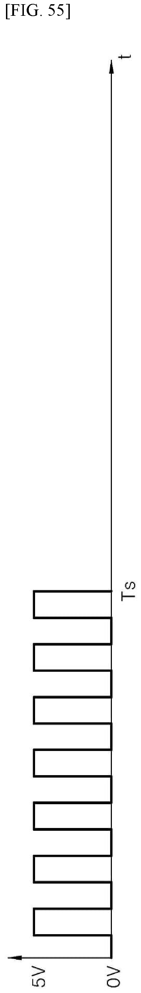

FIG. 53 is a circuit diagram of a sensing circuit according to an embodiment. FIG. 54 is a diagram illustrating a waveform of a resonance signal output from an output node of a sensing circuit according to an embodiment. FIG. 55 is a diagram illustrating a waveform of a square wave output from a comparator of a sensing circuit according to an embodiment.

In an embodiment, the controller 500 may perform container detection with the use of the sensing circuit shown in FIG. 53.

Referring to FIG. 53, a sensing circuit according to an embodiment may include a sensing coil SC, a resonance capacitor Cr2 connected in parallel with the sensing coil SC, a switching element SWt connected with the sensing coil SC and the resonance capacitor Cr2, and a comparator 360 comparing a resonance signal output from the output node N with a predetermined reference signal and outputting a square wave.

When the container detection starts, the controller 500 may turn on the switching element SWt for a predetermined charging time. Thereby, the first power voltage VR1 and the ground terminal can be electrically connected with each other, so that a voltage can be applied to the sensing coil SC and the resonance capacitor Cr2.

When the predetermined charging time has elapsed, the controller 500 may turn off the switching element SWt. Thereby, a resonance phenomenon can occur by the sensing coil SC and the resonance capacitor Cr2.

When the resonance phenomenon occurs by the sensing coil SC and the resonance capacitor Cr2, a resonance signal may be output through the output node N. FIG. 54 is a diagram illustrating a waveform of a resonance signal output from an output node of a sensing circuit according to an embodiment.

In an embodiment, the sensing circuit may further include a DC blocking unit 350 for removing a DC component from the resonance signal output from the output node N. In another embodiment, the DC blocking unit 350 may be omitted.

The resonance signal output from the output node N may be input to the comparator 360. The comparator 360 may output a square wave by comparing the resonance signal with a reference signal defined by a second power voltage VR2. FIG. 55 is a diagram illustrating a waveform of a square wave output from a comparator of a sensing circuit according to an embodiment.

More specifically, the comparator 360 may compare the voltage magnitude of the reference signal generated by the second power voltage VR2 with the voltage magnitude of the resonance signal output from the output node N, and may output a square wave according to the comparison result. For example, if the voltage magnitude of the resonance signal output from the output node N is greater than or equal to the voltage magnitude of the reference signal, the comparator CP may output a signal having a voltage magnitude of the first level (e.g., 5V), and if the voltage magnitude of the resonance signal is less than the voltage magnitude of the reference signal, the comparator CP may output a signal having a voltage magnitude of the second level (e.g., 0V).

The controller 500 may count the number of waveforms in the square wave output from the comparator 360, and determine whether a container is present on the top of the sensing coil SC based on the counted number of waveforms in the square wave.

When a container is present on the top of the sensing coil SC, the impedance of the sensing coil SC and the resonance capacitor Cr2 is maintained relatively high compared to when a container is not present. Therefore, the resonance signal can be attenuated and then dissipated over a relatively short period of time. Conversely, when there is no container on the top of the sensing coil SC, the impedances of the sensing coil SC and the resonance capacitor Cr2 are maintained relatively low compared to when a container is present. Therefore, the resonance signal can be attenuated and then dissipated over a relatively long period of time.

As a result, the number of waveforms in the square wave output by the comparator 360 when there is no container on the top of the sensing coil SC is greater than the number of waveforms in the square wave output by the comparator 360 when there is a container on the top of the sensing coil SC.

Therefore, the controller 500 can determine that a container is present on the top of the sensing coil SC if the counted number of waveforms in the square wave is less than or equal to a predetermined reference value. Conversely, the controller 500 can determine that there is no container on the top of the sensing coil SC if the counted number of waveforms in the square wave exceeds a predetermined reference value. The reference value is a value that may be set differently according to an embodiment.

In an embodiment, the controller 500 may sequentially perform the container detection on each sensing coil SC. Therefore, while the container detection is performed for one sensing coil SC, the remaining sensing coils SC may be maintained in a discharged state.

Although the present specification has been described with reference to the drawings as examples, it is obvious that the present specification is not limited to the embodiments and drawings disclosed in present disclosure, and that various modifications can be made by those skilled in the art. Additionally, even if the effects according to the configuration of the present specification were not explicitly written while describing the embodiments of the present specification, it is natural that the effects that can be predicted by the configuration should also be recognized.

## Claims

1. A working coil comprising:
a plurality of first coil layers disposed along a first pattern and stacked in a vertical direction; and
a plurality of second coil layers disposed along a second pattern, stacked in a vertical direction, and disposed in layers different from the plurality of first coil layers,
wherein the working coil includes a connection region and a non-connection region, and
wherein the connection region includes a via electrically connecting at least one of coil strands included in the plurality of first coil layers with at least one of coil strands included in the plurality of second coil layers.

2. The working coil of claim 1, wherein each of coil strands included in the plurality of first coil layers and each of coil strands included in the plurality of second coil layers are disposed in different traces in the non-connection region.

3. The working coil of claim 1, wherein each of coil strands included in the plurality of first coil layers and each of coil strands included in the plurality of second coil layers are disposed in a same trace in the non-connection region.

4. The working coil of claim 1, wherein each of coil strands included in the plurality of first coil layers and each of coil strands included in the plurality of second coil layers are parallel to each other in the non-connection region.

5. The working coil of claim 1, wherein each of coil strands included in the plurality of first coil layers and each of coil strands included in the plurality of second coil layers intersect with each other in the connection region.

6. The working coil of claim 1, wherein the connection region includes two or more via patterns, and
wherein each of the via patterns is disposed on a straight line orthogonal to a coil strand included in the plurality of first coil layers or the plurality of second coil layers.

7. The working coil of claim 1, wherein the connection region includes two or more via patterns, and
wherein each of the via patterns is disposed on a straight line intersecting at a predetermined angle with a coil strand included in the plurality of first coil layers or the plurality of second coil layers.

8. The working coil of claim 1, wherein the working coil includes a plurality of coil turns, and
wherein each of the via patterns included in each of the coil turns is disposed on a same straight line.

9. The working coil of claim 1, wherein the working coil includes a plurality of coil turns, and
wherein the via pattern included in each of the coil turns is disposed in a same position as the via included in another coil turn.

10. The working coil of claim 1, wherein the working coil includes a plurality of coil turns,
wherein each of the via patterns included in an nth coil turn is disposed on a first straight line, and
wherein each of the via patterns included in an (n+2)th coil turn is disposed on a second straight line.
(where n is a positive integer)

11. The working coil of claim 1, wherein the connection region and the non-connection region are alternately disposed.

12. The working coil of claim 1, wherein the first coil layer and the second coil layer are alternately disposed with each other in a vertical direction.

13. The working coil of claim 1, wherein the working coil is included in a home appliance and heats an object.

14. A working coil comprising:
a plurality of first coil layers disposed along a first pattern and stacked in a vertical direction;
a plurality of second coil layers disposed along a second pattern, stacked in a vertical direction, and disposed in layers different from the plurality of first coil layers; and
a plurality of third coil layers disposed along a third pattern, stacked in a vertical direction, and disposed in layers different from the plurality of first coil layers and the plurality of second coil layers,
wherein the working coil includes a connection region and a non-connection region, and
wherein the connection region includes a via electrically connecting at least one of coil strands included in the plurality of first coil layers, at least one of coil strands included in the plurality of second coil layers, and at least one of coil strands included in the plurality of third coil layers.

15. The working coil of claim 14, wherein each of the coil strands included in the plurality of first coil layers, each of the coil strands included in the plurality of second coil layers, and each of the coil strands included in the plurality of third coil layers are disposed in a same trace in the non-connection region.

16. The working coil of claim 14, wherein the connection region includes a first connection region and a second connection region,
wherein in the first connection region, the via is formed in an nth coil turn, and
wherein in the second connection region, the via is formed in an (n+2)th coil turn.
(where n is a positive integer)

17. The working coil of claim 16, wherein at least one of each of the coil strands included in the plurality of first coil layers and at least one of each of the coil strands included in the plurality of second coil layers are electrically connected by the via in the first connection region.

18. The working coil of claim 16, wherein at least one of each of the coil strands included in the plurality of second coil layers and at least one of each of the coil strands included in the plurality of third coil layers are electrically connected by the via in the second connection region.

19. The working coil of claim 14, wherein each of the coil strands included in the plurality of first coil layers, each of the coil strands included in the plurality of second coil layers, and each of the coil strands included in the plurality of third coil layers intersect with each other in the connection region.

20. The working coil of claim 14, wherein the connection region includes two or more via patterns, and
wherein each of via patterns is disposed on a straight line orthogonal to a coil strand included in the plurality of first coil layers or the plurality of second coil layers or the plurality of third coil layers.

21. The working coil of claim 14, wherein the connection region includes two or more via patterns, and
wherein each of the via patterns is disposed on a straight line intersecting at a predetermined angle with a coil strand included in the plurality of first coil layers or the plurality of second coil layers or the plurality of third coil layers.

22. The working coil of claim 14, wherein the working coil includes a plurality of coil turns,
wherein each of the via patterns included in an nth coil turn is disposed on a first straight line, and
wherein each of the via patterns included in an (n+2)th coil turn is disposed on a second straight line.
(where n is a positive integer)

23. The working coil of claim 14, wherein the connection region and the non-connection region are alternately disposed.

24. The working coil of claim 16, wherein in the nth coil turn, the first connection region and the non-connection region are alternately disposed, and
wherein in the (n+2)th coil turn, the second connection region and the non-connection region are alternately disposed.
(where n is a positive integer)

25. The working coil of claim 14, wherein at least two coil layers of the first coil layer, the second coil layer, and the third coil layer are alternately disposed with each other in a vertical direction.

26. The working coil of claim 14, wherein the working coil is included in a home appliance and heats an object.
